(19) Europäisches Patentamt
European Patent Office
Office européen des brevets

(11) EP 2 894 942 A1

(12) EUROPEAN PATENT APPLICATION
published in accordance with Art. 153(4) EPC

(43) Date of publication:
**15.07.2015 Bulletin 2015/29**

(21) Application number: **13834542.6**

(22) Date of filing: **03.09.2013**

(51) Int Cl.:
***H05B 33/02*** *(2006.01)* ***C03C 17/38*** *(2006.01)*
***H01L 51/50*** *(2006.01)* ***H05B 33/10*** *(2006.01)*

(86) International application number:
**PCT/JP2013/073712**

(87) International publication number:
**WO 2014/038559 (13.03.2014 Gazette 2014/11)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **04.09.2012 JP 2012194341**

(71) Applicant: **Mitsubishi Chemical Corporation**
**Chiyoda-ku**
**Tokyo 100-8251 (JP)**

(72) Inventors:
- **BANDO, Yoshimasa**
  **Yokohama-shi**
  **Kanagawa 227-8502 (JP)**
- **KATOU, Masanori**
  **Yokohama-shi**
  **Kanagawa 227-8502 (JP)**
- **NAGAO, Shigeki**
  **Yokohama-shi**
  **Kanagawa 227-8502 (JP)**
- **OGATA, Tomoyuki**
  **Yokohama-shi**
  **Kanagawa 227-8502 (JP)**

(74) Representative: **Merkle, Gebhard**
**Ter Meer Steinmeister & Partner**
**Patentanwälte mbB**
**Mauerkircherstrasse 45**
**81679 München (DE)**

# (54) ORGANIC ELECTROLUMINESCENT DEVICE AND MANUFACTURING METHOD THEREOF

(57) An organic electroluminescent device of the present invention comprising comprises, as stacked on a baseplate, at least, a first conductive layer, a charge injection and transport layer, a light-emitting layer, and a second conductive layer, wherein (1) the charge injection and transport layer includes a charge injection layer in contact with the first conductive layer, (2) the charge injection and transport layer has a thickness ranging from 130 to 1000 nm, (3) the charge injection layer contains a crosslinked aromatic amine polymer, and the baseplate is a glass baseplate, and the minimum value of a waviness tangent for the surface of the glass baseplate towards the first conductive layer is equal to or more than $4.00 \times 10^{-6}$, or a maximum value of the waviness tangent is equal to or more than $22 \times 10^{-6}$.

[Fig. 1]

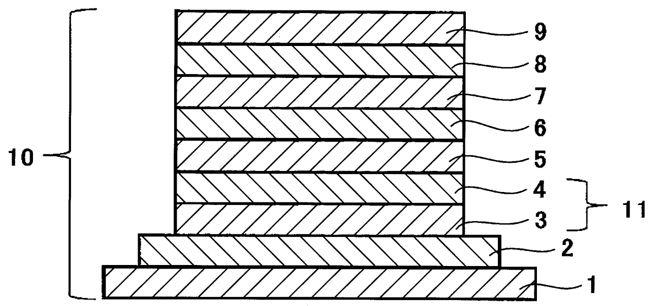


EP 2 894 942 A1

## Description

### Technical Field

The present invention relates to an organic electroluminescent device and a method for producing the same.

### Background Art

Having a simple device configuration, an organic electroluminescent device can emit various colors of lights, and therefore, recently, has become much developed as a technique to produce light-emitting devices such as displays, lightings, etc.

The organic electroluminescent device is a device in which positive and negative charges (carriers) are injected into organic layers between two electrodes and lights are emitted when these carriers are recombined in them.

Heretofore, as a baseplate of an organic electroluminescent device, widely used is a glass baseplate from the viewpoints of light permeability, flatness, rigidity and the like thereof.

Regarding materials and production methods for a glass baseplate, generally used is soda-lime glass (hereinafter this may be referred to as alkali-glass) by using the method of float process from the viewpoint that large-area glass baseplates are easy to produce at a low cost. However, as a baseplate for organic electroluminescent devices, generally used is alkali-free glass by using a method of fusion process. The reasons are as follows.

Soda-lime glass is glass containing a large amount of alkali compounds, and when it is used as a baseplate for organic electroluminescent device, then alkali metal ions would dissolve out and be diffused in the organic electroluminescent device on the baseplate due to changing with time, therefore causing device degradation and a lifetime of the organic electroluminescent device tends to be thereby shortened. Accordingly, as a material of the glass baseplate for organic electroluminescent device, preferably used is alkali-free glass containing few alkali compounds (see PTL 1).

In producing alkali-free glass, the method of float process is problematic because the viscosity of glass in high temperature is high, and therefore, in general, a method of fusion process is adopted (see PTL 2).

Method of fusion process comprises introducing a molten glass material into a gutter-shaped source having a long and narrow spout, then overflowing it on both sides in the longitudinal direction to drip downward, and the dripped glass melts meet again under the source while further keeping them still dripping down, and gradually cooling the dripped glass to obtain a continuous sheet glass.

The sheet glass produced by using the above method of fusion process hardly has surface defects such as flaws and the like since it is prevented from coming into contact with any other substances than air, or that is, any solid such as rolls in the production line until the sheet glass surface exposed in air could be sufficiently solidified, from the characteristic feature of the production method, and therefore, as compared with that according to the method of float process to be mentioned below, the sheet glass to be produced by using the above-mentioned method of fusion process could have sufficiently high flatness, or that is, sufficiently high planarity (with little shape deviation of warpage)/smoothness (with little surface waviness and surface roughness), and could have a surface with few surface defects.

On the other hand, the method of float process comprises uniformly melting a glass material in a melting furnace, a molten glass continuously flowing through an output port, slowly sliding it on a pool furnace where tin is molten, and gradually cooling and taking it out. The method of float process makes it possible to readily produce large-area sheet glass at a low cost, as compared with the former method of fusion process. However, as compared with the method of fusion process, the method of float process is problematic in that the produced sheet glass has poor flatness and many surface defects. When a glass baseplate having many surface defects is used in an organic electroluminescent device, then the device would have micro defects, therefore causing electrical defects such as local short-circuit and/or leakage.

Because of the above-mentioned reasons, as the glass baseplate for organic electroluminescent devices, it is considered that alkali-free glass produced by using a method of fusion process would be favorably used, since the glass of the type causes little degradation of devices owing to outward diffusion of alkali compounds from the glass, and since it has good flatness and has little surface defects.

However, alkali-free glass is expensive in production cost since impurities of alkali metal compounds therein are reduced as compared with those in soda-lime glass, and, in addition, the method of fusion process is poorly productive as compared with the method of float process, and is therefore also problematic in that the production cost is high.

For the purpose of producing organic electroluminescent devices at a lower cost, PTL 1 proposes using alkali-glass as a baseplate and providing a barrier layer of $SiO_2$ on the surface of the baseplate to thereby prevent from outward diffusion of alkali compounds out of the glass into the organic electroluminescent devices. In this, however, the production method is presumed to be the method of float process, and therefore it is considered that the method is still unsatisfactory in solving the problem of surface defects.

On the other hand, use of a glass baseplate produced by using the less expensive float process in organic electroluminescent devices has been tried, but in the case, it is necessary to polish at least one side of the baseplate

surface for improving the surface characteristics of the glass baseplate, and such a baseplate is problematic in that the production cost is still high (see PTL 3). In addition, PTL 3 says as follows: "A soda-lime glass baseplate for STN-LCD must be processed for reducing the waviness of the glass baseplate for the purpose of preventing cell gap unevenness. For this, the glass surface is polished, and in order to use for passive organic EL devices, further micro-level control of the irregularities of the glass baseplate is necessary." From this disclosure, it is considered that the glass baseplate described in PTL 3 is processed to reduce waviness. In Examples in PTL 3, the constitutive layers are formed on the anode by using a vacuum evaporation method.

As described above, it is desired to use a non-polished soda-lime glass baseplate produced by using the method of float process from the viewpoint of the production cost, but for the reasons of lifetime prolongation and restraint of electrical defects causing short-circuit and/or leakage, it is actual that an alkali-free glass baseplate produced by using a method of fusion process is widely used in the art.

Citation List

Patent Literature

PTL 1: JP-A 11-195487
PTL 2: JP-A 2007-091522
PTL 3: JP-A 2004-111201

Summary of Invention

Technical Problem

An object of the present invention is to provide an organic electroluminescent device capable of being produced at a low cost, which has few electrical device defects causing short-circuit and/or leakage in the case where the device is produced. Another object of the invention is to provide an organic electroluminescent device capable of being produced at a low cost, which, even in producing the organic electroluminescent device using a non-polished glass baseplate produced by using the method of float process, still has few electrical defects causing short-circuit and/or leakage.

Solution to Problem

In consideration of the situation mentioned above, the present inventors have assiduously studied and, as a result, have found that, when the charge injection and transport layer to form an organic electroluminescent device contains a crosslinked aromatic amine polymer and when the layer has a thickness within the specific limits, then the above-mentioned objects can be attained, and have reached the present invention. Further, as a result of assiduous studies about glass baseplates, the present inventors have further found that, when a non-polished glass baseplate produced by using the method of float process and having a value of waviness in a specific range is used and when a charge injection and transport layer containing a specific aromatic amine polymer and having a thickness within the specific limits is formed on the glass substrate, then the organic electroluminescent device of the type can attain the above-mentioned objects, and have reached the present invention.

Specifically, the first aspect of the present invention is as follows:

An organic electroluminescent device comprising, as stacked on a glass baseplate, at least, the first conductive layer, a charge injection and transport layer, a light-emitting layer, and the second conductive layer, wherein:

(1) the minimum value of a waviness tangent of the surface of the glass baseplate towards the first conductive layer is equal to or more than $4.00 \times 10^{-6}$, or the maximum value of the waviness tangent is equal to or more than $22 \times 10^{-6}$,
(2) the charge injection and transport layer is a layer formed by using a wet method of film formation,
(3) the charge injection and transport layer includes a charge injection layer in contact with the first conductive layer,
(4) the charge injection and transport layer has a thickness ranging from 130 to 1000 nm,
(5) the charge injection layer contains a crosslinked aromatic amine polymer.

In the first aspect of the present invention, preferably, a density of surface defects in the state where the first conductive layer is formed on the glass baseplate is equal to or more than 2.0 defects/$cm^2$.

In the first aspect of the present invention, preferably, the glass baseplate contains at least one of $Na_2O$ and $K_2O$ in an amount equal to or more than 1.0% by mass.

In the first aspect of the present invention, preferably, the thickness of the charge injection and transport layer is ranging from 130 to 500 nm.

In the first aspect of the present invention, preferably, the glass baseplate is produced by using the method of float process, and is more preferably an unpolished glass baseplate.

In the first aspect of the present invention, preferably, the crosslinked aromatic amine polymer contains a partial structure represented by the following formula (1):

[Chem. 1]

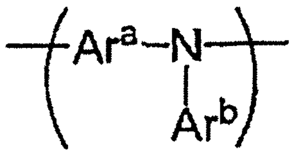

(1)

(In the formula (1), each of $Ar^a$ and $Ar^b$ independently represents an aromatic hydrocarbon-cyclic group or an aromatic heterocyclic group having from 4 to 60 carbon atoms and optionally having a substituent, and $Ar^a$ is a divalent group, and $Ar^b$ is a monovalent group.)

In the first aspect of the present invention, preferably, the crosslinked aromatic amine polymer has a crosslinked structure derived from a crosslinking group selected from the following crosslinking group family T:

<Crosslinking Group Family T>

[Chem. 2]

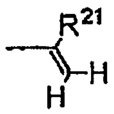 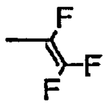 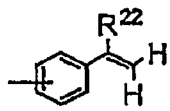 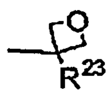 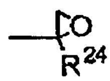 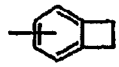

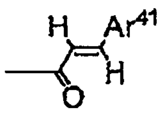 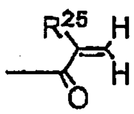 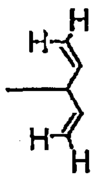 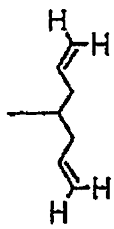 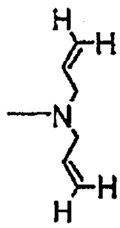

(In the formulae, each of $R^{21}$ to $R^{25}$ independently represents a hydrogen atom or an alkyl group having from 1 to 12 carbon atoms, $Ar^{41}$ represents an aromatic hydrocarbon-cyclic group optionally having a substituent or an aromatic heterocyclic group optionally having a substituent, and the benzocyclobutene ring may optionally have a substituent.)

In addition, the present inventors have found that an organic electroluminescent device having, on a baseplate, a charge injection and transport layer containing a specific aromatic amine polymer and having a specific thickness can attain the above-mentioned objects, and have reached the present invention.

Specifically, the second aspect of the present invention is as follows:

An organic electroluminescent device comprising, as stacked on a glass baseplate, a first conductive layer, a charge injection and transport layer, a light-emitting layer, and a second conductive layer, wherein:

(1) the charge injection and transport layer is a layer formed by using a wet method of film formation,
(2) the charge injection and transport layer includes a charge injection layer in contact with the first conductive layer,
(3) the charge injection and transport layer has a thickness ranging from 130 to 1000 nm,
(4) the charge injection layer contains a crosslinked aromatic amine polymer.

In the second aspect of the present invention, preferably, the baseplate is a glass baseplate, and the density of surface defects in the state where the first conductive layer is formed on the glass baseplate is equal to or more than 2.0 defects/$cm^2$.

In the second aspect of the present invention, preferably, the glass baseplate is produced by using the method of float process, and is more preferably an unpolished glass baseplate.

In the second aspect of the present invention, preferably, the thickness of the charge injection and transport layer is ranging from 130 to 500 nm.

The third aspect of the present invention is a method to produce the organic electroluminescent device of the first aspect above, and is as follows:

A method to produce an organic electroluminescent device comprising, as stacked on a glass baseplate, at least, a first conductive layer, a charge injection and transport layer, a light-emitting layer, and a second conductive layer, wherein:

(1) as the glass baseplate, a glass baseplate where the minimum value of waviness tangent of the surface thereof towards the first conductive layer is equal to or more than $4.00 \times 10^{-6}$, or the maximum value of the waviness tangent is equal to or more than $22 \times 10^{-6}$, is used, in such a manner so that the surface thereof having the value of the waviness tangent is the surface towards the first conductive layer,
(2) the charge injection and transport layer is formed by using a wet method of film formation,
(3) the charge injection and transport layer includes a charge injection layer in contact with the first conductive layer,
(4) the charge injection layer is formed with coating, that is a wet method of film formation, a composition containing a crosslinking group-having aromatic amine polymer a solvent, and drying and crosslinking the coating film with coating the composition,
(5) the charge injection and transport layer is formed to have a thickness ranging from 130 to 1000 nm.

In the third aspect of the present invention, preferably, a density of surface defects in the state where the first conductive layer is formed on the glass baseplate is equal to or more than 2.0 defects/$cm^2$.

In the third aspect of the present invention, preferably, as the glass baseplate, a glass baseplate containing at least one of $Na_2O$ and $K_2O$ in an amount equal to or more than 1.0% by mass, is used.

In the third aspect of the present invention, preferably, the thickness of the charge injection and transport layer is ranging from 130 to 500 nm.

In the third aspect of the present invention, preferably, as the glass baseplate, a glass baseplate produced by using the method of float process, is used, and more preferably, as the glass baseplate, a glass baseplate that has been produced by using the method of float process and is unpolished, is used.

The fourth aspect of the present invention is a method for producing the organic electroluminescent device of the second aspect above, and is as follows:

A method to produce an organic electroluminescent device comprising, as stacked on a glass baseplate, at least, a first conductive layer, a charge injection and transport layer, a light-emitting layer, and a second conductive layer, wherein:

(1) the charge injection and transport layer is formed by using a wet method of film formation,
(2) the charge injection and transport layer includes a charge injection layer in contact with the first conductive layer,
(3) the thickness of the charge injection and transport layer is ranging from 130 to 1000 nm,
(4) the charge injection layer is formed with coating, that is a wet method of film formation, a composition containing a crosslinking group-having aromatic amine polymer and a solvent, and drying and crosslinking the coating film with coating the composition,

In the fourth aspect of the present invention, preferably, the baseplate is a glass baseplate, and a density of surface defects in the state where the first conductive layer is formed on the glass baseplate is equal to or more than 2.0 defects/$cm^2$.

In the fourth aspect of the present invention, preferably, as the glass baseplate, a glass baseplate produced by using the method of float process, is used, and more preferably, as the glass baseplate, a glass baseplate that has been produced by using the method of float process and is unpolished, is used.

In the fourth aspect of the present invention, preferably, the thickness of the charge injection and transport layer is ranging from 130 to 500 nm.

In addition, the present inventors have further found that an organic electroluminescent device having, on a non-polished glass baseplate produced by using the method of float process, a charge injection and transport layer having a specific thickness ratio to the first conductive layer can attain the above-mentioned objects, and have reached the present invention.

Specifically, the fifth aspect of the present invention is as follows:

An organic electroluminescent device comprising, as stacked on a glass baseplate, at least, a first conductive layer, a charge injection and transport layer formed by using a wet method of film formation and containing a charge transport material, a light-emitting layer, and a second conductive layer, in this order, wherein:
the glass baseplate is produced by using the method of float process,
the surface of the glass baseplate towards the first conductive layer is in an unpolished state, and
the thickness of the charge injection and transport layer is not smaller than 1.3 times the thickness of the first conductive layer.

Further, the present inventors have found that an organic electroluminescent device, in which the non-polished glass baseplate produced by using the method of float process has a value of waviness in a specific range and which has, as formed on the glass baseplate having the value of waviness, a charge injection and transport layer having a thickness ratio, which is specifically ranging, relative to the first conductive layer thickness, can attain the above-mentioned objects, and have reached the present invention.

Specifically, the sixth aspect of the present invention is as follows:

An organic electroluminescent device comprising, as stacked on a glass baseplate, at least, a first conductive layer, a charge injection and transport layer formed by using a wet method of film formation and containing a charge transport material, a light-emitting layer, and a second conductive layer, in this order, wherein:

> the minimum value of a waviness tangent of the surface of the glass baseplate towards the first conductive layer is equal to or more than $4.20 \times 10^{-6}$, or the maximum value of the waviness tangent is equal to or more than $22 \times 10^{-6}$, the thickness of the charge injection and transport layer is not smaller than 1.3 times the thickness of the first conductive layer.

Advantageous Effects of Invention

According to the present invention, it is possible to produce an organic electroluminescent device, in which the charge injection layer in contact with the first conductive layer contains a specific polymer and the thickness of the layer falls within a specific range, and which therefore has few electrical defects causing short-circuit and/or leakage. Further, even in a case where a glass baseplate is used as the baseplate and where the surface of the glass baseplate the first conductive layer to be formed thereon has a value of waviness tangent in a specific range, or where an unpolished glass baseplate produced by using the method of float process, it is still possible to produce an organic electroluminescent device having few electrical defects causing short-circuit and/or leakage.

Brief Description of Drawings

[Fig. 1] Fig. 1 is a schematic cross-sectional view showing one example of an embodiment of the organic electroluminescent device of the present invention.

Description of Embodiments

Embodiments of the organic electroluminescent device of the invention where an unpolished glass baseplate produced by using the method of float process is used as the baseplate, and the production method for the device are described in detail hereinunder; however, the description given below is of some examples (typical examples) of the embodiments of the present invention, and the present invention is not specifically defined by these contents, not overstepping the scope and the spirit thereof.

In the present invention, all percentage expressed by mass is the same as the percentage expressed by weight.

[Fundamental Idea of Invention]

Regarding the base material to support the organic electroluminescent device as referred to in this description, one that indicates to include the first conductive layer is expressed as "substrate"; and one that indicates not to include the first conductive layer is expressed as "baseplate". Still another one that indicates both the two is referred to as "baseplate and the like". In a case where the main material of the support is specifically indicated, the material expression is put just before the term. For example, in a case where the main material is glass, adoptive here can be expressions of "glass baseplate", "glass substrate", "glass baseplate and the like".

The present invention is characterized in that an organic electroluminescent device, in which the charge injection and transport layer contains a crosslinked aromatic amine polymer and has a thickness in a specific range, has realized an organic electroluminescent device capable of reducing electrical device defects of short-circuit and/or leakage. Further,

the present invention has realized an organic electroluminescent device having good properties, using a low-cost glass baseplate that has heretofore been difficult to use for maintaining the characteristics of organic electroluminescent devices. Concretely, the present invention is characterized in that an organic electroluminescent device capable of reducing electrical defects causing short-circuit or leakage has been realized, using a glass baseplate that has been produced by using the method of float process and is not polished.

The surface of the glass substrate that comprises the first conductive layer formed on a glass baseplate produced according to by using the method of float process is, as described above, poorly flat, and has a large number of surface defects existing therein. The surface defects result from microscopic surface irregularities on the glass baseplate or from minute exfoliation of the first conductive layer. In case where an organic electroluminescent device having layer configurations which has been already adopted, is formed on such a glass substrate, no desired configuration for the layers could be realized in the surface-defective portions and, as a result, microscopically, there emerge regions not functioning as an organic electroluminescent device, therefore having a negative influence on the entire characteristics of the device.

To reduce the influence of surface defects, it is considered that, in forming a charge injection and transport layer just above the first conductive layer, the surface defects that may result in short-circuit and/or leakage in organic electroluminescent devices are reduced in the surface after formation of the charge injection and transport layer thereon. In case where the charge injection and transport layer is formed in a manner of dry method of film formation such as a sputtering method or a vacuum evaporation method, the layer tends to be conformal along the defect profiles on the first conductive layer, and therefore in such a case, it is difficult to reduce the surface defects that may result in the above-mentioned short-circuit and/or leakage. On the other hand, in case where the charge injection and transport layer is formed by using wet method of film formation such a spin coating method or an inkjet method, a flat surface may be readily formed irrespective of the presence or absence of surface defects in the first conductive layer. However, when the first conductive layer has large irregularities exceeding the thickness of the charge injection and transport layer to be formed thereon, then it is still difficult to planarize the surface of the layer even in a wet method of film formation. Consequently, it is considered that when a charge injection and transport layer is formed to have a thickness larger than a predetermined level by using a wet method of film formation, then the influence of the surface defects exiting in the substrate could be significantly reduced.

Accordingly, one characteristic feature of the first aspect of the present invention is that the thickness of the charge injection and transport layer is ranging from 130 to 1000 nm. Having a thickness that falls within the range, the flatness of the charge injection and transport layer can be secured even when the flatness of the glass baseplate is poor and the glass baseplate has a large number of surface defects, and as a result, it is possible to significantly reduce the generation of a region not functioning as an organic electroluminescent device. A thicker layer could secure better flatness; however, the thickness of the layer is at most 1000 nm to prevent absorption of light from light-emitting material.

The characteristic properties of an unpolished glass baseplate produced by using the method of float process are discussed in point of the physical properties thereof, and it may be said that the unpolished glass baseplate has the following characteristics. First, the glass baseplate produced by using the method of float process is poorly flat as compared with already-existing glass baseplates produced by using a method of fusion process, or in other words, is characterized in that the baseplate surface waviness is large. In case where the glass baseplate is polished in some way, the waviness of the glass baseplate surface would be reduced to the same level as that of glass baseplates produced by using a method of fusion process. However, the unpolished glass baseplate in the present invention still has large waviness. Accordingly, the glass baseplate or the glass substrate to be used in the present invention, is characterized by having waviness on a certain level or more. Consequently, in the first aspect of the present invention, as described in detail hereinunder, the waviness tangent of the surface of the glass baseplate towards the first conductive layer has a value in a specific range.

Further, discussing the issue from the viewpoint of surface defects, the glass baseplate produced by using a method of fusion process naturally has a few surface defects, but even for the glass baseplate produced by using the method of float process, it is possible to reduce the surface defects thereof by polishing it. The glass baseplate in the present invention is not polished at all after forming into a plate from molten glass, or that is, the glass baseplate is "unpolished" or "non-polished", and therefore, the glass baseplate or the glass substrate to be used in the present invention is characterized by having surface defects on a certain level or more. Hereinafter the state of the unprocessed baseplate is expressed as a common term "unpolished", and the present invention is described in detail.

[Layer Configuration of Organic Electroluminescent Device]

The organic electroluminescent device of the present invention has, as stacked on a baseplate, preferably on a glass baseplate, at least a first conductive layer, a charge injection and transport layer formed by using a wet method of film formation, a light-emitting layer, and a second conductive layer.

One example of an embodiemnt of the layer configuration of the organic electroluminescent device of the present invention is described hereinunder with reference to Fig. 1.

Fig. 1 is a schematic cross-sectional view showing one example of configuration of an organic electroluminescent device 10 of the present invention. In Fig. 1, 1 is a baseplate, 2 is an anode, 3 is a hole injection layer formed by using a wet method of film formation, 4 is a hole transport layer formed by using a wet method of film formation, 5 is a light-emitting layer, 6 is a hole block layer, 7 is an electron transport layer, 8 is an electron injection layer, and 9 is a cathode.
Specifically, in the case of Fig. 1, the first conductive layer in the present invention corresponds to the anode, the charge injection and transport layer in the present invention corresponds to the hole injection layer formed by using a wet method of film formation and a hole transport layer formed by using a wet method of film formation, and the second conductive layer in the present invention corresponds to the cathode.
The organic electroluminescent device of the present invention comprises, as the indispensable constituent layers, the first conductive layer (anode), the charge injection and transport layer containing a charge transport material (corresponding to the hole injection layer formed by using a wet method of film formation and the hole transport layer formed by using a wet method of film formation), the light-emitting layer and the second conductive layer (cathode), but if necessary, the device may has any other functional layers between the above-mentioned indispensable layers as shown in Fig. 1, or in the device, the above-mentioned indispensable layer may be formed to have a multilayer structure of two or more layers. Concretely, a hole transport layer formed by using a vapor deposition method may be provided between the hole transport layer 4 formed by using a wet method of film formation and the light-emitting layer 5. In this case, the hole transport layer formed by using a vapor deposition method does not corresponds to the charge injection and transport layer in the present invention. In case where the hole injection layer 3 alone is formed by using a wet method of film formation and the hole transport layer 4 is formed by using a non-wet method of film formation such as a vacuum evaporation method or the like, the charge injection and transport layer in the present invention is considered to be the hole injection layer 3 alone.

[Baseplate]

The baseplate 1 is to be a support of the organic electroluminescent device. As the baseplate for the organic electroluminescent device of the present invention, usable is a glass plate, a metal plate or a resin. Preferred is a light-permeable glass plate, or a transparent resin sheet. Further, as the glass plate, herein usable is a glass baseplate of which the value of waviness tangent falls in a specific range and which has heretofore been difficult to use in the art (one characteristic feature of the first aspect of the present invention).
A method to produce the glass baseplate having a value of waviness tangent that falls in a specific range is described below.
In case where the baseplate in the present invention is a glass baseplate, the glass baseplate 1 is produced by using the method of float process. The float process is a process that comprises uniformly melting a glass material including $SiO_2$ and others compounds in a melting furnace, then molten glass continuously flowing via an output port, slowly sliding it on a molten tin pool furnace to be gradually cooled thereon, and then taking it out.
After produced by using such the method of float process, the glass baseplate in the present invention is not mechanically or chemically polished at all on the surface thereof on which the first conductive layer and others are to be formed, or that is, the glass baseplate must be maintained in an unpolished state.
Here, polishing is described in detail. A glass baseplate produced by using a method of fusion process can be used directly as it is, as a baseplate for organic electroluminescent devices, even though not polished, as described above; however, for using the glass baseplate produced by using the method of float process as a baseplate for organic electroluminescent devices, it has heretofore been indispensable to polish it. In a process of polishing the glass baseplate, widely adopted is a so-called mechanical polishing method using an Oscar-type one-side polishing machine, in which a baseplate holder having an opening hole so that the baseplate could be housed in the upper press board is used, and while the glass baseplate is kept held by the baseplate holder and while an abrasive liquid prepared by dispersing abrasive grains comprising a fine powder of cerium oxide or the like in water to be a slurry is supplied thereto, one side of the baseplate is pressed against the rotating lower lap so as to be polished therewith (for example, see JP-A 2004-276133). In such a mechanical polishing method, the surface of the glass baseplate may be scratched depending on the polishing condition or on a changing state of the abrasive cloth used, and chemical polishing may be combined with mechanical polishing for reducing such scratches (for example, see Japanese Patent 4431516). In the glass baseplate thus treated in such a polishing process, surface defects and waviness having formed during float process may be removed, and therefore the surface defects of the first conductive layer to be formed on the baseplate can be reduced, and eventually the device defects of short-circuit and/or leakage to occur in the organic electroluminescent device to be formed thereon can be reduced. However, since the polishing process requires more several steps in addition to the method of float process, the entire process is therefore economically defective so as to be expensive. In this connection, in the glass baseplate processed in the polishing step as described above, the surface defects and waviness to occur in the float process are removed, and therefore, there is a possibility that the "waviness tangent of the surface of the glass baseplate towards the first conductive layer" could not satisfy the specific value defined in the first aspect of the

present invention (the details are described in the following section).

The main component of the glass baseplate 1 is $SiO_2$, and the glass baseplate may contain any conventionally-known impurities, but is preferably alkali glass that contains at least one of $Na_2O$ and $K_2O$ in an amount equal to or more than 1.0% by mass, and more preferably alkali glass that contains $Na_2O$ in an amount equal to or more than 2.0% by mass and particularly 4.0% by mass. The upper limit of the total content of $Na_2O$ and $K_2O$ in alkali glass is generally 25.0% by mass, preferably 20.0% by mass. Other impurities except for $Na_2O$ and $K_2O$ are, for example, CaO, MgO, $Al_2O_3$, $B_2O_3$, $P_2O_5$, $ZrO_2$, etc. The content of $SiO_2$ in alkali glass is generally ranging from 55% by mass to 80% by mass or so. As compared with that for alkali-free glass, the material of alkali glass is inexpensive, and such alkali glass can realize organic electroluminescent device at lower cost.

The components of the glass baseplate are preferably determined according to by using a method of compositional analysis. For example, any of semi-quantitative analysis or quantitative analysis can be adoptive, but preferably, a method of quantitative analysis is adopted from the viewpoint of the accuracy.

For example, for semi-quantitative analysis, there are known methods of X-ray fluorescence analysis (XRF), glow discharge mass spectrometry (GD-MS), solid optical emission spectroscopy, etc. For quantitative analysis, it is known that the baseplate is decomposed with hydrofluoric acid or melted with an alkali, and then analyzed through atomic absorption spectrometry (AAS), inductively coupled plasma Auger electron spectroscopy (ICP-AES), etc.

The glass baseplate 1 of the present invention is, as described above, produced by using the method of float process, and the surface of the glass baseplate on the side on which the first conductive layer is to be formed is unpolished, and this characteristic of the baseplate is defined on another aspect as follows.

The glass baseplate produced by using the method of float process tends to have a larger degree of waviness on the surface thereof as compared with that of the glass baseplate produced by using a method of fusion process. By polishing the glass baseplate produced by using the method of float process, the waviness of the surface of the glass baseplate can be reduced. Accordingly, it can be said that, of the glass baseplate or the glass substrate in the present invention, the index value indicating the degree of waviness of the surface is a specific value or more.

As a result of investigations regarding the waviness of glass baseplates or glass substrates manufactured by various glass manufacturers by using the method of float process or a method of fusion process, it has been known that, of the glass baseplate in the present invention, the minimum value of the waviness tangent, which is one index indicating the waviness thereof, is equal to or more than $4.00 \times 10^{-6}$, or the maximum value of the waviness tangent is equal to or more than $22 \times 10^{-6}$. The upper limit of the minimum value of the waviness tangent is equal to or less than $9.00 \times 10^{-6}$, and the upper limit of the maximum value of the waviness tangent is equal to or less than $100 \times 10^{-6}$.

The minimum value of the waviness tangent is preferably equal to or more than $4.00 \times 10^{-6}$, more preferably $4.02 \times 10^{-6}$, even more preferably $4.20 \times 10^{-6}$. The maximum value of the waviness tangent is generally equal to or more than $22 \times 10^{-6}$, but preferably $28 \times 10^{-6}$, more preferably $33 \times 10^{-6}$.

Also preferably, the minimum value of the waviness tangent is not less than one of the above-mentioned values, or the maximum value of the waviness tangent is not less than one of the above-mentioned values, and more preferably, the minimum value of the waviness tangent is not less than one of the above-mentioned values, and the maximum value of the waviness tangent is not less than one of the above-mentioned values.

In the above statement, the upper limit of the minimum value of the waviness tangent is generally $9.00 \times 10^{-6}$, preferably $8.5 \times 10^{-6}$; and the upper limit of the maximum value of the waviness tangent is generally $100 \times 10^{-6}$, preferably $90 \times 10^{-6}$, more preferably $88 \times 10^{-6}$, even more preferably $70 \times 10^{-6}$, still more preferably $60 \times 10^{-6}$, and most preferably $50 \times 10^{-6}$.

The above-mentioned preferred range is a standard range of the waviness tangent of unpolished glass produced by using the method of float process, and though inexpensive, the glass of the type can be favorable to prevent device defects such as short-circuit and/or leakage as a result of control for constituents and thickness of the charge injection layer to be mentioned below.

As described above, the degree of waviness of the glass baseplate or the glass substrate to be used in the present invention is one characteristic feature of the invention. For the glass baseplate or the glass substrate, usable here are those of commercially available glass or glass produced by using known methods, of which the measured waviness satisfies the above, and in general, the glass baseplate or the glass substrate may be selected from glass, preferably unpolished glass produced by using the method of float process.

On the glass baseplate, the first conductive layer is formed generally by using a vapor-phase growth method such as a sputtering method, a vacuum evaporation method or the like, and therefore, the layer is formed on the glass baseplate almost conformally along the surface texture of the glass baseplate. Accordingly, the value of the waviness tangent of the glass baseplate on which the first conductive layer has been formed is almost the same as that of the glass substrate. The value of the waviness tangent of the surface of the first conductive layer in the case where the first conductive layer is formed by using any other method than vapor-phase growth may differ from the value of the waviness tangent of the surface of the original baseplate, and therefore, the waviness tangent of the baseplate surface of its own is to be evaluated here.

The definition of waviness tangent and the measurement method for waviness tangent are as follows.

For the definition relating to waviness of surface, basically used is "JIS B0601:2001 - Geometrical Product Specifications (GPS) - Surface texture: Profile method - Terms, definitions and surface texture parameters". According to this, waviness is defined as the surface texture parameter calculated by referring to the contents described in "3.1.7 Waviness profile". Of waviness profiles, those derived from data processing are referred to as filtered waviness profiles. Cutoff values and profile filters are described in JIS B0632 2.6 (Transmission band for profile) and 3.2 (Transmission characteristic). A measurement method for waviness tangent is concretely described below.

First, for determining filtered waviness profiles, the surface of the glass baseplate or the like is analyzed with predetermined equipment for measurement to give traced profiles. In this, it is desirable that the length to be measured, or that is, the evaluation length In is defined to be not less than the reference length lw (in the case of waviness, this is equal to $\lambda f$), preferably not less than 3 times the reference length lw, more preferably not less than 5 times lw. It is preferable that the obtained data of the traced profiles are digitalized, and can be rapidly processed in various data processing modes with computers, etc.

Here, some predetermined equipment for measurement is mentioned. A surface texture analyzer has the intended function and includes various modes of a stylus method (mechanical, optical canti-lever), an optical method (white light interference, laser interference, laser ranging) or the like, and the analyzer is suitably selected depending on the subject to be analyzed therewith. More concretely, the equipment may be selected among an optical interferometric surface texture analyzer (Ryoka Systems' VertScan), a stylus optical canti-lever surface texture analyzer (KLA-Tencor's P-15, Tokyo Seimitsu's Surfcom), etc. In this, depending on the type of the analyzer, the above-mentioned "definition relating to waviness" is not according to JIS B0601:2001 but according to the previous version JIS B0601:'94 or the like. However, such case can be also adoptive here so far as the relationship thereof to correspond with JIS B0601:2001 is clear.

To the resultant traced profile data, applied are profile filters of wavelength cutoff value $\lambda f$ for the long wavelength and of wavelength cutoff value $\lambda c$ for the short wavelength, thereby obtaining filtered waviness profiles. Concretely, cutoff values $\lambda f$ = 8.0 mm and $\lambda c$ = 0.8 mm are adopted to obtain a filtered waviness profile having good reproducibility.

Here, it is to be noted that, depending on the shape of the original glass baseplate and the like as well as deviation from the shape and on warpage or deformation, if any, of the glass baseplate and the like, these must be carefully distinguished from waviness and must be removed from the profile data. Those difference to be distinguished from the waviness are filed in a type of profiles as a collective term of "profile deviation", and before processing through the $\lambda f$ profile filter, these must be carefully removed by using the method of least squares.

From the resultant filtered waviness profiles, the following parameters are defined as waviness profile parameters.

(1) Average line

The average line is a curve that expresses the long wavelength component to be cut off by the low-pass $\lambda f$ filter (see JIS B0632 3.2). This may be also expressed as an X-axis.

(2) Extracted waviness profile element (curve comprising mountain and valley adjacent thereto)

Regarding the definition of mountain and valley, these are defined as to how they are higher or lower than the average line. In general, the minimum difference to be determined to be a mountain or a valley is regulated by the percentage of the maximum height (Wz) of the waviness profile. In the present invention, it is defined as mountain or valley that the part of the difference with Wz is not less than 10%.

(3) Profile element width: Xs

The profile element width is the length of the line segment of the X-axis cut off by the profile element. In general, the minimum length in the horizontal direction is regulated by the percentage of the reference length lw. In the present invention, in the case where the segment length measured is not less than 10% of lw, the measured value is taken into account as Xs.

(4) Waviness height

Difference between the mountain height and the valley depth in the extracted waviness profile element.

(5) Wz-min

The minimum value of waviness height.

(6) Wz

The maximum value of waviness height.

(7) Xs-min

The minimum value of extracted waviness profile element width.

(8) Xs-max

The maximum value of extracted waviness profile element width.
(9) The waviness tangent, and its minimum value and maximum value are defined as follows:

$$\text{Waviness tangent} = \{(\text{mountain height}) - (\text{valley depth})\}/\text{Xs}$$

The minimum value of waviness tangent = Wz-min/Xs-max
The maximum value of waviness tangent = Wz/Xs-min
Here, the waviness tangent is not limited to one calculated from the combination of the values measured with one waviness profile element, but may include any others obtained from one and the same sample as the measured values thereof, or that is, the measured values may be combined in any desired manner to provide the waviness tangent.
However, in a case having little waviness, the waviness tangent could not be calculated as the case may be. In the case, "calculation impossible", or to the limit of "Wz $\rightarrow$ 0, Xs-max $\rightarrow \infty$", "0/$\infty$" is given to the expression.
In case where the glass baseplate or the glass substrate to be used in the present invention is provided with partitions to partition an organic electroluminescent device, such as supplemental electrodes, the contact area between the glass baseplate or the like and the partition would increase since the waviness of the glass baseplate or the glass substrate in the present invention is larger than that of already-existing glass baseplates and the like, and therefore, an additional effect of increasing the adhesion strength of the partitions to the baseplate or the like can be expected.
A barrier layer of $SiO_2$ having a thickness ranging from 10 to 30 nm or so may be arranged on the surface of the glass baseplate 1 towards the first conductive layer and between the glass baseplate and the first conductive layer, for the purpose of prevention of alkali constituents dissolution from the glass baseplate.
An anode or a cathode may be provided as the first conductive layer on the baseplate. In case where an anode is provided as the first conductive layer on the baseplate, the charge injection and transport layer is a hole injection and transport layer, the charge injection layer is a hole injection layer, and the second conductive layer is a cathode. In case where a cathode is provided as the first conductive layer on the baseplate, the charge injection and transport layer is an electron injection and transport layer, the charge injection layer is an electron injection layer, and the second conductive layer is an anode. Hereinafter the case where an anode is provided on the baseplate as the first conductive layer and where a hole injection and transport layer is provided as the charge injection and transport layer is described in detail.

[Anode]

In case where an anode is provided on the baseplate, the anode is the first conductive layer in the present invention.
The anode 2 is an electrode that plays a role of hole injection source into the layers towards the light-emitting layer 5.
The anode 2 is required to have an electric conductivity on a certain level or more for applying a sufficient electric voltage to the entire surface of the organic electroluminescent device. In general, in addition, since the light emitted by the organic electroluminescent device is taken out from the side of the baseplate, the anode is required to have transmittance on a certain level or more.
In general, the anode 2 is formed of a metal such as aluminium, gold, silver, nickel, palladium, platinum, etc.; a metal oxide such as indium and/or tin oxide, etc.; a metal halide such as copper iodide, etc.; carbon black; or a

conductive polymer such as poly(3-methylthiophene), polypyrrole, polyaniline, etc. For satisfying the above-mentioned required performance, a metal oxide such as indium and/or tin oxide or the like (hereinafter expressed as ITO) is used as the most preferred material.

A thin conductive inorganic film may be formed on the surface of ITO or the like for the purpose of improving the performance of hole injection into the organic EL layer. In the present invention, such a thin conductive inorganic film is considered to be included in the first conductive layer. The thin conductive inorganic film includes, for example, a light-permeable metal thin film or a light-semipermeable metal thin film, or a metal oxide film of molybdenum oxide or vanadium oxide or the like.

To form the anode 2 of the first conductive layer, adoptive can be any known method of a sputtering method, a vacuum evaporation method, a coating method or the like, depending on the material to be used for the anode 2. In case where ITO is used as the anode material, preferred is a sputtering method in view of the productivity and the easiness in control of characteristics. To form the above-mentioned, thin conductive inorganic film, adoptive can be a sputtering method or a vacuum evaporation method, but preferred is a vacuum evaporation method in view of the productivity and the easiness in control of characteristics.

The thickness of the anode 2 may be suitably selected in accordance with the requirement of transparency and electric conductivity thereof. In case where transparency is required for the first priority, it is desirable that the transmittance in the range of visible light is equal to or more than generally 60%, preferably 80%. In this case, the thickness of the anode 2 is equal to or more than generally 5 nm, preferably 10 nm. Also in this case, the thickness of the anode 2 is equal to or less than generally 1000 nm, preferably 500 nm or so.

Density of the surface defects in the state where the anode of the first conductive layer has been formed on the glass baseplate is described in detail.

As described above, the glass baseplate in the present invention has many surface defects. The surface defects of the glass baseplate are defects formed in the production process for the glass baseplate, and hereinafter these are referred to as "glass defects". The glass defects are categorized into "=internal defects in glass" and "=surface defects on glass", and the respective glass defects involve various modes (categories defined according to cause of defects, morphology and modality thereof).

For example, "=internal defects in glass" include impurities (inclusions) except glass materials having mixed in molten glass, "internal bubbles" having mixed in molten glass, " phase separation" to form stripes through segregation of glass compositions during cooling, etc.; and "surface defects on glass" include "bubbles-derived hollows" of such that unremoved internal bubbles have floated up to the surface of sheet glass during cooling to form hollows on the sheet surface, "drips (also referred to as top specks)" of such that a vapor of molten tin has re-aggregated on the ceiling of a pool furnace to form liquid droplets and the droplets have dripped onto sheet glass being cooled, flaws to be formed by contact with solid such as conveyor rolls in glass baseplate production plants, etc.

Heretofore, in case where a glass baseplate is used for organic electroluminescent devices, a production method capable of producing a glass baseplate having few glass defects must be adopted, or the glass baseplate produced must be polished for removing the glass defects.

The reason for reducing or removing glass defects is that, when a glass baseplate having many glass defects is used and when the first conductive layer is formed thereon, then the first conductive layer could not be formed locally near the glass defects to provide pin holes, or since the first conductive layer is formed on the projections resulting from drips or flaws, the organic thin film of the light-emitting layer or the like to be formed later would be locally thinned, or would not be formed, and as a result, the distance between the first conductive layer and the second conductive layer would get thinner so that the two layers would get much closer to each other, or as the case may be, the two layer would come in direct contact with each other, thereby providing unfavorable electric failures of device defects such as short-circuit or leakage.

The surface defects of the glass baseplate to result in such device defects are not only derived from the glass baseplate itself but also may be generated in the step of forming the first conductive layer. For example, there are mentioned flaws to be formed through contact with solid such as conveyor rolls in film formation plants. In addition, in a case where the first conductive layer is formed of a transparent conductive material, indium tin oxide (ITO) by using a sputtering method, it is desirable that the layer thickness is within a range of about 500 nm or less as described above, but such a thin layer involves various problems in that adhesiveness thereof to the glass baseplate may get locally worse owing to adhesion of debris or particles thereto in the thin-layer forming step, and that the ITO thin layer once formed would peel off during the subsequent process, and further that the peeled film would re-adhere to the baseplate to form protrusion-like defects. There is an extremely high possibility that such film-peeling sites or protrusion -like defects of the ITO thin film would provide electrical device defects of short-circuit and/or leakage, like the glass defects formed in the state of the glass baseplate.

Naturally, when the density of the surface defects in the state where the first conductive layer has been formed is higher, then the degree of electrical device defects of short-circuit and/or leakage would increase more as a whole of organic electroluminescent devices. The density of the surface defects can be reduced by using a glass baseplate

produced by using a method of fusion process, or by polishing the surface of the glass baseplate produced by using the method of float process, as described above; however, the density of the surface defects in the glass substrate to be used in the present invention is higher than that in these glass baseplates. Like in the case of waviness, the present inventors have investigated the density of the surface defects of glass baseplate of various glass manufacturers, produced by using the method of float process or a method of fusion process, in the state where a film of ITO has been formed therein in a thickness of 110 nm or 150 nm, and as a result, have found that the density of the surface defects of the glass baseplate in the present invention is equal to or more than generally 2.0 defects/$cm^2$. The upper limit of the density of the surface defects is preferably equal to or less than 16.0 defects/$cm^2$.

The surface defects in the state where the first conductive layer has been formed on the glass baseplate in the present invention are defined as follows. Specifically, the surface defects in the present invention are, based on the surface of the first conductive layer as the datum plane, hollow-shaped or protrusion-shaped abnormalities relative to the datum plane, of which the size projected on the datum plane is ranging from 5 μm to 200 μm as the major axis thereof. The density of the surface defects in the present invention is measured as follows. The surface defects of the glass baseplate are viewed with an optical microscope, then the existence frequency thereof is measured (that is, the number of the surface defects are counted) in a planned measurement region, and is normalized with the area of the region to calculate the density of the surface defects.

The magnifying power adjustment of the optical microscope as well as the distinction of bright field, dark field and differential interference observation could be made often based on the experience of the person in charge of measurement. Preferably, using a settled mode for surface defects suitably sorted, the person measures the number of the surface defects with settling and using optical microscope in such a manner that the appearance of the surface defects could be accurately detected.

In the present invention, the density of the surface detects is determined concretely as follows. A large number of various glass baseplates are previously analyzed to check and classify the surface defects therein, and then the mode of the surface defects is settled. With that, for the glass baseplate that is required to analyze for the surface defects thereof, the first conductive layer is patterned as rectangles having a size of 7 mm × 10.5 mm squared to be a sample. Four samples are observed with an optical microscope, and the surface defects are counted for each samples, the measured data are normalized with the rectangle area to calculate the density of the surface defects, and the resultant data are averaged via four samples to obtain a mean value. Regarding the condition to be settled for the microscopic observation, the objective lens power is 20 magnifications, and the ocular lens power is 10 magnifications. Under the settled condition, the minimum size among the surface defects that can be recognized are enlarged to a size of about 1 mm in the field of view of the ocular lens. For observation, mainly used is a bright field, so a dark field and differential interference observation are suitably used. The type of microscope is properly used to distinguish the surface defects from any other deposits.

[Hole Injection and Transport Layer]

The hole injection and transport layer is the charge injection and transport layer in the present invention.

In the present invention, the hole injection and transport layer 11 containing a hole transport material is formed between the anode 2 and the light-emitting layer 5 by using a wet method of film formation. The hole injection and transport layer 11 functions to transport the holes injected from the anode 2 to the light-emitting layer 5 and may be formed of one layer, but, as shown in Fig. 1, preferably has a two-layer structure composed of the hole injection layer 3 formed by using a wet method of film formation and the hole transport layer 4 formed by using a wet method of film formation. The hole injection layer 3 is the charge injection layer in the present invention, and comes in contact with the anode of the first conductive layer in the present invention.

In the present invention, the charge injection and transport layer contains an aromatic amine polymer, and therefore the layer is preferably a hole injection and transport layer.

In the present invention, the reason why the hole injection and transport layer 11 is formed by using a wet method of film formation is as follows.

In the state where the first conductive layer is formed on the baseplate in the present invention, the density of the surface defects is large as mentioned above, and in this condition, there is an extremely high risk of causing electrical device defects of short-circuit and/or leakage.

However, as a result of assiduous studies, the present inventors have found that, even in a glass baseplate produced by using a wet method of film formation and therefore having many surface defects existing in a high density therein, the risk of occurring short-circuit and/or leakage can be reduced by covering the surface defects thereof and planarizing the surface of the baseplate.

The result could not be attained if a wet method of film formation is not adopted, or that is, the result is not obtained at all in any other dry method of film formation such as a vacuum evaporation method or the like.

The reason is because, in a dry film formation method, various surface defects in the surface of the above-mentioned first conductive layer could not be sufficiently covered by organic electroluminescent device materials such as the charge injection and transport layer and others, and as a result, the second conductive layer to be formed later on and the first conductive layer are kept in direct contact with each other or the two will face to each other via an extremely thin organic electroluminescent device material provided therebetween, consequently resulting in that, when an voltage is applied between the first conductive layer and the second conductive layer for light emission, the two will cause short-circuit when kept in direct contact with each other, or will cause leakage when facing to each other via an extremely thin organic electroluminescent device material provided therebetween.

Adopting the wet method of film formation has brought about a significant solution to the problem of covering various surface defects. Specifically, just by using the wet method of film formation, an organic electroluminescent device material can fully cover even the back side of the uneven surfaces of the hollows and/or the protrusions of the surface defects, therefore preventing the first conductive layer and the second conductive layer from direct contact with each other or from facing extremely close to each other via an extremely thin organic electroluminescent device material provided therebetween.

Further, the present inventors have found that, for realizing the above-mentioned effect, merely using the wet method of film formation is still insufficient. Specifically, the present inventors have found that, when the condition that the thickness of the charge injection and transport layer formed in contact with the first conductive layer is at least 1.3 times the thickness of the first conductive layer (the fourth and fifth aspects of the present invention), or the thickness of the charge injection and transport layer is from 130 to 1000 nm (the first and second aspects of the present invention) is not satisfied, then a sufficient effect of preventing leakage could not be realized.

In the fourth and fifth aspects of the present invention, the thickness of the charge injection and transport layer is at least 1.3 times the thickness of the first conductive layer. This reason would be presumed so that, when the thickness of the first conductive layer is larger, the unevenness of the hollows and the protrusions of the surface defects would increase more owing to peeling off or re-deposition of the first conductive layer, and therefore the thickness of the charge injection and transport layer to cover the unevenness must be large. The thickness of the charge injection and transport layer is at least 1.3 times the thickness of the first conductive layer, preferably at least 1.5 times, more preferably at least 1.8 times. The upper limit of the thickness of the charge injection and transport layer is at most 6.0 times the thickness of the first conductive layer, preferably at most 5.0 times to prevent absorption of light emitted from light-emitting material.

In case where the thickness of the first conductive layer is small, the influence of the glass defects would be relatively larger than that of the surface defects caused by the first conductive layer, and therefore in the first aspect of the present invention, the thickness of the charge injection and transport layer is equal to or more than 130 nm, more preferably 150 nm, even more preferably 200 nm. The upper limit of the thickness of the charge injection and transport layer is equal to or less than generally 1000 nm to prevent absorption of light emitted from light-emitting material, preferably 700 nm, more preferably 500 nm, even more preferably 400 nm.

Single surface defects could not achieve these definitions, and it is presumed that when the density of the surface defects is not so high as to exceed a certain level as in the glass baseplate in the present invention, the definitions could not be found out.

The reason why these definitions could not be found out is described. In a state where surface defects exist alone, leakage, if any, would be often extremely small, and therefore it is often so considered that such a phenomenon could not be recognized as leakage or no leakage would have occurred. However, in a case of a glass baseplate having a large surface defect density, it is presumed that for the reason that the threshold as to whether leakage could be recognized as such or could not be recognized would be much amplified with even a slight difference for thickness of the charge injection and transport layer owing to the high surface defect density of the glass baseplate as compared with a glass baseplate having a low surface defect density, and as a result, the leakage current would be susceptibly detected as such. Specifically, it is considered that the high surface defect density would be a significant factor of leakage recognition or leakage detection threshold increase.

In other words, it is considered that, as having such a high surface defect density, the glass baseplate could provide the effect of increasing the threshold level of the leakage current detection limit, therefore the definition of the thickness of the charge injection and transport layer relative to the thickness of the first conductive layer could be more clearly defined.

The thickness of the charge injection and transport layer formed by using a wet method of film formation in the present invention is as described above, and the value tends to be larger than the thickness of the charge injection layer of an organic electroluminescent device produced using an already-existing glass baseplate. Accordingly, in a case where the material of the glass baseplate is alkali glass, the influence of alkali constituents out-dissolution can be prevented and therefore it is considered that the present invention can contribute toward lifetime prolongation of organic electroluminescent devices.

As the material for the hole injection layer 3 and the hole transport layer 4, any known hole transport material may be suitably used. However, in the first and second aspects of the present invention, the layer must contain a crosslinked aromatic amine polymer, as will be described below; and in the third and fourth aspects of the present

invention, the layer must contain a crosslinking group-having aromatic amine polymer, as will be described below.

[Material of Hole Injection Layer]

The material to be used for the hole injection layer 3 that is the charge injection layer in the present invention is preferably as described below.

The material to be used for the hole injection layer 3 is preferably a compound having an ionization potential of from 4.5 eV to 6.0 eV, from the viewpoint of the charge injection barrier from the anode to the hole injection layer, but from the viewpoint of amorphousness and visible light transmittance, preferred is an aromatic amine compound and more preferred is an aromatic tertiary amine compound. Here, the aromatic tertiary amine compound is a compound having an aromatic tertiary amine structure. As the aromatic tertiary amine compound, preferably used is a polymer compound (a polymeric compound comprising repeating units continuing therein) having a weight-average molecular weight of from 1,000 to 1,000,000, and the compound has a crosslinking group. In case where a layer is further formed and laminated on the hole injection layer by using a wet method of film formation, it is desirable that the compound has a crosslinking group. The hole injection layer can have an increased conductivity through oxidation of the hole transport compound therein, and therefore it is desirable that the layer contains an electron-accepting compound. As specific examples of the electron-accepting compound, herein mentioned are those described in JP-A 2006-233162; and as specific examples of the crosslinking group-having aromatic tertiary amine compound, mentioned are those described in JP-A 2009-287000.

[Material of Hole Transport Layer]

The material to be used for the hole transport layer 4 is preferably as follows.

The material to be used for the hole transport layer 4 is a material having hole transportability, and from the viewpoint of amorphousness and visible light permeability, preferred is an aromatic compound and more preferred is an aromatic tertiary amine compound. Here, the aromatic tertiary amine compound is a compound having an aromatic tertiary amine structure. As the aromatic tertiary amine compound, preferably used is a polymer compound (a polymeric compound comprising repeating units continuing therein) having a weight-average molecular weight of from 1,000 to 1,000,000, and the compound may have a crosslinking group. In case where a layer is further formed and laminated on the hole transport layer by using a wet method of film formation, it is desirable that the compound has a crosslinking group. As specific examples, herein mentioned are those described in JP-A 2009-287000. In case where the hole transport layer 4 is formed by using a wet method of film formation, the layer is included in the category of the charge injection and transport layer in the present invention.

[Crosslinked Aromatic Amine Polymer]

Of the above, in the first and second aspects of the present invention, the charge injection and transport layer contains a crosslinked aromatic amine polymer; and in the third and fourth aspects of the present invention, the charge injection and transport layer is formed by coating, by using a wet method of film formation, a composition that contains a crosslinking group-having aromatic amine polymer, and drying and crosslinking the coating. The crosslinked aromatic amine polymer to be contained in the charge injection and transport layer will be described below. In the first to fourth aspects of the present invention, the charge injection and transport layer contains a crosslinked aromatic amine polymer and therefore can prevent short-circuit and/or leakage. The reason is considered as follows.

Since the "crosslinking group-having aromatic amine polymer" has a crosslinking group, the layer formed by coating and drying with the polymer could be a dense organic thin film as a result of crosslinking treatment applied thereto. This provides a dielectric breakdown strength that could not be realized with an aromatic amine polymer or any other polymer not having any crosslinking group.

Moreover, the layer is a crosslinked film, and therefore even when an additional layer is formed by coating thereon, the crosslinked film layer is hardly dissolved by the solvent contained in the coating composition. Consequently, when a second layer is further formed, it is possible to prevent the trouble that the acute edges of the hollows and the protrusions that have been covered with the first layer are exposed to lose the effective role of coating the second layer.

Electrostatic breakdown (dielectric breakdown) all the time occurs since the electrons inside a solid are accelerated by an external electric field and collide against the atoms constituting the solid to ionize them. It is known that dielectric breakdown of solid is a thermal breakdown mode at a temperature higher than a certain level (critical temperature), and the voltage to cause insulation breakdown of solid (insulation breakdown voltage) extremely smoothly decreases with temperature rising. The temperature at which the dielectric breakdown voltage rapidly decreases is referred to as a critical temperature, and in an dielectric breakdown phenomenon at a temperature lower than the critical temperature, dielectric breakdown voltage does not almost depend on temperature.

It is known that at a temperature lower than the critical temperature, the dielectric breakdown voltage is proportional to the thickness of the solid sample under test. Specifically, an dielectric breakdown field intensity (or simply a breakdown strength) can be defined, which is calculated by dividing the breakdown voltage by the thickness of the sample under test. This corresponds to the mechanism of dielectric breakdown generation described above.

Here, there is a fact that when the same voltage is applied to the two solid samples under test having the same thickness, then the electric field intensity inside the solid is larger when the relative permittivity of the solid is nearer to 1 (that is, the electric field intensity inside the solid is inversely proportional to the permittivity of the solid). In other words, when the relative permittivity is further larger than 1, then the electric field intensity inside the solid is further lower than the dielectric breakdown field intensity.

Here, as obvious when the classic Clausius-Mossotti relation is recalled, the relative permittivity depends on the product of the degree of polarization and the density, and therefore, for increasing the relative permittivity at the same degree of polarization (the atoms and the molecules to constitute the solid are the same), it is necessary to increase the density.

From the above, it is known that increasing the relative permittivity of the solid sample under test gets the electric field intensity inside it lower as compared with the dielectric breakdown field intensity, therefore dielectric breakdown can hardly take place, and that for increasing the relative permittivity, the density must be increased when the atoms and the molecules constituting the solid are the same. In other words, it is understood that increasing the density (increasing the density of the solid with crosslinking) may make it difficult to cause dielectric breakdown (that is, the dielectric breakdown strength is thereby increased).

Dielectric breakdown occurs locally in the sample under test, likely film. In a thinner film, possibility increases that the device undergoes short-circuit owing to the dielectric breakdown connected between both surfaces of the film, but in a thick film, dielectric breakdown hardly occurs to cause short-circuit. In general, a film having a thickness equal to or more than 100 nm hardly occurs short-circuit owing to dielectric breakdown, but a locally large current would flow through local dielectric breakdown in the film. In current measurement by voltage applied to both surfaces of a film, leakage current could be detected as the current increment. As described above, since leakage occurs owing to local dielectric breakdown, more hardly dielectric breakdown occurs in the film, more hardly leakage occurs. Accordingly, of the two films having the same thickness, a crosslinked one is preferred as hardly leakage occurs.

Dielectric breakdown tends to occur more frequently when the electric field intensity (=applied voltage divided by film thickness) is higher. Therefore, a dielectric breakdown hardly occurs in a sufficiently thick film unless a fairly high voltage is applied thereto, and accordingly, leakage hardly occurs in the film. On the other hand, in an organic electroluminescent device, the voltage to be applied to obtain a necessary brightness is not always proportional to the thickness of the organic layers including the charge transport layer and the light-emitting layer. Consequently, the voltage is not increased proportionally to the increase in the thickness of the charge transport layer, and therefore, the electric field intensity applied to the charge transport layer lowers with increase in the thickness of the charge transport layer and dielectric breakdown hardly occurs in the layer. In other words, the layer is resistant to leakage. Resistance to leakage means that the probability of leakage incidence is low. Leakage incidence ratio can be accurately estimated by increasing the number of samples to be analyzed. Dielectric breakdown occurs when the applied voltage changes and becomes higher than the dielectric breakdown field intensity, and therefore, analyzing samples with changing the voltage applied thereto facilitates leakage detection.

In general, the thickness of the charge transport layer is on a level of at most 100 nm or so, and therefore, when the thickness is increased by 5 times to be 500 nm, the electric field intensity could not be on the same level unless the voltage to be applied is also increased by 5 times. However, in an actual organic electroluminescent device, in general, the voltage may be increased by a few tens % to obtain a necessary brightness. Accordingly, in a case where the thickness of the charge transport layer is relatively large, dielectric breakdown hardly occurs in the layer even though not crosslinked. As a result, the leak incidence ratio could be a low value though could not be 0. However, since the density of the non-crosslinked film is not changed, leakage hardly occurs in the crosslinked film because the density of the crosslinked film is large compared to the one of the non-crosslinked film. Accordingly, it is desirable that even a film having a relatively large thickness is crosslinked as more hardly undergoing leakage than an non-crosslinked film.

Further, it is considered that a local electric field is readily influenced by the surface profile of the substrate, and therefore, it is desirable that the layer in contact with the substrate is crosslinked because dielectric breakdown hardly occurs in the layer in contact with the baseplate, or that is, leakage hardly occurs in the layer. The layer in contact with the baseplate is generally a charge injection layer, and therefore, it is desirable that the charge injection layer is crosslinked.

Assuming that films are uniform, and the electric field intensity in them is the same, it may be considered that a thicker film would have a large number of sites where dielectric breakdown may occur. Accordingly, in case where the charge injection and transport layer is formed of different films, it is considered that dielectric breakdown would occur in the layer formed of a thicker film, and therefore it is desirable that the thickest film of those different films stacked is crosslinked.

The crosslinked aromatic amine polymer and the charge injection and transport layer containing the polymer are described below.

[Aromatic Amine Polymer]

The crosslinked aromatic amine polymer is produced by crosslinking a crosslinking group-having aromatic amine polymer.
The crosslinking a crosslinking group-having aromatic amine polymer is described below.
The crosslinking group-having aromatic amine polymer in the present invention contains a partial structure represented by the following formula (1):
[Chem. 3]

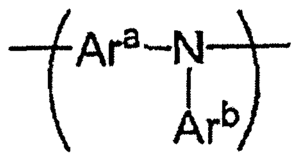

(1)

(In the formula (1), $Ar^a$ and $Ar^b$ each independently represent an aromatic hydrocarbon-cyclic group or an aromatic heterocyclic group having from 4 to 60 carbon atoms and optionally having a substituent, and $Ar^a$ is a divalent group, and $Ar^b$ is a monovalent group.)
The aromatic hydrocarbon-cyclic group includes, for example, a 5- or 6-membered, single ring or 2- to 5-condensed ring having one or two free atomic valences, such as a benzene ring, a naphthalene ring, a phenanthrene ring, an anthracene ring, a triphenylene ring, a chrysene ring, a naphthacene ring, a perylene ring, a coronene ring, an acenaphthene ring, a fluoranthene ring, a fluorene ring, etc., and rings formed of some of these rings directly bonding to each other, etc. Here, in the present invention, the free atomic valence is one capable of forming a bond with any other free atomic valence, as described in Organic Chemistry, Biochemical Nomenclature (Vol. 1) (revised version of 2nd edition, issued by Nanko-do in 1992). Concretely, for example, "a benzene ring having one free atomic valence" is a phenyl group, and "a benzene ring having two free atomic valences" is a phenylene group.
The aromatic heterocyclic group includes, for example, a 5- or 6-membered, single ring or 2- to 4-condensed ring having one or two free atomic valences, such as a furan ring, a benzofuran ring, a thiophene ring, a benzothiophene ring, a pyrrole ring, a pyrazole ring, an imidazole ring, an oxadiazole ring, an indole ring, a carbazole ring, a pyrroloimidazole ring, a pyrrolopyrazole ring, a pyrrolopyrrole ring, a thienopyrrole ring, a thienothiophene ring, a furopyrrole ring, a furofuran ring, a thienofuran ring, a benzisoxazole ring, a benzisothiazole ring, a benzimidazole ring, a pyridine ring, a pyrazine ring, a pyridazine ring, a pyrimidine ring, a triazine ring, a quinoline ring, an isoquinoline ring, a cinnoline ring, a quinoxaline ring, a phenanthridine ring, a perimidine ring, a quinazoline ring, a quinazolinone ring, an azulene ring, a triazine ring, etc., and rings formed of some of these rings directly bonding to each other, etc.
Here, when the aromatic hydrocarbon-cyclic group or the aromatic heterocyclic group is a condensed ring having one or two free atomic valences, the number of the single rings constituting the condensed ring is preferably smaller from the viewpoint of the stability of the ring, and is preferably 8 or less, more preferably 5 or less. On the other hand, the lower limit of the number is 2. The aromatic hydrocarbon-cyclic group or the aromatic heterocyclic group is preferably, having one or two free atomic valences, a single ring such as a benzene ring, a thiophene ring, a pyridine ring or the like; a condensed ring such as a naphthalene ring, an anthracene ring, a phenanthrene ring, a triphenylene ring, a pyrene ring or the like; or an aromatic hydrocarbon ring formed through condensation of from 2 to 8 aromatic rings such as a fluorene ring, a biphenyl, a terphenyl or the like, from the viewpoint of the solubility and the heat resistance. Of those, more preferred is a benzene ring, a fluorene ring, a biphenyl or a terphenyl having one or two free atomic valences, from the viewpoint of realizing high solubility and high stability.
In case where the aromatic amine polymer forms a hole injection layer, most preferred for $Ar^a$ are a benzene ring, a biphenyl and a terphenyl having one or two free atomic valences, from the viewpoint of realizing excellent charge injection from the first conductive layer and realizing excellent charge transportation inside the hole injection layer.
The substituent that the aromatic hydrocarbon-cyclic group or the aromatic heterocyclic group may have includes a saturated hydrocarbon group having from 1 to 20 carbon atoms, an aromatic hydrocarbon-cyclic group having from 6 to 25 carbon atoms, an aromatic heterocyclic group having from 3 to 20 carbon atoms, a diarylamino group having from 12 to 60 carbon atoms, an alkyloxy group having from 1 to 20 carbon atoms, a (hetero)aryloxy group having from 3 to 20 carbon atoms, an alkylthio group having from 1 to 20 carbon atoms, a (hetero)arylthio group having from 3 to 20

carbon atoms, a cyano group, etc. Of those, preferred are a saturated hydrocarbon group having from 1 to 20 carbon atoms and an aromatic hydrocarbon-cyclic group having from 6 to 25 carbon atoms, from the viewpoint of solubility and heat resistance.

Concretely, the saturated hydrocarbon group having from 1 to 20 carbon atoms includes a methyl group, an ethyl group, a propyl group, an isopropyl group, a butyl group, an iso-butyl group, a sec-butyl group, a tert-butyl group, a hexyl group, an octyl group, a cyclohexyl group, a decyl group, an octadecyl group, etc. Of those, preferred are a methyl group, an ethyl group and an isopropyl group, from the viewpoint of the availability and the inexpensiveness of the source materials, and more preferred are a methyl group and an ethyl group.

The monovalent aromatic hydrocarbon-cyclic group having from 6 to 25 carbon atoms includes a phenyl group; a naphthyl group such as a 1-naphthyl group, a 2-naphthyl group, etc.; a phenanthyl group such as a 9-phenanthyl group, a 3-phenanthyl group, etc.; an anthryl group such as a 1-anthryl group, 2-anthryl group, a 9-anthryl group, etc.; a naphthacenyl group such as a 1-naphthacenyl group, a 2-naphthacenyl group, etc.; a chrysenyl group such as a 1-chrysenyl group, a 2-chrysenyl group, a 3-chrysenyl group, a 4-chrysenyl group, a 5-chrysenyl group, a 6-chrysenyl group, etc.; a pyrenyl group such as a 1-pyrenyl group, etc.; a triphenylenyl group such as a 1-triphenylenyl group, etc.; a coronenyl group such as a 1-coronenyl group, etc.; biphenyl group such as a 4-biphenyl group, a 3-biphenyl group, etc.; a group having a fluoranthene ring, a group having a fluorene ring, a group having an acenaphthene ring, a substituent having a benzopyrene ring, etc. Of those, preferred are a phenyl group, a 2-naphthyl group and a 3-biphenyl group from the viewpoint of the stability of the compound, and more preferred is a phenyl group from the viewpoint of easiness in purification.

The aromatic heterocyclic group having from 3 to 20 carbon atoms includes a thienyl group such as a 2-thienyl group, etc.; a furyl group such as a 2-furyl group, etc.; an imidazolyl group such as a 2-imidazolyl group, etc.; a carbazolyl group such as a 9-carbazolyl group, etc.; a pyridyl group such as a 2-pyridyl group, etc.; a triazinyl group such as a 1,3,5-triazin-2-yl group, etc. Of those, preferred is a carbazolyl group and more preferred is a 9-carbazolyl group from the viewpoint of stability.

The diarylamino group having from 12 to 60 carbon atoms includes a diphenylamino group, an N-1-naphthyl-n-phenylamino group, an N-2-naphthyl-N-phenylamino group, an N-9-phenanthryl-N-phenylamino group, an N-(biphenyl-4-yl)-N-phenylamino group, a bis(biphenyl-4-yl)amino group, etc. Of those, preferred are a diphenylamino group, an N-1-naphthyl-N-phenylamino group, and an N-2-naphthyl-N-phenylamino group, and more preferred is a diphenylamino group from the viewpoint of stability.

The alkyloxy group having from 1 to 20 carbon atoms includes a methoxy group, an ethoxy group, an isopropyloxy group, a cyclohexyloxy group, an octadecyloxy group, etc.

The (hetero)aryloxy group having from 3 to 20 carbon atoms includes a substituent having an aryloxy group such as a phenoxy group, a 1-naphthyloxy group, a 9-anthranyloxy group, or the like, or a heteroaryloxy group such as a 2-thienyloxy group, etc.

The alkylthio group having from 1 to 20 carbon atoms includes a methylthio group, an ethylthio group, an isopropylthio group, a cyclohexylthio group, etc.

The (hetero)arylthio group having from 3 to 20 carbon atoms includes an arylthio group such as a phenylthio group, a 1-naphthylthio group, a 9-anthranylthio group, etc.; and a heteroarylthio group such as a 2-thienylthio group, etc.

In case where the aromatic amine polymer in the present invention has an aromatic amine structure to which any other group than an aromatic hydrocarbon-cyclic group or an aromatic heterocyclic group bonds (aromatic amine structure not included in the above-mentioned general formula (1)), in the partial structure thereof, the other group than an aromatic hydrocarbon-cyclic group or an aromatic heterocyclic group is preferably an aliphatic hydrocarbon group having from 1 to 70 carbon atoms. In particular, in the structure corresponding to the formula (1), it is desirable that the groups corresponding to $Ar^a$ and $Ar^b$ each independently represent an aromatic hydrocarbon-cyclic group or an aromatic heterocyclic group having from 4 to 60 carbon atoms, or an aliphatic hydrocarbon group having from 1 to 70 carbon atoms, the group corresponding to $Ar^a$ is a divalent group, the group corresponding to $Ar^b$ is a monovalent group, and at least any of the groups corresponding to $Ar^a$ and $Ar^b$ is preferably an aliphatic hydrocarbon group having from 1 to 70 carbon atoms. The aliphatic hydrocarbon group may be linear or cyclic and may be saturated or unsaturated.

The aliphatic hydrocarbon group includes, for example, a methyl group, an ethyl group, a propyl group, an isopropyl group, a butyl group, an iso-butyl group, a sec-butyl group, a tert-butyl group, a pentyl group, a hexyl group, an octyl group, a cyclohexyl group, a decyl group, an octadecyl group, etc. Of those, preferred is a group having from 1 to 10 carbon atoms such as a methyl group, a 1,2-ethyl group, a 1,3-propyl group, a 1,4-butyl group, a 1,5-pentyl group, a 1,8-octyl group, etc., from the viewpoint of availability and inexpensiveness of the source materials, and more preferred is a group having from 1 to 8 carbon atoms. Also from the viewpoint of facilitation of synthesis of the polymer, especially preferred is a group having from 1 to 3 carbon atoms such as a methyl group, an ethyl group, an isopropyl group, etc.; and most preferred is a group having 1 or 2 carbon atoms such as a methyl group, an ethyl group, etc. The aliphatic hydrocarbon group is preferably a saturated hydrocarbon group from the viewpoint of oxidation-reduction resistance.

The aliphatic unsaturated hydrocarbon group is preferably an alkenylene group, and specific examples thereof include a 1,2-vinylene group, a 1,3-propenylene group, a 1,2-propenylene group, a 1,4-butenylene group, etc. Of those, especially preferred is a vinylene group from the viewpoint that the conjugated plane may be broadened owing to improved molecular planarity, and that the compound stability may be readily increased owing to delocalization of charges. The carbon number of the unsaturated aliphatic hydrocarbon group is preferably 2 or more, and is, on the other hand, preferably 10 or less, more preferably 6 or less, from the viewpoint of the planarity and the charge expansion.

As the aromatic amine polymer to be used in the present invention, more preferred are polymers having a repeating unit represented by the following formula (11), (12), (13) or (14).

The polymer having a repeating unit represented by the following formula (11) may be synthesized through N-Ar bond forming reaction such as Buchwald-Hartwig reaction, Ullmann reaction or the like.

[Chem. 4]

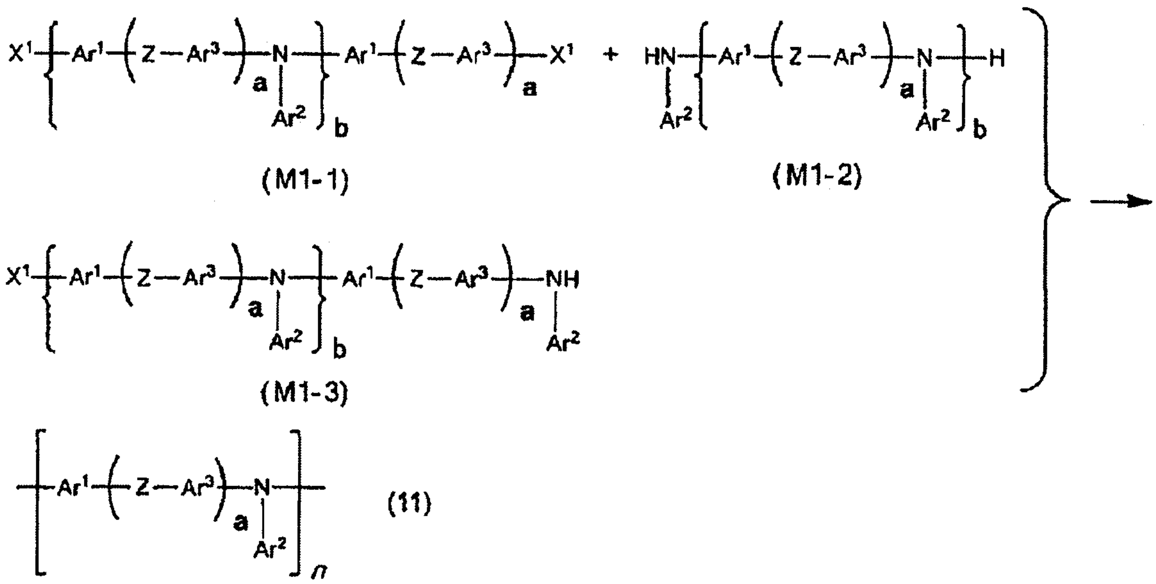

(M1-1) (M1-2) (M1-3) (11)

In the formula (11), $Ar^1$ and $Ar^3$ each represents the same as $Ar^a$ in the formula (1); $Ar^2$ represents the same as $Ar^b$ in the formula (1); Z represents a divalent group, and is preferably a group formed by linking from 1 to 24 substituents selected from a group consisting of $-CR^1R^2-$, -CO-, -O-, -S-, $-SO_2-$ and $-SiR^3R^4-$. $R^1$ to $R^4$ each independently represent a hydrogen atom, an alkyl group having from 1 to 12 carbon atoms and optionally having a substituent, or the same aromatic hydrocarbon-cyclic group or aromatic heterocyclic group as that mentioned above; $R^1$ and $R^2$, and $R^3$ and $R^4$ each may bond to each other to form a ring. The symbol "a" indicates an integer of from 0 to 8. When "a" is an integer of from 2 to 8, $Ar^3$'s and Z's may be the same or different. The symbol "n" indicates a repeating number of the repeating unit.

In the formulae (M1-1) to (M1-3), $Ar^1$ to $Ar^3$, Z and "a" each represents the same as that in the formula (11), b indicates an integer of from 0 to 8. $X^1$ represents a halogen atom, a sulfonic acid ester group such as a trifluoromethanesulfonyloxy group (($CF_3SO_2O$-), etc.

One alone or two or more different types of the monomers represented by the formula (M1-1) to the formula (M1-3) may be used here either singly or as combined. Preferably, at most 10 types of those monomers are used here.

In case where the formula (11), the formula (M1-1) to the formula (M1-3) have two or more $Ar^1$'s to $Ar^3$'s, Z's, a's and $X^1$'s, these may differ from each other.

The polymer having a repeating unit represented by the following formula (12) may be synthesized through Ar-Ar bond forming reaction such as Yamamoto reaction, Negishi reaction, Migita-Kosugi-Stille reaction, Suzuki-Miyaura reaction or the like.

In the following formula (12), the upper stage on the left-hand side indicates a homocoupling reaction of a halogen compound alone (Ullmann reaction, Yamamoto reaction etc.), the lower stage on the left-hand side indicates a crosscoupling reaction of a halogen compound and an organic metal (Suzuki-Miyaura reaction, Negishi reaction, Migita-Kosugi-Stille reaction, etc.).

[Chem. 5]

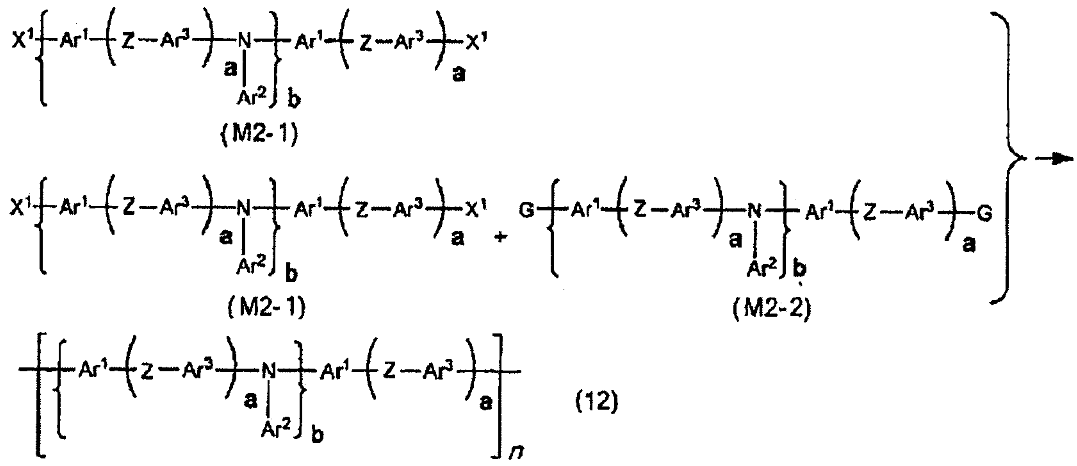

(M2-1)

(M2-1) (M2-2)

(12)

In the formula (12), the formula (M2-1) and the formula (M2-2), $Ar^1$ to $Ar^3$, Z, the symbols "a", "b", $X^1$ and "n" each represents the same as that in the formula (11) and the formula (M1-1) to the formula (M1-3).

In the formula (M2-2), G represents, in Negishi reaction, a zinc atom having a substituent such as BrZn- or the like, or in Migita-Kosugi-Stille reaction, represents a tin atom having a substituent such as $(CH_3)_3Sn$- or the like, or in Suzuki-Miyaura reaction, represents a boron atom having a substituent such as $(RO)_2B$- (R represents a hydrogen atom, or an alkyl group that may bond to each other to form a ring), etc.

In case where the formula (12), the formula (M2-1) and the formula (M2-2) have two or more $Ar^1$'s to $Ar^3$'s, Z's, a's, b's and $X^1$'s, these may differ from each other.

The polymer having a repeating unit represented by the following formula (13) may be synthesized through O-Ar bond or S-Ar bond forming reaction.

[Chem. 6]

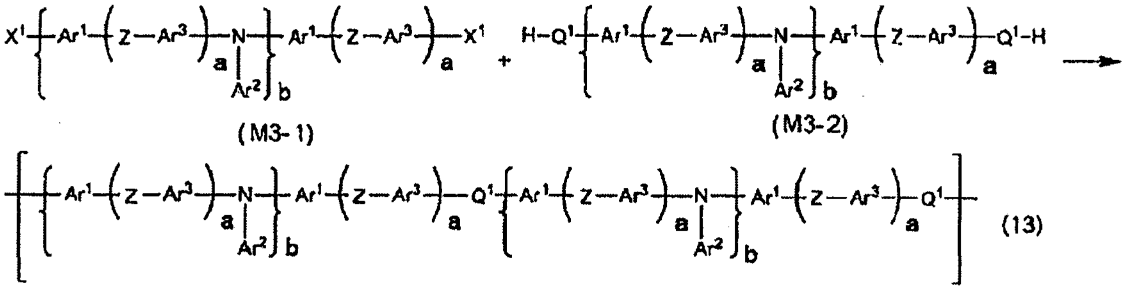

(M3-1) (M3-2)

(13)

In the formula (13), the formula (M3-1) and the formula (M3-2), $Ar^1$ to $Ar^3$, Z, the symbols "a", "b", $X^1$ and "n" each represents the same as that in the formula (11), the formula (M1-1) and the formula (M1-3).

In the formula (13) and the formula (M3-2), $Q^1$ represents an oxygen atom or a sulfur atom.

In case where the formula (13), the formula (M3-1) and the formula (M3-2) have two or more $Ar^1$'s to $Ar^3$'s, Z's, a's, b's, $Q^1$'s and $X^1$'s, these may differ from each other.

The polymer having a repeating unit represented by the following formula (14) may be synthesized through ester bond or amide bond forming reaction.

[Chem. 7]

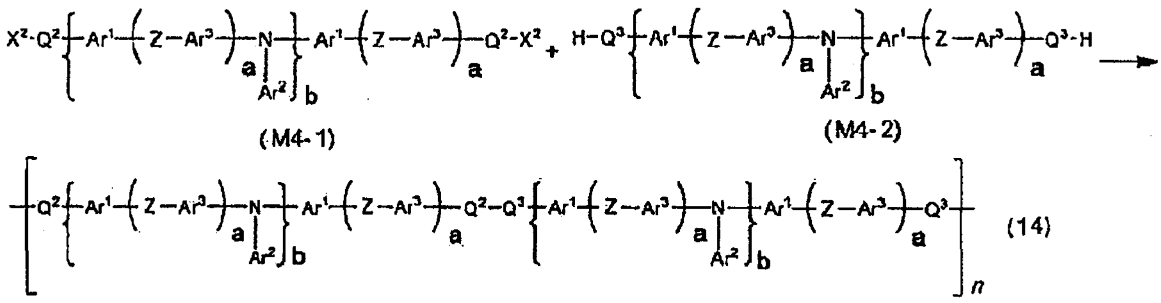

In the formula (14), the formula (M4-1) and the formula (M4-2), $Ar^1$ to $Ar^3$, Z, the symbols "a", "b" and "n" each represents the same as that in the formula (11), and the formula (M1-1) to the formula (M1-3).

In the formula (14), the formula (M4-1) and the formula (M4-2), $Q^2$ represents a carbonyl group or a sulfonyl group, $Q^3$ represents an oxygen atom, a sulfur atom, or a group $-NR^5-$ ($R^5$ represents a hydrogen atom, an alkyl group optionally having a substituent, or the same aromatic hydrocarbon-cyclic group or aromatic heterocyclic group as that mentioned above); $X^2$ represents a halogen atom.

In case where the formula (14), the formula (M4-1) and the (M4-2) have two or more $Ar^1$'s to $Ar^3$'s, Z's, a's, b's, $Q^2$'s and $Q^3$'s, these may differ from each other.

Of the above, as the aromatic amine polymer in the present invention, preferred is the use of at least one polymer having a repeating unit represented by the formula (11) or the formula (12). More preferred is the use of the polymer having a repeating unit represented by the formula (11) from the viewpoint of hole transporting performance and durability. In the formulae (11) to (14), a is preferably 0 from the viewpoint that the compounds are excellent in hole injecting and transporting performance. On the other hand, a is preferably 1 or 2 and more preferably 1, from the viewpoint that the compounds realize a wide band gap and are excellent in hole transporting performance. Z is preferably $-CR^1R^2-$ in view of excellent durability.

<Crosslinking Group>

In the first and second aspects of the present invention, the charge injection layer contains a crosslinked aromatic amine polymer. Therefore, in this case, the aromatic amine compound has a crosslinking group. Here, crosslinking group means a group to react with the same group or one of different groups in any other molecule existing near the crosslinking group through heating and/or irradiation with active energy rays, thereby forming a new chemical bond.

The aromatic amine polymer having a crosslinking group can be crosslinked at the group after coating. After crosslinked, the aromatic amine polymer becomes insoluble with solvent, and preferably, therefore, another functional thin film can be stacked on the aromatic amine polymer by wet coating.

The crosslinking group is selected from the following "crosslinking group family T" from the viewpoint of good crosslinking performance (easy to crosslink each other) thereof. In this case, the crosslinked aromatic amine polymer in the present invention shall have a crosslinked structure derived from the crosslinking group selected from the crosslinking group family T.

<Crosslinking Group Family T>

[Chem. 8]

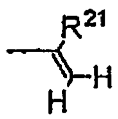 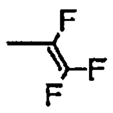 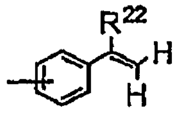 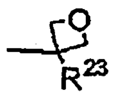 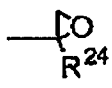 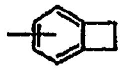

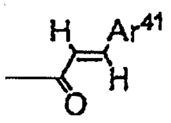 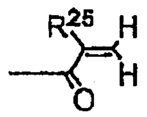 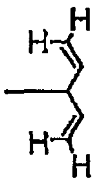 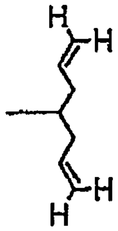 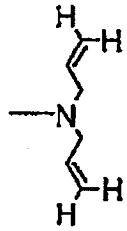

In the formulae, $R^{21}$ to $R^{25}$ each independently represent a hydrogen atom, or an alkyl group having from 1 to 12 carbon atoms. $Ar^{41}$ represents an aromatic hydrocarbon-cyclic group optionally having a substituent, or an aromatic heterocyclic group optionally having a substituent. The benzocyclobutene ring may have a substituent.

The crosslinking group is preferably a cyclic ether group such as an epoxy group, an oxetane group or the like, or a cationic polymerizing group such as a vinyl ether group or the like, from the viewpoint that the group has a high reactivity and can readily crosslinkable against organic solvent. Above all, especially preferred is an oxetane group from the viewpoint that the cationic polymerization speed is easy to control; and also preferred is a vinyl ether group from the viewpoint that hydroxyl group that may degrade the devices is hardly formed during cationic polymerization.

Also preferably, the crosslinking group is an arylvinylcarbonyl group such as a cinnamoyl group or the like, or a group capable of undergoing cyclization addition reaction such as a benzocyclobutene ring or the like, from the viewpoint of the ability thereof to further enhance the electrochemical stability of the polymer. Especially preferred is a benzocyclobutene ring from the viewpoint of high stability of the crosslinked structure.

In the molecule of the aromatic amine polymer in the present invention, (a) the crosslinking group may directly bond to the aromatic hydrocarbon group or the aromatic heterocyclic group in the molecule, or (b) may bond to the aromatic hydrocarbon group or the aromatic heterocyclic group via a group -O-, or (c) may bond to the aromatic hydrocarbon group or the aromatic heterocyclic group via a divalent group comprising one or more groups $-CH_2-$ optionally having a substituent, or via a divalent group formed by linking these groups to a group -O- or a group -C(=O)-. In case where one or more groups $-CH_2-$ optionally having a substituent exist(s) between the crosslinking groups, the total carbon number of the divalent linking group is from 1 to 30, preferably from 1 to 20.

Specific examples of the crosslinking group that bonds via such a divalent group, or that is, those containing a crosslinking group are as shown in the following <Crosslinking Group-Containing Group Family T'>, to which, however, the present invention is not limited.

<Crosslinking Group-Containing Group Family T'>

[Chem. 9]

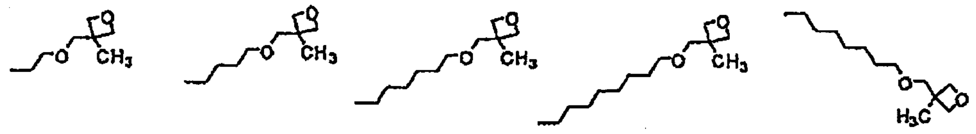

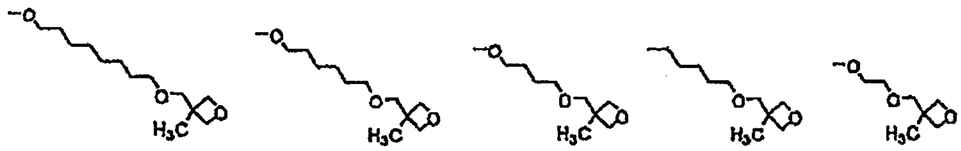

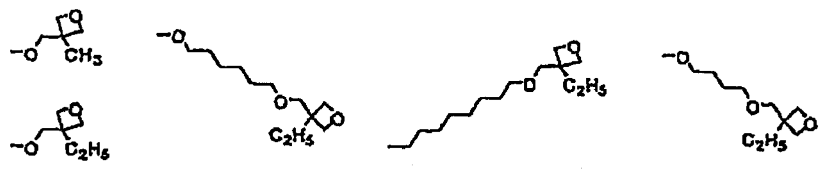

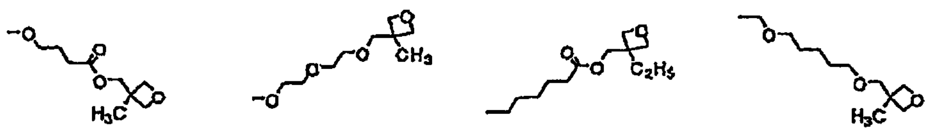

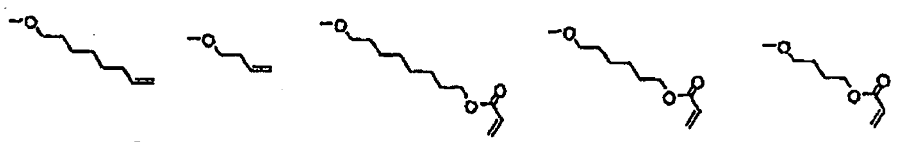

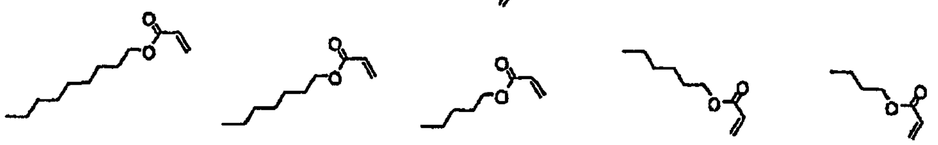

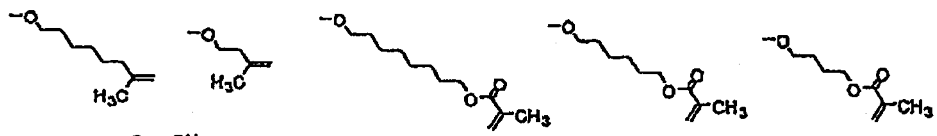

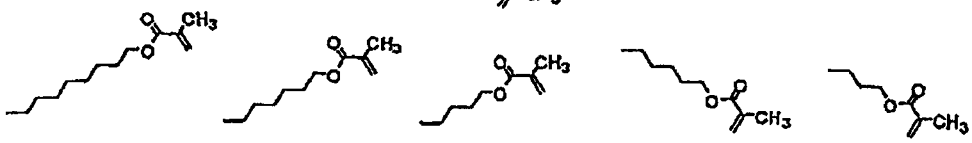

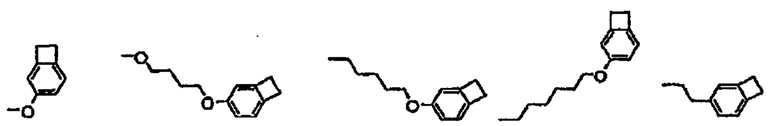

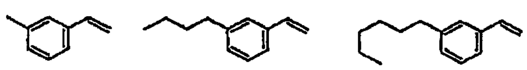

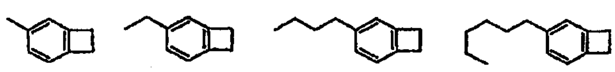

The aromatic amine polymer in the present invention preferably contains a partial structure comprising the following formula (2).

[Chem. 10]

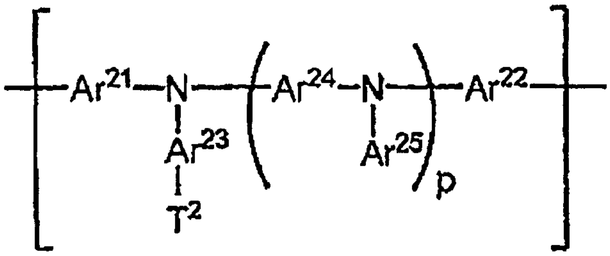

(2)

(In the formula (2), the symbol "p" indicates an integer of from 0 to 3; $Ar^{21}$ and $Ar^{22}$ each independently represent a direct bond, an aromatic hydrocarbon group optionally having a substituent, or an aromatic heterocyclic group optionally having a substituent; $Ar^{23}$ to $Ar^{25}$ each independently represent an aromatic hydrocarbon-cyclic group optionally having a substituent or an aromatic heterocyclic group optionally having a substituent; and $T^2$ represents a group containing a crosslinking group.

In case where the formula (2) has plural $Ar^{24}$'s and $Ar^{25}$'s, these may be the same or different from each other.)

The aromatic hydrocarbon-cyclic group optionally having a substituent or the aromatic heterocyclic group optionally having a substituent, which is usable for $Ar^{21}$, $Ar^{22}$ and $Ar^{24}$, has the same structure as that for $Ar^a$ in the above-mentioned formula (1). The aromatic hydrocarbon-cyclic group optionally having a substituent or the aromatic heterocyclic group optionally having a substituent, which is usable for $Ar^{23}$ and $Ar^{25}$, has the same structure as that for $Ar^b$ in the above-mentioned formula (1).

$T^2$ is selected from the above-mentioned crosslinking group family T, and from groups formed by linking the group in the crosslinking group family T to the above-mentioned divalent group (b) or (c). Above all, $T^2$ is preferably selected from the above-mentioned crosslinking group family T and the crosslinking group-containing group family T'. Especially preferably, $T^2$ is a group containing a group represented by the following formula (3).

[Chem. 11]

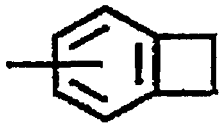

(3)

(In the formula (3), the benzocyclobutene ring may have a substituent. The 44 substituents may bond to each other to form a ring.)

The aromatic amine polymer in the present invention may contain a partial structure comprising the following formula (4).

[Chem. 12]

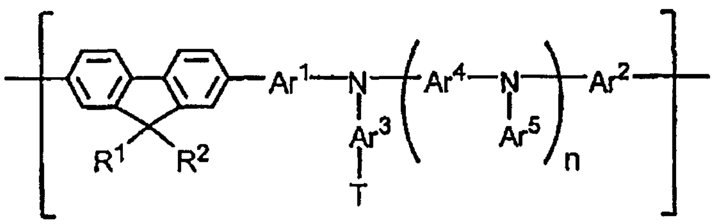

(4)

(In the formula (4), $R^1$ and $R^2$ each independently represent a hydrogen atom, an aromatic hydrocarbon-cyclic group optionally having a substituent, an aromatic heterocyclic group optionally having a substituent, or an alkyl group optionally having a substituent, and $R^1$ and $R^2$ may bond to each other to form a ring;

The symbol "n" indicates an integer of from 0 to 3;

$Ar^1$ represents an aromatic hydrocarbon-cyclic group optionally having a substituent, or an aromatic heterocyclic group

optionally having a substituent;
$Ar^2$ represents a direct bond, an aromatic hydrocarbon-cyclic group optionally having a substituent, or an aromatic heterocyclic group optionally having a substituent;
Each of $Ar^3$ to $Ar^5$ independently represents an aromatic hydrocarbon-cyclic group optionally having a substituent, or an aromatic heterocyclic group optionally having a substituent.

T represents a group containing a crosslinking group.

In case where the formula (4) has plural $Ar^4$'s and $Ar^5$'s, these may be the same as or different from each other.)

The aromatic hydrocarbon-cyclic group optionally having a substituent, or the aromatic heterocyclic group optionally having a substituent usable for $Ar^1$, $Ar^2$ and $Ar^4$ has the same structure as that represented by $Ar^a$ in the above-mentioned formula (1). The aromatic hydrocarbon-cyclic group optionally having a substituent, or the aromatic heterocyclic group optionally having a substituent usable for $Ar^3$ and $Ar^5$ has the same structure as that represented by $Ar^b$ in the above-mentioned formula (1).

T includes the same groups as those of $T^2$ in the above-mentioned general formula (2), and is preferably selected from the crosslinking group family T and the crosslinking group-containing group family T' mentioned above. In particular, T is preferably a group containing the group represented by the above-mentioned formula (3).

Preferably, the aromatic amine polymer in the present invention contains a partial structure comprising the following formula (5).

[Chem. 13]

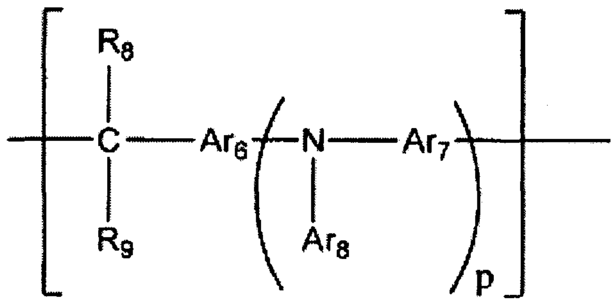

(5)

(In the formula (5), $Ar_6$ and $Ar_7$ each independently represent a divalent aromatic group optionally having a substituent; $Ar_8$ represents an aromatic group optionally having a substituent; $R_8$ and $R_9$ each independently represent a hydrogen atom, an alkyl group having from 1 to 12 carbon atoms and optionally having a substituent, an alkoxy group having from 1 to 12 carbon atoms and optionally having a substituent, an aromatic hydrocarbon group having from 6 to 25 carbon atoms and optionally having a substituent, or an aromatic heterocyclic group having from 3 to 20 carbon atoms and optionally having a substituent.

$R_8$ and $R_9$ may bond to each other to form a ring.

The symbol "p" indicates an integer of from 1 to 5.

In case where the formula (5) has plural $Ar_6$'S to $Ar_8$'s, $R_8$'s and $R_9$'s, these may be the same as or different from each other.)

Also preferably, the aromatic amine polymer in the present invention contains a partial structure comprising the following formula (6).

[Chem. 14]

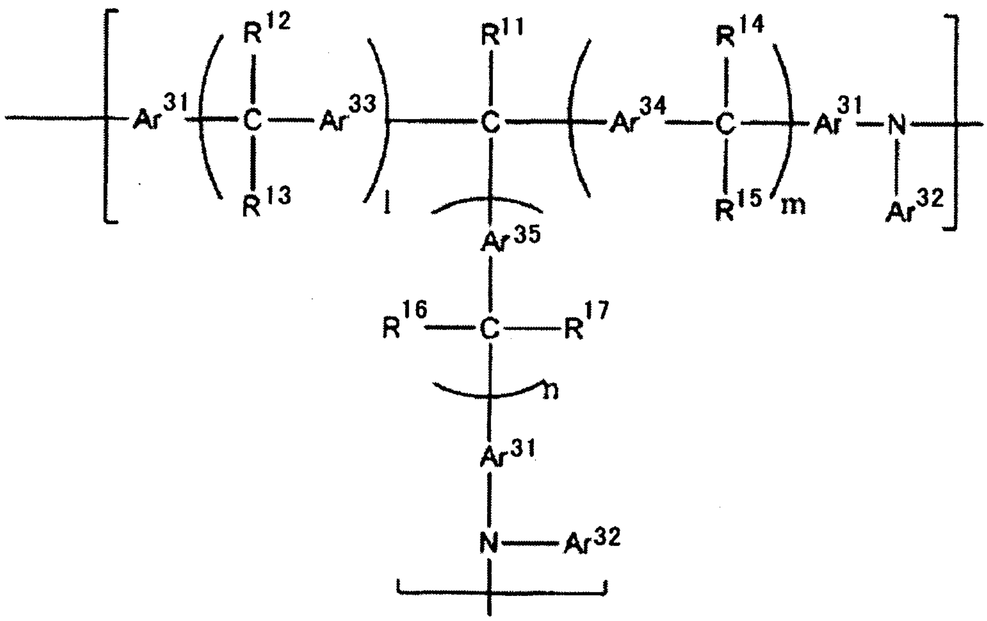

(6)

(In the formula (6), $Ar^{31}$, $Ar^{33}$, $Ar^{34}$ and $Ar^{35}$ each independently represent a divalent aromatic hydrocarbon-cyclic group optionally having a substituent, or a divalent aromatic heterocyclic group optionally having a substituent; $Ar^{32}$ represents an aromatic hydrocarbon-cyclic group optionally having a substituent, or an aromatic heterocyclic group optionally having a substituent.

$R^{11}$ represents an alkyl group having from 1 to 12 carbon atoms and optionally having a substituent, or an alkoxy group having from 1 to 12 carbon atoms and optionally having a substituent; $R^{12}$ to $R^{17}$ each independently represent a hydrogen atom, an alkyl group having from 1 to 12 carbon atoms and optionally having a substituent, an alkoxy group having from 1 to 12 carbon atoms and optionally having a substituent, an aromatic hydrocarbon-cyclic group having from 6 to 25 carbon atoms and optionally having a substituent, or an aromatic heterocyclic group having from 3 to 20 carbon atoms and optionally having a substituent.

$R^{12}$ and $R^{13}$, $R^{14}$ and $R^{15}$, as well as $R^{16}$ and $R^{17}$ may bond to each other to form a ring.

Each of the symbols "l", "m" and "n" independently indicates an integer of from 0 to 2.

In the formula (6), plural $Ar^{31}$'s to $Ar^{35}$'s or plural $R^{12}$'s to $R^{17}$'s, if any, may be the same as or different from each other.)

The divalent aromatic hydrocarbon group optionally having a substituent, which is usable for $Ar^{31}$, $Ar^{33}$, $Ar^{34}$, $Ar^{35}$, $Ar_6$ and $Ar_7$, is the same as the divalent aromatic hydrocarbon group usable for the above-mentioned $Ar^a$.

The aromatic hydrocarbon group optionally having a substituent, which is usable for $Ar^{32}$ and $Ar_8$, is the same as the aromatic hydrocarbon group usable for the above-mentioned $Ar^b$.

$R^{12}$ to $R^{17}$, and $R_8$ and $R_9$ each independently represent a hydrogen atom, an alkyl group optionally having a substituent, an alkoxy group optionally having a substituent, or an aromatic group optionally having a substituent, and these may bond to each other to form a ring. $R^{11}$, $R^{12}$ to $R^{17}$, and $R_8$ and $R_9$ each are preferably an alkyl group having from 1 to 12 carbon atoms or an alkoxy group having from 1 to 12 carbon atoms from the viewpoint of solubility, more preferably an alkyl group having from 1 to 12 carbon atoms.

The substituent that $Ar^{31}$, $Ar^{33}$, $Ar^{34}$, $Ar^{35}$, $Ar_6$, $Ar_7$, $R^{12}$ to $R^{17}$, $R_8$ and $R_9$ may have includes the substituent that the aromatic hydrocarbon group or the aromatic heterocyclic group represented by the above-mentioned $Ar^a$ or $Ar^b$ may have, or the above-mentioned crosslinking group.

The aromatic amine polymer in the present invention is preferably a polymer having a partial structure selected from the formulae (1), (11), (12), (13), (14), (2), (4), (5) and (6), a divalent benzene ring, and an aromatic hydrocarbon of a divalent, 5- or 6-membered single ring or 2- to 5-condensed ring. Of those, the aromatic amine polymer in the present invention is more preferably a polymer having a partial structure selected from the formulae (1), (11), (12), (13), (14), (2), (4), (5) and (6), a divalent benzene ring, and an aromatic hydrocarbon of a divalent, 6-membered, 2- to 5-condensed ring.

<Molecular Weight of Aromatic Amine Polymer>

The weight-average molecular weight (Mw) of the aromatic amine polymer in the present invention is generally equal to or less than 3,000,000, preferably 1,000,000, more preferably 500,000, and is generally equal to or more than

2,000, preferably 3,000, more preferably 5,000.

The number-average molecular weight (Mn) of the aromatic amine polymer in the present invention is generally equal to or more than 3,000, preferably 6,000 and is generally equal to or less than 1,000,000, preferably 500,000.

The molecular weight distribution (Mw/Mn: Mw divided by Mn) of the aromatic amine polymer in the present invention is generally equal to or less than 3.5, preferably 2.5, more preferably 2.0.

In general, the weight-average molecular weight is determined through SEC (size exclusion chromatography) analysis. In SEC, a high-molecular-weight component takes a shorter elution time, and the low-molecular-weight component takes a longer elution time. Using a calibration curve drawn from the elution time of polystyrene (standard sample) having a known molecular weight, the elution time for the sample is converted into the molecular weight thereof, and accordingly, the weight-average molecular weight of the analyzed sample is thereby calculated.

[Method for Formation of Charge Injection and Transport Layer]

A method to form the charge injection and transport layer containing the above-mentioned aromatic amine polymer is described below. In case where the present invention corresponds to the embodiment of Fig. 1, the charge injection and transport layer is a hole injection and transport layer. Therefore, a case where the charge injection and transport layer is a hole injection and transport layer is described below.

The hole-injection-and-transport-layer-forming composition to be used to form the hole injection and transport layer is prepared by mixing the above-mentioned, crosslinking group-having an aromatic amine polymer and other optional components in a solvent capable of dissolving or dispersing these.

In case where the hole-injection-and-transport-layer-forming composition contains the above-mentioned, crosslinking group-having aromatic amine polymer, the solvent to be contained in the hole-injection-and-transport-layer-forming composition is, though not specifically defined, a solvent that can dissolve the aromatic amine polymer in an amount of generally 0.1% by mass or more, preferably 0.5% by mass or more and more preferably 1.0% by mass or more, at 25°C and under one atmospheric pressure.

The solvent to be used in the hole-injection-and-transport-layer-forming composition may be any of ester solvents, aromatic hydrocarbon solvents, ether solvents, alkane solvents, ketone solvents, alcohol solvents, halogen-containing organic solvents, amide solvents and the like satisfying the above-mentioned demand characteristics. Preferred are ester solvents, aromatic hydrocarbon solvents, ether solvents, alkane solvents and ketone solvents as having high solubilization power and providing few negative influences of residual solvents.

The ester solvents include, for example, aliphatic esters such as ethyl acetate, n-butyl acetate, ethyl lactate, n-butyl lactate, etc.; and aromatic esters such as phenyl acetate, phenyl propionate, methyl benzoate, ethyl benzoate, propyl benzoate, n-butyl benzoate, etc.

The aromatic hydrocarbon solvents include, for example, toluene, xylene, mesitylene, cyclohexylbenzene, 3-isopropylbiphenyl, 1,2,3,4-tetramethylbenzene, 1,4-diisopropylbenzene, methylnaphthalene, etc.

The ether solvents include, for example, aliphatic ethers such as ethylene glycol dimethyl ether, ethylene glycol diethyl ether, propylene glycol-1-monomethyl ether acetate (PGMEA), etc.; aromatic ethers such as 1,2-dimethoxybenzene, 1,3-dimethoxybenzene, anisole, phenetol, 2-methoxytoluene, 3-methoxytoluene, 4-methoxytoluene, 2,3-dimethylanisole, 2,4-dimethylanisole, etc.

The alkane solvents include, for example, n-decane, cyclohexane, ethylcyclohexane, decalin, bicyclohexane, etc.

The ketone solvents include, for example, alicyclic ketones such as cyclohexanone, cyclooctanone, fenchone, etc.; aliphatic ketones such as methyl ethyl ketone, dibutyl ketone, etc.

The alcohol solvents include, for example, alicyclic alcohols such as cyclohexanol, cyclooctanol, etc.; aliphatic alcohols such as butanol, hexanol, etc.

The halogen-containing organic solvents include 1,2-dichloroethane, chlorobenzene, o-dichlorobenzene, etc.

The amide solvents include, for example, N,N-dimethylformamide, N,N-dimethylacetamide, etc.

In addition to these, also usable are dimethyl sulfoxide, etc.

One alone or two or more of these solvents may be used here either singly or as combined in any desired manner and in any desired mixing ratio.

For providing a more uniform film, it is desirable that the solvent is evaporated away from a wet film at a suitable evaporation rate just after forming the wet film. For this, it is desirable that the boiling point of the solvent is generally equal to or higher than 80°C, preferably 100°C, more preferably 120°C. It is also desirable that the boiling point of the solvent is generally equal to or lower than 270°C, preferably 250°C, more preferably 230°C. When the boiling point of the solvent is significantly low, then the drying speed would be too high to make quality of the dried film good. On the other hand, when the boiling point is unnecessarily high, accordingly the temperature in the drying step must be high, therefore that high temperature might bring about a possibility of some negative influences on the other layers and the baseplate.

The amount of the solvent to be contained in the hole-injection-and-transport-layer-forming composition is generally equal to or more than 10% by mass, preferably 50% by mass, more preferably 60% by mass, even more preferably 80% by mass, and is generally equal to or less than 99.99% by mass.

The amount of the aromatic amine polymer to be contained in the hole-injection-and-transport-layer-forming composition is preferably larger from the viewpoint that the viscosity of the composition could be high; but on the other hand, from the viewpoint of solubility, the amount is preferably smaller. Concretely, therefore, the amount of the aromatic amine polymer to be contained in the hole-injection-and-transport-layer-forming composition is generally equal to or more than 0.01% by mass, preferably 0.1% by mass, more preferably 0.5% by mass, and is, on the other hand, generally equal to or less than 50% by mass, preferably 40% by mass, more preferably 20% by mass. The hole-injection-and-transport-layer-forming composition may contain two or more different types of aromatic amine polymers, and in the case, it is desirable that the total amount of those two or more polymers falls within the above range.

The hole injection and transport layer 11 in the present invention is formed by using a wet method of film formation. Here, the wet method of film formation is a method of forming a film in a wet mode, using, as a material coating method, for example, a spin coating method, a dip coating method, a die coating method, a bar coating method, a blade coating method, a roll coating method, a spray coating method, a capillary coating method, an inkjet method, a nozzle printing method, a screen printing method, a gravure printing method, a flexographic printing method or the like, in which the coating film is dried to form a solid film. Of those film formation methods, preferred is a spin coating method, a spray coating method, an inkjet method, a nozzle printing method, etc.

As described above, the hole injection and transport layer 11 in the present invention is formed by using such a wet method of film formation. However, in case where the hole-injection-and-transport-layer-forming composition contains a crosslinking group-having aromatic amine polymer and where the hole injection and transport layer (charge injection and transport layer) contains a crosslinked aromatic amine polymer, the method includes a step of crosslinking group-having aromatic amine polymer contained in the coating film of the hole-injection-and-transport-layer-forming composition. The step of crosslinking the coating film of the hole-injection-and-transport-layer-forming composition and the aromatic amine polymer may comprise two steps, or may be one step.

In case where the aromatic amine polymer in the present invention is crosslinked, in general, the polymer is heated. The heating method is not specifically defined. Regarding the condition in heating and drying, the film formed of the hole-injection-and-transport-layer-forming composition is heated generally at the temperature equal to or higher than 100°C, preferably 120°C, more preferably 150°C, and is generally at the temperature equal to or lower than 300°C, preferably 280°C, more preferably 270°C. The heating time may be generally equal to or more than 1 second, and is preferably equal to or less than 10 hours. The heating method is not specifically defined. The stacked films having formed one is put on a hot plate, or is heated in an oven. For example, the stacked films may be heated on a hot plate at the temperature equal to or higher than 120°C for the duration equal to or longer than 1 minute.

In case where the coating film is heated through irradiation with active energy such as light or the like, there may be adopted a method of direct irradiation using a UV/visible light/IR light source such as an ultrahigh-pressure mercury lamp, a high-pressure mercury lamp, a halogen lamp, an IR lamp or the like, or a method of irradiation using a mask aligner or a conveyor-type photoirradiation apparatus having a built-in light source of the above-mentioned ones. For active energy irradiation not with light, for example, there may be adopted a method using an irradiating apparatus with microwaves generated through a magnetron, or that is, using a so-called microwave oven.

For active energy irradiation with light or the like, especially preferred is heating with IR rays. For heating with IR rays, usable are a halogen heater, a ceramic-coated halogen heater, a ceramic heater, etc. As a halogen heater, for example, included are those manufactured by USHIO (UH-USC, UH-USD, UH-MA1, UH-USF, UH-USP, UH-USPN, and halogen heaters manufactured by ceramic-coating (black-coating) these); and those manufactured by Heraeus, etc. As a far-IR heater, for example, AMK's far-IR panel clean heaters are included.

As the heating method, for example, adoptive here can be a method where the above-mentioned IR heater is positioned above the baseplate and heating it with IR rays.

In heating with IR rays, the baseplate preferably has a local minimum for IR transmission in a range of wavelength from 2000 nm to 3300 nm. The upper limit of the IR transmittance is generally equal to or less than 95%, preferably 90%, more preferably 85%, even more preferably 80%, still more preferably 75%. The lower limit is generally equal to or more than 5%, preferably 10%, more preferably 20%, even more preferably 25%.

Falling within the above range, the substrate can be suitably heated, and owing to the thermal conduction, the coating film of the hole-injection-and-transport-layer-forming composition can be thereby heated. In other words, the coating film of the hole-injection-and-transport-layer-forming composition on the baseplate having the above-mentioned thickness can be suitably heated to thereby enhance the performance of the hole injection and transport layer. Even in a case where the coating film of the hole-injection-and-transport-layer-forming composition is heated excessively much, the baseplate can provide a heat bath to suitably release the excessive heat.

The lower limit of the peak wavelength of the IR heater is generally equal to or longer than 0.8 μm, preferably 0.9 μm, more preferably 1 μm, even more preferably 1.1 μm. The upper limit is generally equal to or shorter than 25

μm, preferably 10 μm, more preferably 5 μm, even more preferably 3 μm.

Falling within the range, the coating film of the hole-injection-and-transport-layer-forming composition can absorb IR rays and can be thereby heated in its own. At the peak wavelength of the IR heater falling within the range, the baseplate can be suitably heated, and the coating film of the hole-injection-and-transport-layer-forming composition can be heated by the heat generated in the baseplate. In case where an organic material is used for the hole-injection-and-transport-layer-forming composition, the organic material absorbs the IR rays from the IR heater, and the coating film of the hole-injection-and-transport-layer-forming composition can be thereby heated with IR induction heating.

In the above-mentioned combination of baseplate and IR rays, as described above, the IR transmittance of the baseplate has a local minimum value in a range of wavelength from 2000 to 3300 nm, and the lower limit of the product (α) of the wavelength at the local minimum and the peak wavelength of the IR heater is generally equal to or more than 2 $\mu m^2$, preferably 2.5 $\mu m^2$, more preferably 3 $\mu m^2$. The upper limit is generally equal to or less than 16 $\mu m^2$, preferably 15.5 $\mu m^2$, more preferably 15 $\mu m^2$.

When the product (α) of the wavelength at the local minimum of the IR transmittance of the baseplate and the peak wavelength of the IR heater falls within the range, the coating film of the hole-injection-and-transport-layer-forming composition can be heated suitably, and the performance of the conductive thin film like a hole injection and transport layer can be thereby enhanced.

The reason why the product (α) of the wavelength at the local minimum of the IR transmittance of the baseplate and the peak wavelength of the IR heater is used as the parameter for specifically defining the invention is described below.

With the wavelength at the local minimum transmittance in the range from 2000 to 3300 nm for IR absorption of the baseplate, the baseplate can be suitably heated without overheating. One typical parameter that features the IR heater to heat the baseplate is the peak wavelength of the IR heater radiation. The relationship between wavelength and energy is inversely proportional to each other, and therefore, a smaller value of the product (α) means that the energy given to the baseplate is larger. Also, a larger value of the product (α) means that the energy given to the baseplate is smaller. In the present invention, it is necessary to suitably heat the coating film of the hole-injection-and-transport-layer-forming composition, and therefore when the baseplate is heated suitably and the coating film of the hole-injection-and-transport-layer-forming composition is heated excessively much, then a heat bath is formed, but on the contrary, when the coating film could hardly be heated, it is necessary to give heat from the baseplate to the coating film of the hole-injection-and-transport-layer-forming composition. In the present invention, the parameter product (α) can be an index of heating.

[Hole Injection Layer]

In case where the layer formed of the above-mentioned hole-injection-and-transport-layer-forming composition is formed on an anode, the layer in contact with the anode functions as a hole injection layer. In this case, the hole-injection-and-transport-layer-forming composition preferably contains a compound accepting an electron, that is, an electron-accepting compound.

<Electron-Accepting Compound>

The electroconductivity of the hole injection layer can be increased through oxidation of the hole-transporting compound therein, and therefore the layer preferably contains an electron-accepting compound.

The electron-accepting compound is preferably an oxidative compound having the ability of receiving one electron from the above-mentioned hole-transporting compound. Concretely, preferred is a compound having an electron affinity equal to or more than 4 eV, and more preferred is a compound having an electron affinity equal to or more than 5 eV.

The electron-accepting compound of the type includes, for example, one or more compounds selected from a group consisting of triarylboron compounds, metal halides, Lewis acids, organic acids, onium salts, salts of arylamines and metal halides, and salts of arylamines and Lewis acids. Concretely, included are onium salts substituted by an organic group such as triphenylsulfonium tetrafluoroborate, etc.; iron(III) chloride (JP-A 11-251067); high-valent inorganic compounds such as ammonium peroxodisulfate, etc.; cyano compounds such as tetracyanoethylene, etc.; aromatic boron compounds such as tris(pentafluorophenyl)borane (JP-A 2003-31365), etc.; ionic compounds described in WO2005/089024; fullerene derivatives, iodine, etc.

Among the above-mentioned compounds, preferred are organic group-substituted onium salts and high-valence inorganic compounds as having a high oxidation power. On the other hand, from the viewpoint of high solubility in organic solvent and facilitating to form film by using a wet method of film formation, also preferred are organic group-substituted onium salts, cyano compounds and aromatic boron compounds.

Specific examples of organic group-substituted onium salts, cyano compounds and aromatic boron compounds that are favorable as electron-accepting compounds here are described in WO2005/089024, and also referred to here are the preferred examples of the compounds disclosed therein.

Specific examples of the electron-accepting compounds in the present invention are listed up below, to which, however, the invention is not limited. n1 in the following general formula (I-1), n2 in the following general formula (I-2) and n3 in the following general formula (I-3) each independently indicates an arbitrary positive integer corresponding to the ionic valence of the counter anions from $Z^{n1-}$ to $Z^{n3-}$, respectively. The values of n1 to n3, not specifically defined, are preferably 1 or 2, most preferably 1.

[Table 1]

| $([R^1\text{-}A^1\text{-}R^2]^+)_{n1}Z^{n1-}$ (I-1) | | | | |
|---|---|---|---|---|
| Number | $A^1$ | $-R^1$ | $-R^2$ | $Z^{n1-}$ |
| A-1 | I | 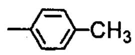 | 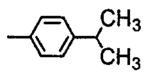 | 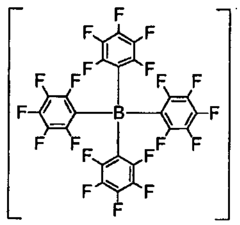 |
| A-2 | I | 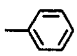 | 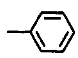 | 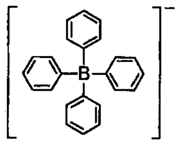 |
| A-3 | I | 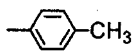 | 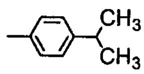 | 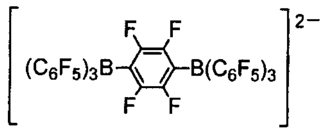 |
| A-4 | I | 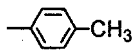 | 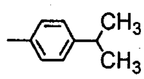 | 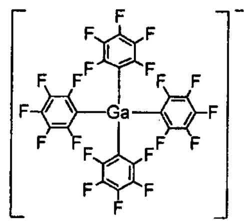 |
| A-5 | I | 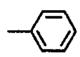 | 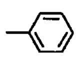 | $PF_6^-$ |
| A-6 | I | 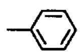 | 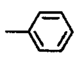 | $SbF_6^-$ |
| A-7 | I | 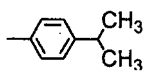 | 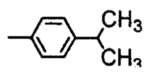 | $BF_4^-$ |
| A-8 | I | 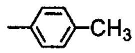 | 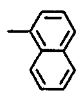 | $ClO_4^-$ |
| A-9 | I | 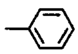 | 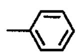 | $I^-$ |
| A-10 | I | 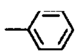 | 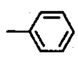 | $CF_3SO_3^-$ |
| A-11 | I | 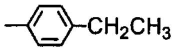 | 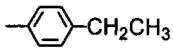 | $CH_3CO_2^-$ |

(continued)

| Number | $A^1$ | $-R^1$ | $-R^2$ | $Z^{n1-}$ |
|---|---|---|---|---|
| A-12 | I | 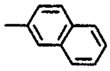 | 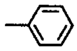 | $AsF_6^-$ |
| A-13 | I | 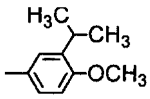 | 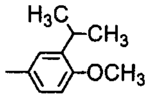 | $BF_4^-$ |
| A-14 | I | 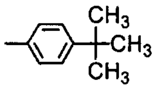 | 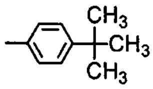 | 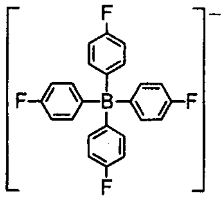 |

[Table 2]

| Number | $A^1$ | $-R^1$ | $-R^2$ | $Z^{n1-}$ |
|---|---|---|---|---|
| A-15 | I | 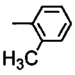 | 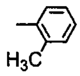 | $NO_3$ |
| A-16 | I | 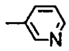 | 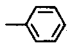 | 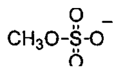 |
| A-17 | I | 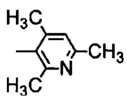 | 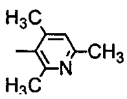 | $PF_6^-$ |
| A-18 | I | 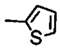 | 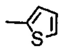 | 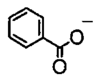 |
| A-19 | I | 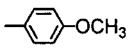 | 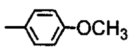 | 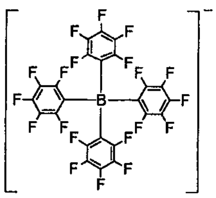 |
| A-20 | I | 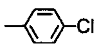 | 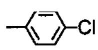 | $GaF_4^-$ |
| A-21 | I | 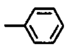 | 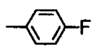 | $IO_3^-$ |
| A-22 | I | 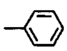 | 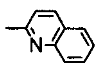 | $Cl^-$ |
| A-23 | I | 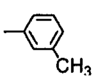 | 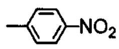 | $Br^-$ |
| A-24 | I | 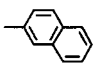 | 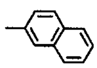 | $PF_6^-$ |

(continued)

| Number | $A^1$ | $-R^1$ | $-R^2$ | $Z^{n1-}$ |
|---|---|---|---|---|
| A-25 | I | 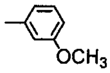 | 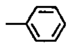 | $CF_3CO_2^-$ |
| A-26 | I | 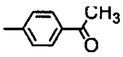 | 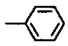 | $F^-$ |
| A-27 | I | 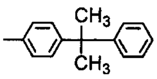 | 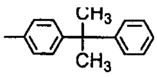 | $SO_4^{2-}$ |
| A-28 | I | 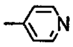 | 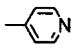 | $NO_3^-$ |
| A-29 | I | 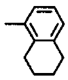 | 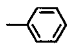 | $BF_4^-$ |
| A-30 | I | 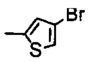 | 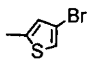 | $ClO_4^-$ |
| A-31 | I | 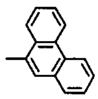 | 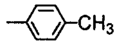 | 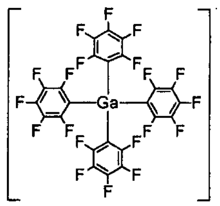 |

[Table 3]

| Number | $A^1$ | $-R^1$ | $-R^2$ | $Z^{n1-}$ |
|---|---|---|---|---|
| A-32 | I | 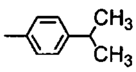 | 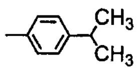 | $NO_3^-$ |
| A-33 | I | 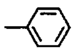 | 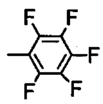 | $PF_6^-$ |
| A-34 | I | 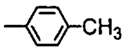 | 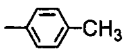 | $Cl^-$ |
| A-35 | I | 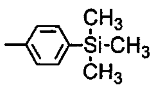 | 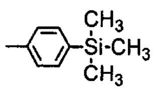 | $CF_3CF_2SO_3^-$ |
| A-36 | I | 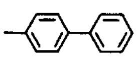 | 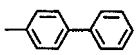 | 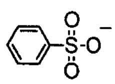 |
| A-37 | I | $-CH_3$ | 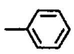 | 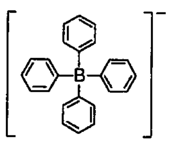 |

(continued)

| Number | $A^1$ | $-R^1$ | $-R^2$ | $Z^{n1-}$ |
|---|---|---|---|---|
| A-38 | I | 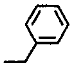 | 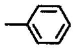 | $NO_3^-$ |
| A-39 | I | 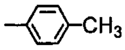 | $-CH=CH_2$ | $ClO_4^-$ |
| A-40 | I | 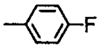 | $-CH_2-C\equiv CH$ | 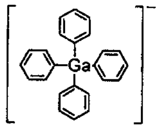 |
| A-41 | I | 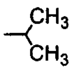 | 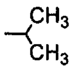 | $PF_6^-$ |
| A-42 | I | $-CF_2CF_3$ | 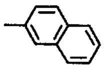 | 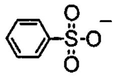 |
| A-43 | I | 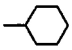 | 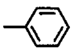 | $I^-$ |
| A-44 | I | $-CF_3$ | 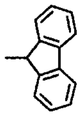 | $BF_4^-$ |
| A-45 | I | 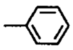 | $-CF_2CF_2CF_3$ | $CF_3SO_3^-$ |
| A-46 | I | 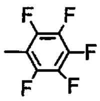 | $-CF_3$ | $GaF_4^-$ |
| A-47 | I | 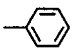 | $-CF_2CF_2CF_2CF_2CF_2CF_3$ | 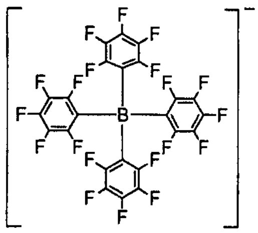 |
| A-48 | I | 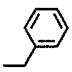 | $-CH_3$ | $Br^-$ |

[Table 4]

| Number | $A^1$ | $-R^1$ | $-R^2$ | $Z^{n1-}$ |
|---|---|---|---|---|
| A-49 | I | 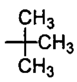 | 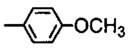 | $BrO_4^-$ |
| A-50 | I | $-CH_2CH_3$ | 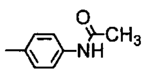 | $NO_2^-$ |

(continued)

| Number | $A^1$ | $-R^1$ | $-R^2$ | $Z^{n1-}$ |
|---|---|---|---|---|
| A-51 | I | 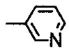 | 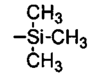 | $CF_3SO_3^-$ |
| A-52 | I | $-CH_2-CH=CH_2$ | 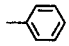 | $PO_4^{3-}$ |
| A-53 | I | $-CH_2O-CH_3$ | 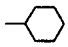 | $OH^-$ |
| A-54 | I | 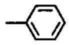 | 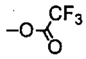 | $CF_3CO_2^-$ |
| A-55 | I | 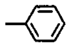 | 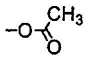 | $CH_3CO_2^-$ |
| A-56 | I | 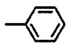 | -OH | 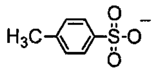 |
| A-57 | I | $-OCH_2CH_3$ | 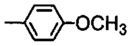 | $BF_4^-$ |
| A-58 | I | 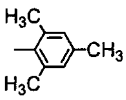 | 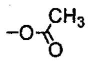 | $PF_6^-$ |
| A-59 | I | 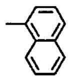 | -OH | $OH^-$ |
| A-60 | I | 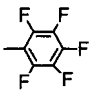 | 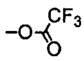 | $CF_3CO_2^-$ |
| A-61 | I | 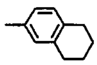 | 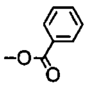 | $NO_3^-$ |
| A-62 | I | 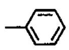 | 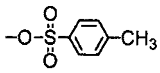 | 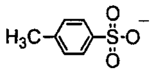 |
| A-63 | I | $-CH_2CH_3$ | 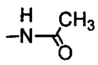 | $SbF_6^-$ |
| A-64 | I | 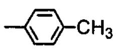 | $-OCH_3$ | 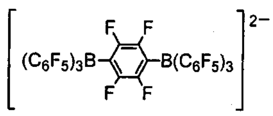 |
| A-65 | Br | 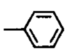 | 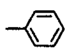 | $BF_4^-$ |
| A-66 | Br | 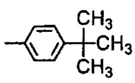 | 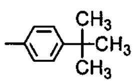 | $PF_6^-$ |
| A-67 | Br | 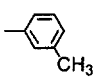 | 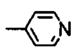 | $Br^-$ |

(continued)

| Number | A1 | -R1 | -R2 | Zn1- |
|---|---|---|---|---|
| A-68 | Br | 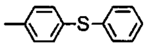 | 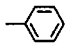 | $CF_3CF_2SO_3^-$ |

[Table 5]

| Number | A1 | -R1 | -R2 | Zn1- |
|---|---|---|---|---|
| A-69 | Br | 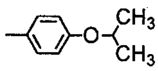 | 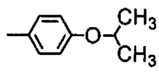 | 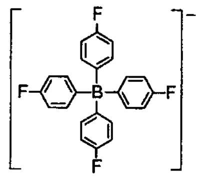 |
| A-70 | Br | 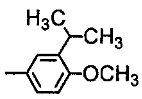 | 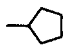 | $ClO_4^-$ |
| A-71 | Br | 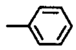 | $-CH_2-CH=CH-CH_3$ | $GaF_4^-$ |
| A-72 | Br | 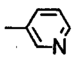 | $-CF_2CF_2CF_3$ | $SO_4^{2-}$ |
| A-73 | Br | 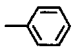 | 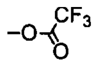 | $CF_3CO_2^-$ |
| A-74 | Br | $-CH=CH_2$ | 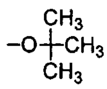 | 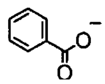 |
| A-75 | Cl | 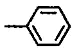 | 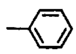 | $PF_6^-$ |
| A-76 | Cl | $-CH_2CH_3$ | 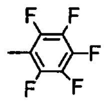 | $Cl^-$ |
| A-77 | Cl | 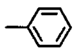 | 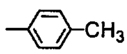 | $CF_3CO_2^-$ |
| $\left(\left[R^1—A^1—R^2\right]^+\right)_{n1}\ Z^{n1-}$ | | | | |
| Number | $[R^1-A^1-R^2]^+$ | | | Zn1- |
| A-79 | 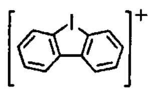 | | | $SO_4^{2-}$ |

(continued)

| Number | $[R^1-A^1-R^2]^+$ | $Z^{n1-}$ |
|---|---|---|
| A-80 | 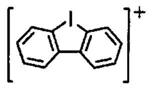 | 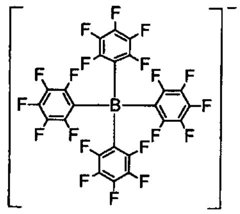 |
| A-81 | 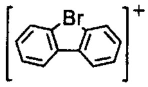 | $BF_4^-$ |
| A-82 | 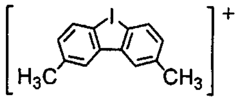 | $PF_6^-$ |
| A-83 | 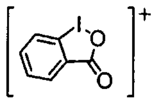 | $CF_3CO_2^-$ |
| A-84 | 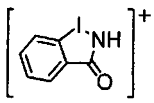 | 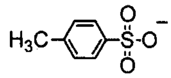 |

[Table 6]

| 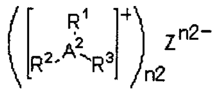 (I-2) | | | | | |
|---|---|---|---|---|---|
| Number | $A^2$ | $-R^1$ | $-R^2$ | $-R^3$ | $Z^{n2-}$ |
| B-1 | S | 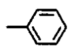 | 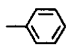 | 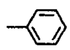 | 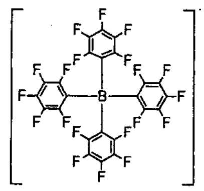 |
| B-2 | S | 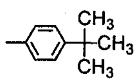 | 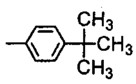 | 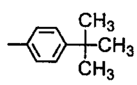 | 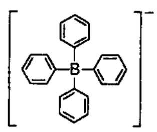 |
| B-3 | S | 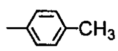 | 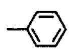 | 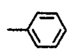 | 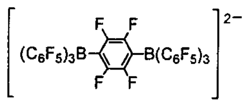 |
| B-4 | S | 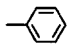 | 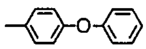 | 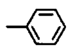 | $CF_3SO_3^-$ |
| B-5 | S | 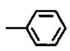 | 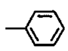 | 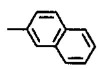 | $PF_6^-$ |

(continued)

| Number | $A^2$ | $-R^1$ | $-R^2$ | $-R^3$ | $Z^{n2-}$ |
|---|---|---|---|---|---|
| B-6 | S | 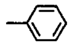 | 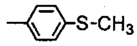 | $-CH_3$ | $CF_3SO_3^-$ |
| B-7 | S | 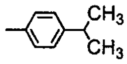 | 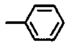 | 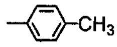 | $BF_4^-$ |
| B-8 | S | 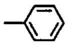 | 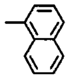 | 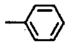 | $ClO_4^-$ |
| B-9 | S | 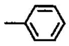 | 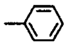 | 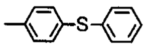 | $PF_6^-$ |
| B-10 | s | 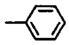 | 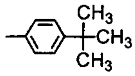 | 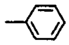 | 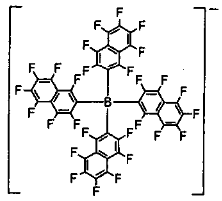 |
| B-11 | S | 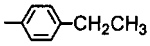 | 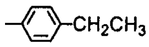 | 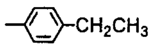 | $CH_3CO_2^-$ |
| B-12 | S | 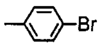 | 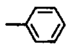 | 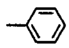 | $AsF_6^-$ |
| B-13 | S | 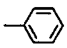 | 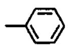 | 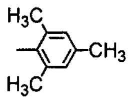 | 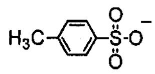 |
| B-14 | S | 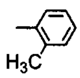 | 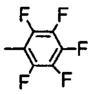 | 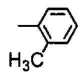 | $NO_3^-$ |

[Table 7]

| Number | $A^2$ | $-R^1$ | $-R^2$ | $-R^3$ | $Z^{n2-}$ |
|---|---|---|---|---|---|
| B-15 | S | 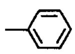 | $-CH_2CH_2CH_2CH_3$ | 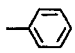 | 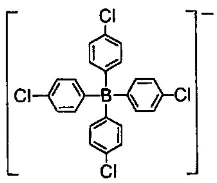 |
| B-16 | S | $-CH_3$ | $-CH_3$ | 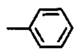 | $PF_6^-$ |
| B-17 | S | 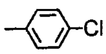 | 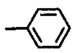 | 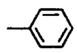 | $Cl^-$ |
| B-18 | S | 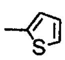 | 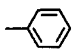 | 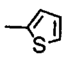 | 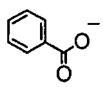 |

(continued)

| Number | $A^2$ | $-R^1$ | $-R^2$ | $-R^3$ | $Z^{n2-}$ |
|---|---|---|---|---|---|
| B-19 | S | 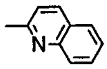 | 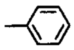 | 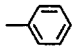 | $GaF_4^-$ |
| B-20 | S | 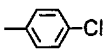 | 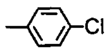 | 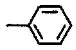 | $NO_3^-$ |
| B-21 | S | 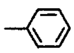 | $-CH_2-CH=CH_2$ | 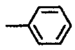 | $CF_3CO_2^-$ |
| B-22 | S | 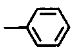 | 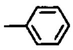 | $-CH=CH_2$ | $Cl^-$ |
| B-23 | S | 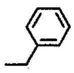 | 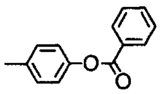 | $-CH_3$ | $SbF_6^-$ |
| B-24 | S | 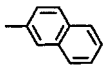 | 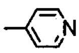 | 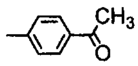 | $PF_6^-$ |
| B-25 | S | 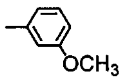 | 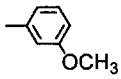 | 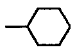 | $SO_4^{2-}$ |
| B-26 | S | $-CH_2CH_3$ | 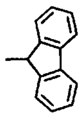 | $-CH_2CH_3$ | $NO_3^-$ |
| B-27 | S | 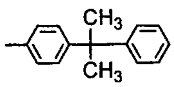 | 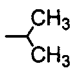 | 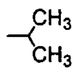 | $PF_6^-$ |
| B-28 | S | 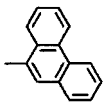 | $-CH_2CH_2CH_2CH_3$ | $-CH_2CH_2CH_2CH_3$ | $BF_4^-$ |
| B-29 | S | $-CH_3$ | $-CH_3$ | $-CH_2CH_2NH_2$ | $I^-$ |
| B-30 | S | 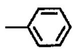 | 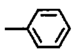 | 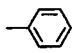 | $BF_4^-$ |
| B-31 | S | 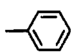 | 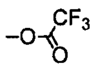 | 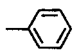 | $CF_3CO_2^-$ |
| B-32 | Se | 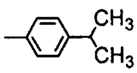 | 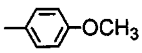 | 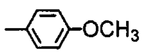 | $ClO_4^-$ |
| B-33 | Se | 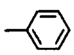 | 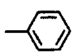 | 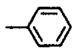 | $PF_6^-$ |
| B-34 | Se | 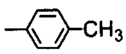 | $-CH_3$ | $-CH_3$ | $I^-$ |
| B-35 | Se | 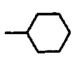 | 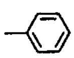 | 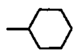 | $CF_3CF_2SO_3^-$ |

[Table 8]

| Number | $A^2$ | $-R^1$ | $-R^2$ | $-R^3$ | $Z^{n2-}$ |
|---|---|---|---|---|---|
| B-36 | Te | 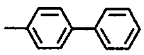 | 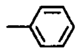 | 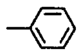 | $PF_6^-$ |
| B-37 | Te | $-CH_3$ | 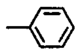 | $-CH_3$ | 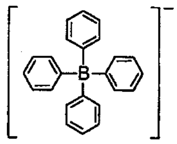 |
| B-38 | Te | 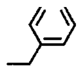 | 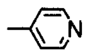 | 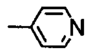 | $NO_3^-$ |

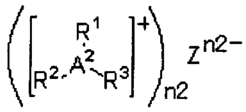 (I-2)

| Number | 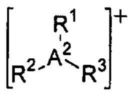 | $Z^{n2-}$ |
|---|---|---|
| B-39 | 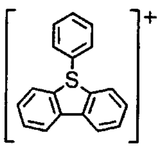 | 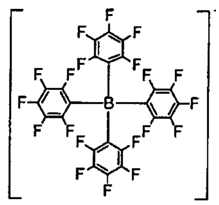 |
| B-40 | 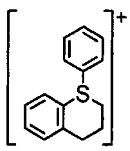 | 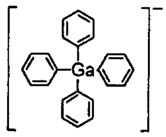 |
| B-41 | 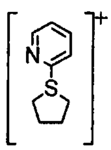 | $PF_6^-$ |
| B-42 | 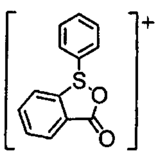 | $BF_4^-$ |
| B-43 | 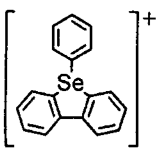 | $NO_3^-$ |

[Table 9]

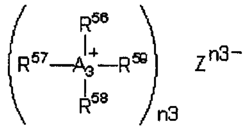 (I-3)

| Number | $A_3$ | $-R^{56}$ | $-R^{57}$ | $-R^{58}$ | $-R^{59}$ | $Z^{n3-}$ |
|---|---|---|---|---|---|---|
| C-1 | P | 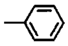 | 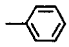 | 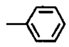 | 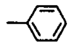 | 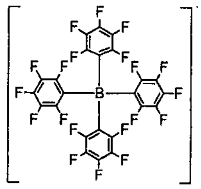 |
| C-2 | P | 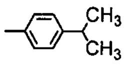 | 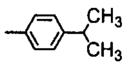 | 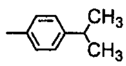 | 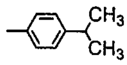 | $PF_6^-$ |
| C-3 | P | 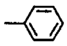 | 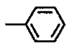 | 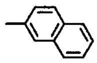 | 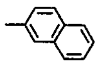 | 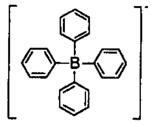 |
| C-4 | P | 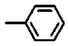 | 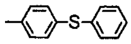 | 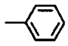 | 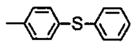 | $CF_3SO_3^-$ |
| C-5 | P | $-CH_3$ | 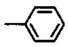 | 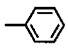 | 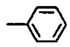 | $BF_4^-$ |
| C-6 | P | 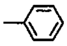 | $-CH_2-CH=CH_2$ | 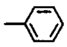 | 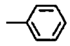 | $ClO_4^-$ |
| C-7 | P | 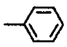 | 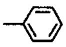 | $-CH_2-C\equiv CH$ | 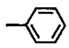 | $PF_6^-$ |
| C-8 | P | 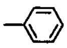 | 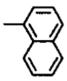 | 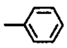 | 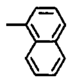 | $AsF_6^-$ |
| C-9 | P | 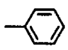 | 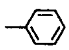 | 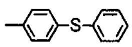 | 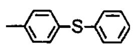 | 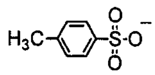 |
| C-10 | P | 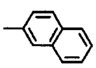 | 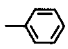 | | | 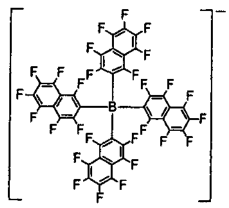 |
| C-11 | P | | | | | $Cl^-$ |
| C-12 | P | | | | | $AsF_6^-$ |
| C-13 | P | | | | | $Br^-$ |

(continued)

| Number | $A_3$ | $-R^{56}$ | $-R^{57}$ | $-R^{58}$ | $-R^{59}$ | $Z^{n3-}$ |
|---|---|---|---|---|---|---|
| C-14 | P | 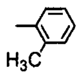 | 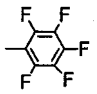 | 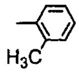 | 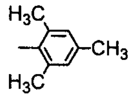 | $NO_3^-$ |

[Table 10]

| Number | $A^3$ | $-R^1$ | $-R^2$ | $-R^3$ | $-R^4$ | $Z^{n3-}$ |
|---|---|---|---|---|---|---|
| C-15 | P | 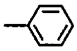 | 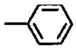 | 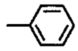 | $-CH=CH_2$ | $CF_3CF_2SO_3$ |
| C-16 | P | $-(CH_2)_5CH_3$ | 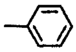 | 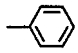 | 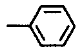 | $PF_6^-$ |
| C-17 | P | 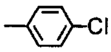 | 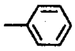 | 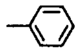 | 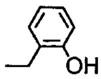 | $I^-$ |
| C-18 | P | $-CH_3$ | 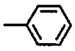 | 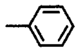 | $-CH_3$ | $I^-$ |
| C-19 | P | 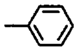 | 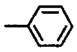 | 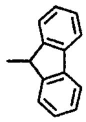 | 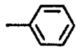 | 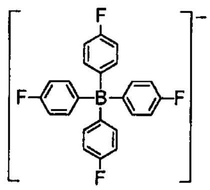 |
| C-20 | P | 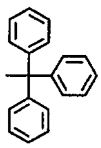 | 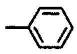 | 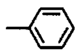 | 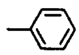 | $NO_3^-$ |
| C-21 | P | 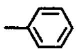 | 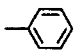 | 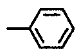 | 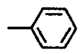 | 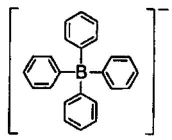 |
| C-22 | P | 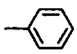 | 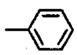 | $-CH_2CH_3$ | $-CH_2CH_3$ | $SO_4^{2-}$ |
| C-23 | P | 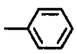 | 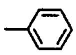 | 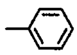 | 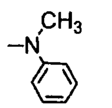 | $PF_6^-$ |
| C-24 | P | 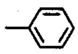 | 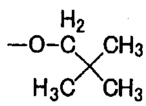 | 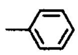 | 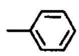 | $ClO_4^-$ |
| C-25 | As | | | | | $BF_4^-$ |

(continued)

| Number | $A^3$ | $-R^1$ | $-R^2$ | $-R^3$ | $-R^4$ | $Z^{n3-}$ |
|---|---|---|---|---|---|---|
| C-26 | As | 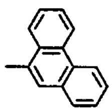 | 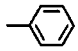 | 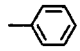 | 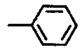 | $NO_3^-$ |
| C-27 | As | 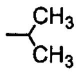 | 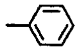 | 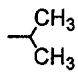 | 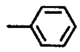 | $PF_6^-$ |
| C-28 | As | 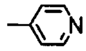 | 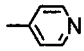 | 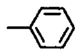 | 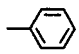 | $BF_4^-$ |
| C-29 | Sb | $-CH_3$ | $-CH_3$ | 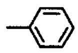 | 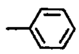 | $I^-$ |
| C-30 | Sb | 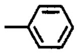 | 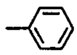 | 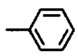 | 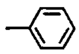 | $BF_4^-$ |

[Table 11]

| 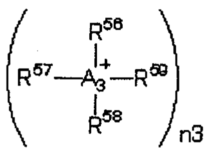 $Z^{n3-}$ (I-3) | | |
|---|---|---|
| Number | 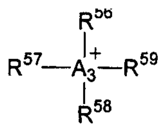 | $Z^{n3-}$ |
| C-31 | 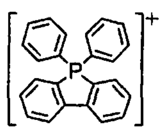 | 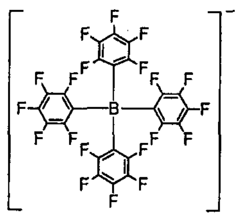 |
| C-32 | 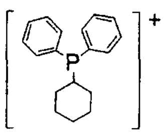 | $NO_3^-$ |
| C-33 | 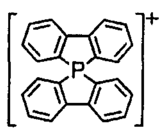 | 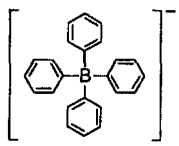 |
| C-34 | 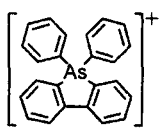 | $BF_4^-$ |

Of the above-mentioned specific examples, preferred are compounds of A-1 to 48, 54, 55, 60 to 62, 64 to 75, 79 to 83, B-1 to 20, 24, 25, 27, 30 to 37, 39 to 43, C-1 to 10, 19 to 21, 25 to 27, 30 and 31, from the viewpoint of electron

acceptability, heat resistance and solubility in solvent thereof; more preferred are compounds of A-1 to 9, 12 to 15, 17, 19, 24, 29, 31 to 33, 36, 37, 65, 66, 69, 80 to 82, B-1 to 3, 5, 7 to 10, 16, 30, 33, 39, C-1 to 3, 5, 10, 21, 25 and 31; and even more preferred are compounds of A-1 to 7 and 80.

One alone or two or more different types of electron-accepting compounds may be used here either singly or as combined in any desired manner and in any desired mixing ratio.

Content of the electron-accepting compound in the hole-injection-layer-forming composition is generally equal to or more than 0.01% by mass, preferably 0.05% by mass and is generally equal to or less than 20% by mass, preferably 10% by mass. The hole-injection-layer-forming composition may contain two or more electron-accepting compounds, and in such a case, it is desirable that the total content of two or more falls within the above range.

The content of the electron-accepting compound relative to the aromatic amine polymer in the hole-injection-layer-forming composition is generally equal to or more than 0.1% by mass, preferably 1% by mass, and is generally equal to or less than 100% by mass, preferably 40% by mass.

<Cationic Radical Compound>

Preferably, the hole injection layer contains a cationic radical compound from the viewpoint of increasing the efficiency of hole injection from anode and the viewpoint of increasing the performance of hole transportation.

Cationic radical compound is preferably an ionic compound that comprises a cationic radical of a chemical species formed by removing one electron from a hole-transporting compound, and a counter anion. However, when the cationic radical is derived from a hole-transporting aromatic amine polymer, the cationic radical has a structure formed by removing one electron from the aromatic amine structure of the aromatic amine polymer.

Preferably, the cationic radical is a chemical species formed by removing one electron from the compound described above as a hole-transporting compound, from the viewpoint of the amorphous structure, transmittance in the visible light range, the heat resistance and the solubility in solvent.

Here, the cationic radical compound may be formed by mixing the above-mentioned hole-transporting compound and the electron-accepting compound. Specifically, by mixing the hole-transporting compound and the electron-accepting compound, electron transfer from the hole-transporting compound to the electron-accepting compound occurs to form a cationic compound that comprises the cation radical of the hole-transporting compound and a counter anion.

[Light-Emitting Layer]

The light-emitting layer contains at least a material having a property of light emission (light-emitting material), and preferably further contains a material having charge transportability (charge-transporting material).

Not specifically defined, the light-emitting material may be any known light-emitting material capable of emitting light in a desired emission wavelength range and not negatively affecting the advantageous results of the present invention. The light-emitting material may be a fluorescent light-emitting material or a phosphorescent light-emitting material, but is preferably a material having good emission efficiency. From the viewpoint of the internal quantum efficiency thereof, preferred is a phosphorescent light-emitting material.

As the phosphorescent light-emitting material, for example, included are organic metal complexes containing a metal selected from Groups 7 to 11 of the Long Periodic Table. As the metal selected from Groups 7 to 11 of the Long Periodic Table, preferably mentioned are ruthenium, rhodium, palladium, silver, rhenium, osmium, iridium, platinum, gold, etc. More preferred are iridium and gold.

The ligand in the organic metal complexes is preferably one having a (hetero)aryl group and pyridine, pyrazole, phenanthroline or the like bonding thereto, such as a (hetero)arylpyridine ligand, a (hetero)arylpyrazole ligand or the like, and is more preferably a phenylpyridine ligand or a phenylpyrazole ligand. These ligands may further have a substituent. Here, (hetero)aryl means an aryl group or a heteroaryl group.

The charge-transporting material is a material having positive charge (hole) and/or negative charge (electron) transportability, for which usable without limitation are any known light-emitting materials not negatively affecting the advantageous results of the present invention.

As the charge-transporting material, usable are compounds heretofore used in the light-emitting layer in organic electroluminescent devices, and especially preferred are the compounds used as a host material in the light-emitting layer.

For forming the light-emitting layer, a vacuum evaporation method or a wet method of film formation can be adopted, but as excellent in film formability, preferred is a wet method of film formation. The light-emitting layer may be formed by using a wet method of film formation in the same manner as that for forming the hole injection and transport layer by using a wet method of film formation as mentioned above, in which, however, a light-emitting-layer-forming composition prepared by mixing a material to be a light-emitting layer in a solvent is used in substitution of the hole-injection-and-transport-layer-forming composition.

[Cathode]

The cathode in this embodiment is the second conductive layer in the present invention.

The cathode 9 is an electrode that plays a role of injecting electrons into the layer between the light-emitting layer 5 and the cathode.

The material of the cathode 9 is generally composed of a metal such as aluminium, gold, silver, nickel, palladium, platinum, etc.; a metal oxide such as indium oxide and/or tin oxide, etc.; a metal halide such as copper iodide, etc.; carbon black; or a conductive polymer such as poly(3-methylthiophene), polypyrrole, polyaniline, etc. Of those, preferred is a metal having a low work function to efficiently inject electrons, and for example, usable is a suitable metal such as tin, magnesium, indium, calcium, aluminium, silver or the like, or an alloy thereof. Concretely, included are alloy electrodes having a low work function, such as magnesium-silver alloy, magnesium-indium alloy, aluminium-lithium alloy, etc.

One alone or two or more different materials may be used for the cathode, either singly or as combined in any desired manner and in any desired mixing ratio.

To form the cathode 9, any known method is suitably adopted depending on the material thereof, and preferred is a vacuum evaporation method or a sputtering method.

The thickness of the cathode 9 varies depending on the necessary transparency. When high transparency is needed, the visible light transmittance is generally equal to or more than 60%, preferably 80%. In this case, the thickness of the cathode 9 is generally equal to or more than 5 nm, preferably 10 nm, and is generally equal to or less than 1000 nm, preferably around 500 nm. In case where the cathode 9 may be non-transparent, the thickness thereof may be arbitrary. Any other conductive material may be stacked on the cathode 9.

Further, for example, to protect the cathode formed of a metal having a low work function, for example, an alkali metal such as sodium, cesium or the like, or an alkaline earth metal such as barium, calcium or the like, it is desirable to further stack thereon a metal layer that has a high work function and has high stability to air, as increasing the device stability. For this purpose, for example, used is a metal such as aluminium, silver, copper, nickel, chromium, gold, platinum, etc. One alone or two or more different types of these materials may be used either singly or as combined in any desired manner and in any desired mixing ratio.

[Other Layers]

The organic electroluminescent device of the present invention may have the other functional layer between the above-mentioned indispensable layers. Examples of the other functional layers are mentioned below.

(Hole Blocking Layer)

The hole blocking layer 6 may be provided between the light-emitting layer 5 and the electron injection layer 8 to be mentioned below. The hole blocking layer 6 is a layer composed in the electron transport layer that plays a role to block holes injected from the anode 2 to reach the cathode 9. The hole blocking layer 6 is a layer to be stacked on the light-emitting layer 5 so as to be kept in contact with the interface of the light-emitting layer 5 towards the cathode 9.

The hole blocking layer 6 plays a role to block the holes injected from the anode 2 to reach the cathode 9, and plays a role to efficiently transport the electrons injected from the cathode 9 toward the light-emitting layer 5.

Regarding required physical properties thereof, materials to constitute the hole blocking layer 6 is desired to have a high electron mobility, a low hole mobility, a large energy gap (difference between HOMO and LUMO of the material) and a high excitation triplet energy level (T1). The material satisfying the requirements for the hole blocking layer 6 includes, for example, mixed ligand complexes such as bis(2-methyl-8-quinolinolato)(phenolato)aluminium, bis(2-methyl-8-quinolinolato)(triphenylsilanolato)aluminium, etc.; metal complexes such as bis(2-methyl-8-quinolato)aluminium-μ-oxo-bis(2-methyl-8-quinolinolato)aluminium binuclear metal complex, etc.; styryl compounds such as distyrylbiphenyl derivatives, etc. (JP-A 11-242996); triazole derivatives such as 3-(4-biphenylyl)-4-phenyl-5(4-tert-butylphenyl)-1,2,4-triazole, etc. (JP-A 7-41759); phenanthroline derivatives such as bathocuproin, etc. (JP-A 10-79297), etc. Further, compounds having at least one pyridine ring substituted at the 2,4,6-positions, as described in WO2005/022962, are also preferred as the material for the hole blocking layer 6.

The method to form the hole blocking layer 6 is not specifically defined. Accordingly, the hole blocking layer 6 may be formed by using a wet method of film formation, a vapor evaporation method or any other method.

The thickness of the hole blocking layer 6 may be any desired one, not markedly affecting negatively the advantageous results of the present invention. The thickness of the hole blocking layer 6 is typically equal to or more than 0.3 nm, preferably 0.5 nm, and is typically equal to or less than 100 nm, preferably 50 nm.

(Electron Transport Layer)

Electron transport layer 7 is a layer provided between the light-emitting layer and the cathode to transport electrons.

As the material to transport electrons for the electron transport layer 7, generally adopted is a compound having a high efficiency of electron injection from the cathode or the adjacent layer to the cathode, having a high electron mobility and capable to efficiently transport the injected electrons. The compound satisfying the requirements includes, for example, metal complexes such as aluminium complex or lithium complex of 8-hydroxyquinoline, etc. (JP-A 59-194393), 10-hydroxybenzo[h]quinoline metal complexes, oxadiazole derivatives, distyrylbiphenyl derivatives, silol derivatives, 3-hydroxyflavone metal complexes, 5-hydroxyflavone metal complexes, benzoxazole metal complexes, benzothiazole metal complexes, trisbenzimidazolylbenzene (USP 5645948), quinoxaline compounds (JP-A 6-207169), phenanthroline derivatives (JP-A 5-331459), 2-t-butyl-9,10-N,N'-dicyanoanthraquinonediimine, triazine compound derivatives, n-type hydrogenated amorphous silicon carbide, n-type zinc sulfide, n-type zinc selenide, etc.

As the material to transport electrons to be used for the electron transport layer, it is also desirable to dope an alkali metal such as sodium, potassium, cesium, lithium, rubidium or the like in an organic electron-transporting compound such as typically a nitrogen-containing heterocyclic compound, for example, basophenanthroline or the like or a metal complex, for example, an aluminium complex of 8-hydroxyquinoline or the like (as described in JP-A 10-270171, 2002-100478, 2002-100482, etc.), as capable to satisfy both good electron injection/transportation performance and excellent film quality. It is also effective to dope inorganic salt such as lithium fluoride, cesium carbide and so on, in the above-mentioned organic electron-transporting compound.

The formation method for the electron transport layer 7 is not specifically defined. Accordingly, the layer can be formed by using a wet method of film formation or a vapor evaporation method or in any other method.

Not significantly affecting negatively the advantageous results of the present invention, the thickness of the electron transport layer may be arbitrary. The thickness is generally equal to or more than 1 nm, preferably 5 nm, and is generally equal to or less than 300 nm, preferably 100 nm.

(Electron Injection Layer)

To efficiently inject the electrons from the cathode 9 into the light-emitting layer 5, the electron injection layer 8 may be provided between the electron transport layer 7 and the cathode 9 to be mentioned below. The electron injection layer 8 is formed of an inorganic salt, etc.

As the material for the electron injection layer 8, for example, included are lithium fluoride (LiF), magnesium fluoride ($MgF_2$), lithium oxide ($Li_2O$), cesium(II) carbonate ($CsCO_3$) or the like (see Applied Physics Letters, 1997, Vol. 70, p. 152; JP-A 10-74586; IEEE transactions on Electron Devices, 1997, Vol. 44, p. 1245; SID 04 Digest, p. 154, etc.).

The formation method for the electron injection layer 8 is not specifically defined. Accordingly, the layer may be formed by using a wet method of film formation or a vapor evaporation method or in any other method.

In many cases, the electron injection layer 8 have significantly little ability to transport electrons, and therefore, for efficient electron injection, it is desirable that the layer is extremely thin, and the thickness thereof is generally equal to or more than 0.1 nm and is preferably equal to or less than 5 nm.

[Evaluation Method for Electric Device Defects of Short-Circuit or Leakage in the Invention]

Short-circuit as referred to in the present invention means that, though the current increases nearly in proportion to the applied voltage, brightness of the emission does not increase in proportion to the supplying current and therefore the device does not almost emit light. Accordingly, the short-circuited device has a low brightness or does not emit light, and therefore could not fully function as an organic electroluminescent device. Leakage as referred to in the present invention means a phenomenon of such that current flows excessively relative to the applied voltage, as compared with the current value estimated according to its own nature. In case where an organic electroluminescent device has leakage therein, the supplying current focusses at the site where leakage occurs and therefore the brightness at the other part is getting lower, or excessive heat is generated at the leakage site and therefore the organic electroluminescent device degrades around the site as the center, and finally the device could no more emit light.

To check organic electroluminescent devices for electric device defects such short-circuit or leakage, generally adopted is a method comprising connecting an external electric power source to the supply terminals of an organic electroluminescent device finished to fabricate and observing and measuring the the emission of the device with supplying the electric power.

In this situation, when the device has short-circuited, the emission brightness does not increase proportionally to the supplying current though the current could increase nearly proportionally to the applied voltage, and in the worst case, the device does not almost emit light. Accordingly, it is relatively easy to determine short-circuited devices.

It is often difficult to judge whether devices have leakage or not. In case where an amount of leakage current is relatively large, a following method can be adoptive. A large number of organic electroluminescent devices having the same configuration and having a small emission area (in which the number of potential cause for the leakage would become stochastically small in accordance with the density of the surface defects to possibly cause leakage) are previously produced. The current efficiency to the emission brightness is previously measured, and this is compared with the current efficiency to the emission brightness of the organic electroluminescent device under test for current leakage.

Another method can be also adopted here. A readily leaking or a just leaking organic electroluminescent device is unstable, and spikes or steps readily occur in the voltage-current density graph of the device. Based on the fact, the differential of current density with voltage for the voltage-current density graph is calculated. When the calculated value has reached a certain level or more, the device under test is judged to have leakage. In general, a positive voltage is applied at the anode of the organic electroluminescent device for light emission, and by using the above-mentioned method, the setup that the current density change is measured in a state applying reverse voltage by applying a negative voltage to the anode can make the sensitivity to leakage more increased.

The details of the method for detecting leakage are described in the section of Examples given below.

## Examples

The present invention is described more concretely with reference to the following Examples. However, the present invention is not limited to the Examples, and the invention can be carried out in any modified manner not overstepping the scope and the spirit thereof.

<Detection And Judgment of Leakage -1 (reversed voltage applying method)>

Voltage at the step of interval -0.1 V in the voltage range from -3.1 V to -9 V was applied to an organic electroluminescent device finished to fabricate and the current through the device was measured. The ratio of the absolute value of the current change per -0.1 V in the above-mentioned applied voltage range to the current value at the lower absolute value of the voltage (hereinafter this is referred to as Z) is calculated as %, and within the total measurement voltage range, when at least one value of Z was more than 20%, the analyzed sample was judged to have "leakage", but when all the values were not more than 20%, the analyzed sample was judged to have "no leakage". More strictly, the measured voltage within the range from -3.1 V to -8.9 V is expressed as V0, and the current at the measured voltage is expressed by J[V0], therefore Z is defined as follows:

$$Z = |((J[V0\text{-}0.1]\text{-}J[V0])/J[V0])| \times 100\ (\%)$$

At every step of 0.1 V in the range of V0 from -3.1 to -8.9 V, Z is calculated. When all the values of Z are not more than 20%, then the device under test was judged to have "no leakage", and the others were judged to have "leakage".

Here, the judgment criteria for <Detection of Leakage -1> are severer than those for <Detection of Leakage -2> to be mentioned below.

<Detection And Judgment of Leakage -2 (reversed voltage applying method)>

Samples were analyzed by using the detection method of leakage -1. In this method, however, when at least one value of Z is more than 50%, then the analyzed sample was judged to have "leakage"; and when all the values of Z are not more than 50%, the analyzed sample was judged to have "no leakage".

(Reference Example)

Various types of glass baseplates produced by changing the production method and the material thereof and by changing the presence or absence of treatment for polishing them, various glass baseplates manufactured by different glass baseplate manufacturers, and glass substrates (A to H) were analyzed in point of the waviness tangent, the content of $Na_2O$ and $K_2O$, and the density of surface defects, and the results are shown below. The evaluation condition for each parameter is mentioned below.

[Measurement Condition for Waviness Tangent]

Measurement Apparatus: SURFCOM M480A (manufactured by Tokyo Seimitsu Co., Ltd.)

Setup based on filtered centerline waviness measurement (JIS B0601 :'94)

(a) Evaluation length = from 80 mm or more to less than 100 mm
(b) Measurement speed = 3.0 mm/sec.
(c) Cutoff value (λc -λf) = from 0.8 to 8.0 mm
(d) Filter class = 2RC (compensation)

[Content of $Na_2O$ and $K_2O$]

Measurement method: X-ray fluorescence analysis (XRF)
Measurement Apparatus: RIX-3001 (manufactured by Rigaku Corporation)
XRF measurement condition

(a) Measurement room vacuum degree = 10 Pa or less
(b) X-ray tube voltage-current = 50 kV - 50 mA

[Density of surface defects]

Measurement area: four regions of 7 mm × 10.5 mm squared
ITO film thickness: 110 nm, or 150 nm
Optical microscope: LV100D (manufactured by Nikon Corporation)
Objective lens/ocular lens magnification: 20-fold/10-fold

Specifications and measured results of the glass baseplate (H) and the glass substrates (A to G and I) are shown in Table 12.

[Table 12]

Table 12

| Type of Glass Baseplate/ Substrate | Glass Production Method | Glass Material | Presence or Absence of Polishing | Waviness Tangent (× $10^{-5}$) minimum/ maximum | $Na_2O$ Content (mass%) | $K_2O$ Content (mass%) | Density of Surface Defects (/$cm^2$) |
|---|---|---|---|---|---|---|---|
| A | floating | alkali | no | 8.22/35.06 | 5.47 | 4.12 | 15.64 |
| B | floating | alkali | no | 4.73/46.06 | 7.45 | 2.04 | 4.08 |
| C | floating | alkali | no | 7.76/36.64 | 7.63 | 1.42 | 5.10 |
| D | floating | alkali | no | 4.71/47.30 | 7.21 | 1.99 | 8.84 |
| E | floating | alkali | no | 7.22/87.13 | 4.65 | 6.08 | 2.04 |
| F | fusion | non-alkali | no | - | - | - | 1.70 |
| G | fusion | non-alkali | no | 3.97/21.08 | less than detection limit | 0.018 | - |
| H | floating | non-alkali | yes | 0/∞ | - | - | - |
| I | floating | alkali | no | 4.07/38.43 | - | - | 2.72 |

The glass substrates from A to E and I are glass substrates produced by forming a layer of ITO (A to E having its thickness of 110 nm, and I having 150 nm) by using a sputtering method. The ITO of each substrate was deposited via an $SiO_2$ barrier layer of about 20 nm on each unpolished glass baseplate produced by using the method of float process; the glass substrate F and the glass substrate G are glass substrates produced by forming a layer of ITO having

a thickness of 110 nm by using a sputtering method, directly on each unpolished glass baseplate produced by using a method of fusion process; and the glass baseplate H is a glass baseplate produced only with polishing a glass baseplate produced by using the method of float process.

The glass substrates to be used in the organic electroluminescent device of the present invention are A to E and I that were produced by using the method of float process and were not polished. For each of these, the minimum value of waviness tangent of the substrate is not less than $4.00 \times 10^{-6}$, even not less than $4.02 \times 10^{-6}$, and the maximum value of the waviness tangent is not less than $22 \times 10^{-6}$. The $Na_2O$ content is not less than 2.0% by mass. The density of the surface defects is not less than 2.0 defects/$cm^2$.

On the other hand, for both of the glass substrate G produced by using a method of fusion process and the glass baseplate H produced by using the method of float process and polished, the minimum value of waviness tangent of the baseplate and the like is less than $4.02 \times 10^{-6}$, even less than $4.00 \times 10^{-6}$, and the maximum value of the waviness tangent is less than $22 \times 10^{-6}$. The density of the surface defects of the glass substrate F produced by using a method of fusion process is less than 2.0 defects/$cm^2$.

[Example 1-1]

An organic electroluminescent device was produced having the layer configuration of Fig. 1, in which the hole blocking layer 6 and the electron transport layer 7 were omitted, and having an emission area of 9x9 mm squared.

<Formation of Coating-type Hole Injection and Transport Layer on Substrate>

First, ITO of the glass substrate A formed of ITO as an anode having a thickness of 110 nm was patterned to provide an emission area of 9x9 mm squared.

Next, the polymer compound having a repeating structure shown by the following formula (A) (Mw = 65,000), the polymer compound having a repeating structure shown by the following formula (B) (Mw = 85,000) and 4-isopropyl-4'-methyldiphenyliodonium tetrakis(pentafluorophenyl)borate were mixed in a ratio by mass of 5/95/15, and dissolved in ethyl benzoate to prepare a composition having a total concentration of the mixture therein of 5.5% by mass. The composition was applied onto the glass substrate by using a spin-coating method in air at the rotation speed of 2850 rpm for duration of 30 seconds. Subsequently, this substrate was heated at 230°C for 1 hour to form a hole injection layer having a thickness of 150 nm.

[Chem. 15]

Formula (A)

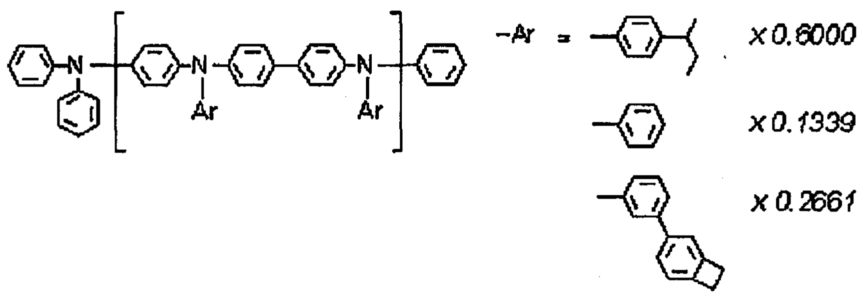

Formula (B)

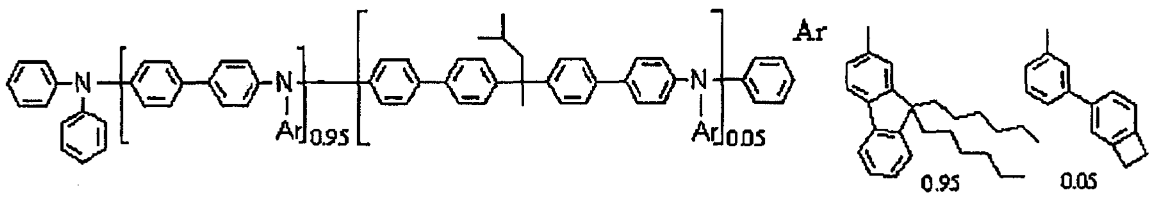

<Formation of Hole Transport Layer>

Next, as a hole transport layer, 4,4'-bis[N-(9-phenanthryl)-N-phenylamino]biphenyl (PPD) shown below was formed thereon to have a thickness of 45 nm by using a vacuum evaporation method.

[Chem. 16]

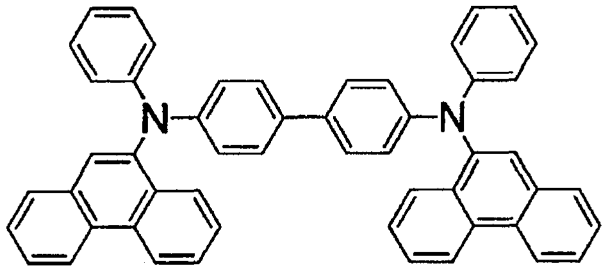

<Formation of Light-Emitting Layer>

Next, as a light-emitting layer, tris(8-hydroxyquinolinato)aluminium (Alq3) was formed thereon to have a thickness of 60 nm by using a vacuum evaporation method.

<Formation of Electron Injection Layer>

Next, lithium fluoride (LiF) was deposited to have a thickness of 0.5 nm on the light-emitting layer by using a vacuum evaporation method, thereby forming an electron injection layer thereon.

<Formation of Cathode>

Next, aluminium was deposited to have a thickness of 80 nm by using a vapor evaporation method, thereby forming a cathode.

<Sealing Step>

Subsequently, in a nitrogen globe box, a photocurable resin was dispensed to the outer periphery of a glass plate, and in the center part of the plate, a water getter sheet was placed on it. The glass plate was positioned and stuck to the device that had been processed to have thereon all the layers up to the second electrode 4. With that, only the region coated with the photocurable resin was exposed to UV light to cure the resin. Accordingly, an organic electroluminescent device was obtained.

In Example 1-1, the hole injection layer alone was formed by using a wet method of film formation, and therefore, the hole injection layer alone corresponds to the charge injection and transport layer in the present invention.

[Example 2-1]

An organic electroluminescent device was produced in the same manner as in Example 1-1, except that the hole injection layer was formed to have a thickness of 200 nm by using a spin-coating method at 1950 rpm for 30 seconds.

[Example 3-1]

An organic electroluminescent device was produced in the same manner as in Example 1-1, except that the hole injection layer was formed to have a thickness of 400 nm by using a spin-coating method at 910 rpm for 30 seconds.

[Example 4-1]

An organic electroluminescent device was produced in the same manner as in Example 1-1, except that the hole injection and transport layer was formed to have a thickness of 500 nm using a solution having a composition concentration of 6.5 wt% and by using a spin-coating method at 1050 rpm for 30 seconds.

[Comparative Example 1-1]

An organic electroluminescent device was produced in the same manner as in Example 1-1, except that the hole injection and transport layer was formed to have a thickness of 100 nm by using a spin-coating method at 5500 rpm for 30 seconds.

[Reference Example 1-1]

An organic electroluminescent device was produced in the same manner as in Example 1-1, except that the glass substrate F produced by using a method of fusion process was used and the hole injection and transport layer was formed to have a thickness of 30 nm.

<Check for Short-Circuit and/or Leakage>

Voltage at the step of interval -0.1 V from -3.1 V to -9 V was applied to the organic electroluminescent device finished to fabricate, and the current was measured. The device was checked for the presence or absence of leakage therein by using the above-mentioned method (detection of leakage -1). Plural samples of each organic electroluminescent device produced in Examples 1-1 to 4-1, Comparative Example 1-1 and Reference Example 1-1 were tested in the manner, and the ratio of the number of the samples judged to have leakage was referred to as "leakage incidence ratio". The results are shown in Table 13.

[Table 13]

Table 13

| | Type of Glass Substrate | Glass Production Method | Glass Material | Presence or Absence of Polishing | Hole Injection Layer Thickness (nm) | Hole Injection Layer Thickness/ Anode Thickness | Leakage Incidence Ratio |
|---|---|---|---|---|---|---|---|
| Example 1-1 | A | floating | alkali | no | 150 | 1.36 | 56% |
| Example 2-1 | A | floating | alkali | no | 200 | 1.82 | 22% |
| Example 3-1 | A | floating | alkali | no | 400 | 3.64 | 0% |
| Example 4-1 | A | floating | alkali | no | 500 | 4.55 | 0% |
| Comparative Example 1-1 | A | floating | alkali | no | 100 | 0.91 | 100% |
| Reference Example 1-1 | F | fusion | non-alkali | no | 30 | 0.27 | 25% |

The above results confirm that, even though organic electroluminescent devices are produced using an unpolished and inexpensive glass substrate produced by using the method of float process, or that is, a glass baseplate having a large waviness, of which the minimum value of the waviness tangent is equal to or more than $4.20 \times 10^{-6}$ or the maximum value of the waviness tangent is equal to or more than $22 \times 10^{-6}$, or a glass substrate having many surface defects, of which the density of the surface defects is equal to or more than 2.0 defects/$cm^2$, it is possible to realize organic electroluminescent devices with no leakage only when a hole injection layer of which the thickness is at least 1.3 times the thickness of the anode is formed by using a wet method of film formation (the fourth and fifth aspects of the present invention), and it is also possible to realize organic electroluminescent devices free from leakage on the same level as or on a higher level than those produced using an already-existing expensive glass substrate only when a hole injection layer having a thickness of at least 1.8 times the thickness of the anode is formed by using a wet method of film formation.

The above results also confirm that, even though organic electroluminescent=devices are produced using an unpolished and inexpensive glass substrate produced by using the method of float process, or that is, a glass baseplate having a large waviness, of which the minimum value of the waviness tangent is equal to or more than $4.00 \times 10^{-6}$ or the maximum value of the waviness tangent is equal to or more than $22 \times 10^{-6}$, it is possible to realize organic electroluminescent devices with no leakage to the same degree as that of organic electroluminescent devices produced using already-existing expensive glass substrates only when the thickness of the anode is equal to or more than 130 nm and the charge injection layer contains a crosslinked aromatic amine polymer (the first aspect of the present invention).

[Example 1-2 to Example 4-2, Comparative Example 1-2, and Reference Example 1-2]

Organic electroluminescent devices of Example 1-2 to Example 4-2, Comparative Example 1-2 and Reference Example 1-2 were produced in the same manner as that in Example 1-1 to Example 4-1, Comparative Example 1-1,

and Reference Example 1-1, and checked for the presence or absence of leakage therein according to <detection of leakage -2>.

The results are shown in Table 14.

[Table 14]

Table 14

| | Type of Glass Substrate | Glass Production Method | Glass Material | Presence or Absence of Polishing | Hole Injection Layer | Hole Transport Layer (wet method of film formation) | Hole Injection and Transport Layer Thickness (nm) | Leakage Incidence Ratio (%)*1 |
|---|---|---|---|---|---|---|---|---|
| Example 1-2 | A | floating | alkali | no | formula (A) +formula (B) | - | 150 | 30 |
| Example 2-2 | A | floating | alkali | no | formula (A) +formula (B) | - | 200 | 0 |
| Example 3-2 | A | floating | alkali | no | formula (A) + formula (B) | - | 400 | 0 |
| Example 4-2 | A | floating | alkali | no | formula (A) +formula (B) | - | 500 | 0 |
| Comparative Example 1-2 | A | floating | alkali | no | formula (A) +formula (B) | - | 100 | 100 |
| Reference Example 1-2 | F | fusion | non-alkali | no | formula (A) +formula (B) | - | 30 | 0 |

*1: according to detection of leakage -2.

[Example 5]

An organic electroluminescent device was produced having the layer configuration of Fig. 1, in which the hole blocking layer 6 and the electron transport layer 7 were omitted, and having an emission area of 7x7 mm squared.

<Formation of Coating-type Hole Injection and Transport Layer on Substrate>

First, ITO of the glass substrate I formed of ITO as an anode having a thickness of 150 nm was patterned to provide an emission area of 7x7 mm squared.

Next, the polymer compound having a repeating structure shown by the following formula (C) (Mw = 83,000) and 4-isopropyl-4'-methyldiphenyliodonium tetrakis(pentafluorophenyl)borate were mixed in a ratio by mass of 100/15, and dissolved in ethyl benzoate to prepare a composition having a total concentration of the mixture therein of 5.0% by mass. The composition was applied onto the glass substrate I by using a spin-coating method in air at 6000 rpm for 30 seconds. Subsequently, this was heated at 230°C for 1 hour to form a hole injection layer having a thickness of 73 nm.

[Chem. 17]

Formula (C)

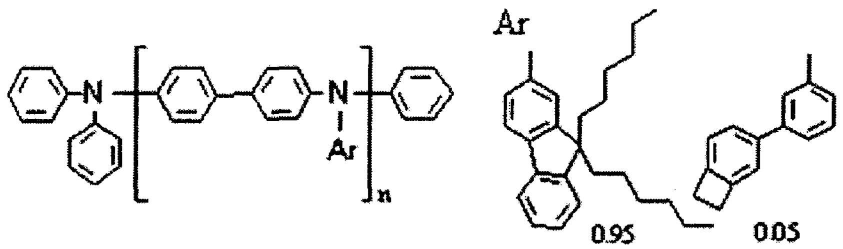

<Formation of Coating-type Hole Transport Layer>

Next, the polymer compound having a repeating structure shown by the following formula (D) (Mw = 60,000) was dissolved in cyclohexylbenzene to have a concentration of 3.0% by mass, thereby preparing a composition.

[Chem. 18]

Formula (D)

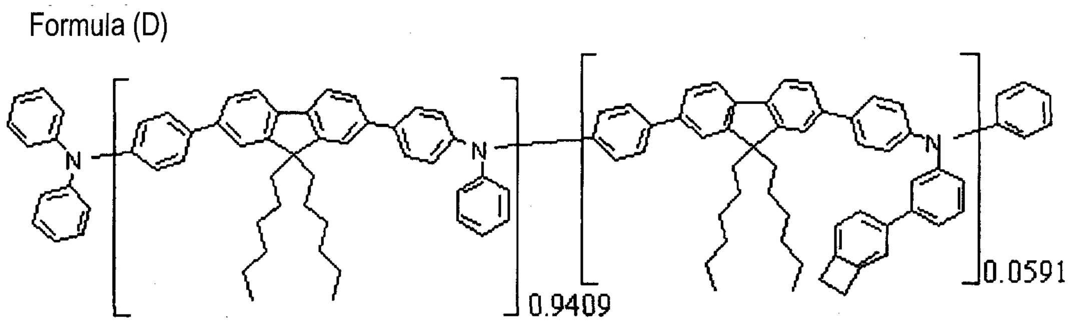

The composition was applied onto the glass baseplate I with the hole injection layer formed thereon, by using a spin-coating method in a nitrogen atmosphere at 2950 rpm for 120 seconds. Subsequently, this was heated in a nitrogen atmosphere at 230°C for 1 hour, thereby to form a coating-type hole transport layer having a thickness of 57 nm. Next, 4,4'-bis[N-(9-phenanthryl)-N-phenylamino]biphenyl (PPD) shown below was formed thereon to have a thickness of 45 nm by using a vacuum evaporation method, thereby to form a deposition-type hole transport layer.

<From Formation of Light-Emitting Layer to Sealing Step>

Next, according to the same process as in Example 1-1 from the step of light-emitting layer formation to the sealing step, an organic electroluminescent device was produced.

In Example 5, the hole injection layer and the coating-type hole transport layer were formed by using a wet method of film formation, and therefore both the hole injection layer and the coating-type hole transport layer correspond

to the charge injection and transport layer in the present invention.

[Example 6]

An organic electroluminescent device was produced in the same manner as in Example 5, except that the hole injection layer was formed to have a thickness of 88 nm by using a spin-coating method at 4200 rpm for 30 seconds and that the coating-type hole transport layer was formed to have a thickness of 62 nm by using a spin-coating method at 2250 rpm for 120 seconds.

[Example 7]

An organic electroluminescent device was produced in the same manner as in Example 5, except that the hole injection layer was formed to have a thickness of 122 nm by using a spin-coating method at 2500 rpm for 30 seconds, and also except that the coating-type hole transport layer was formed to have a thickness of 79 nm by using a spin-coating method at 3200 rpm for 120 seconds using a solution having a composition concentration of 4.0 wt%.

[Example 8]

An organic electroluminescent device was produced in the same manner as in Example 5, except that the hole injection layer was formed to have a thickness of 187 nm by using a spin-coating method at 4300 rpm for 30 seconds using a solution having a composition concentration of 7.0 wt%, and also except that the coating-type hole transport layer was formed to have a thickness of 118 nm by using a spin-coating method at 3500 rpm for 120 seconds using a solution having a composition concentration of 5.0 wt%.

[Example 9]

An organic electroluminescent device was produced in the same manner as in Example 8, except that the hole injection layer was formed to have a thickness of 245 nm by using a spin-coating method at 2750 rpm for 30 seconds, and also except that the coating-type hole transport layer was formed to have a thickness of 158 nm by using a spin-coating method at 2500 rpm for 120 seconds.

[Example 10]

An organic electroluminescent device was produced in the same manner as in Example 8, except that the hole injection layer was formed to have a thickness of 303 nm by using a spin-coating method at 2150 rpm for 30 seconds, and also except that the coating-type hole transport layer was formed to have a thickness of 198 nm by using a spin-coating method at 2500 rpm for 120 seconds using a solution having a composition concentration of 6.0 wt%.

[Comparative Example 2]

An organic electroluminescent device was produced in the same manner as in Example 5, except that the hole injection layer was formed to have a thickness of 32 nm by using a spin-coating method at 3500 rpm for 30 seconds using a solution having a composition concentration of 2.5 wt%, and also except that the coating-type hole transport layer was formed to have a thickness of 28 nm by using a spin-coating method at 3500 rpm for 120 seconds using a solution having a composition concentration of 2.0 wt%.

[Comparative Example 3]

An organic electroluminescent device was produced in the same manner as in Example 5, except that the hole injection layer was formed to have a thickness of 61 nm by using a spin-coating method at 2600 rpm for 30 seconds using a solution having a composition concentration of 3.5 wt%, and also except that the coating-type hole transport layer was formed to have a thickness of 44 nm by using a spin-coating method at 3800 rpm for 120 seconds.

[Example 11]

An organic electroluminescent device was produced in the same manner as in Example 5, except that the hole injection layer and the coating-type hole transport layer were produced as follows.
The polymer compound having a repeating structure shown by the following formula (F) (Mw = 39,000) and 4-isopropyl-4'-methyldiphenyliodonium tetrakis(pentafluorophenyl)borate were mixed in a ratio by mass of 100/20, and dissolved in ethyl benzoate to prepare a composition having a total concentration of the mixture therein of 5.0% by mass. The composition was applied onto the glass substrate I by using a spin-coating method in air at 2200 rpm for 30 seconds. Subsequently, this substrate was heated at 230°C for 1 hour to form a hole injection layer having a thickness of 93 nm.

[Chem. 19]

Formula (F)

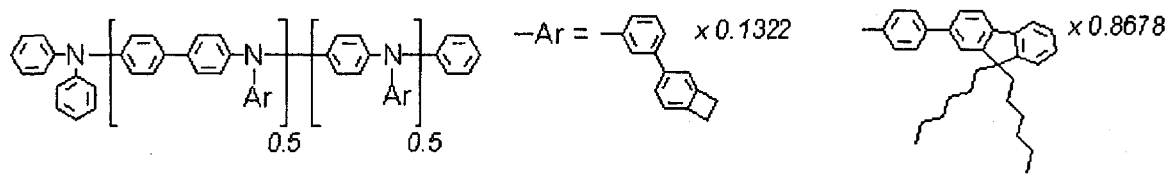

The coating-type hole transport layer was formed to have a thickness of 56 nm by using a spin-coating method at 2100 rpm for 120 seconds, in the same manner as in Example 6.

[Comparative Example 4]

An organic electroluminescent device was produced in the same manner as in Example 5, except that the hole injection layer and the coating-type hole transport layer were produced as follows.

The polymer compound having a repeating structure shown by the following formula (G) (Mw = 29,000) and 4-isopropyl-4'-methyldiphenyliodonium tetrakis(pentafluorophenyl)borate were mixed in a ratio by mass of 100/40, and dissolved in ethyl benzoate to prepare a composition having a total concentration of the mixture therein of 4.0% by mass. The composition was applied onto the glass substrate I by using a spin coating method in air at 3100 rpm for 30 seconds. Subsequently, this was heated at 230°C for 1 hour to form a hole injection layer having a thickness of 59 nm.

[Chem. 20]

Formula (G)

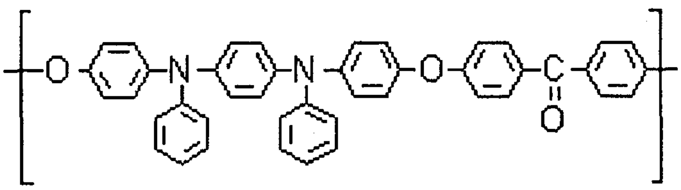

The coating-type hole transport layer was formed to have a thickness of 41 nm by using a spin-coating method at 4500 rpm for 120 seconds, in the same manner as in Example 7.

[Comparative Example 5]

An organic electroluminescent device was produced in the same manner as in Comparative Example 4, except that the hole injection layer was formed to have a thickness of 79 nm by using a spin-coating method at 3400 rpm for 30 a solution having a composition concentration of 5.0 wt%, and also except that the coating-type hole transport layer was formed to have a thickness of 50 nm by using a spin-coating method at 2950 rpm for 120 seconds using a solution having a composition concentration of 3.0 wt%.

[Comparative Example 6]

An organic electroluminescent device was produced in the same manner as in Comparative Example 5, except that the hole injection layer was formed to have a thickness of 92 nm by using a spin-coating method at 2700 rpm for 30 seconds, and also except that the coating-type hole transport layer was formed to have a thickness of 59 nm by using a spin-coating method at 2950 rpm for 120 seconds.

[Comparative Example 7]

An organic electroluminescent device was produced in the same manner as in Comparative Example 4, except that the hole injection layer was formed to have a thickness of 107 nm by using a spin-coating method at 2300 rpm for 30 seconds using a solution having a composition concentration of 5.0 wt%, and also except that the coating-type hole transport layer was formed to have a thickness of 85 nm by using a spin-coating method at 3000 rpm for 120 seconds.

[Comparative Example 8]

An organic electroluminescent device was produced in the same manner as in Comparative Example 5, except that the hole injection layer was formed to have a thickness of 183 nm by using a spin-coating method at 2300 rpm for 30 seconds using a solution having a composition concentration of 7.0 wt%, and also except that the coating-type hole transport layer was formed to have a thickness of 118 nm by using a spin-coating method at 2300 rpm for 120 seconds using a solution having a composition concentration of 5.0 wt%.

[Comparative Example 9]

An organic electroluminescent device was produced in the same manner as in Comparative Example 8, except that the hole injection layer was formed to have a thickness of 232 nm by using a spin-coating method at 2750 rpm for 30 seconds using a solution having a composition concentration of 8.0 wt%, and also except that the coating-type hole transport layer was formed to have a thickness of 158 nm by using a spin-coating method at 2000 rpm for 120 seconds.

[Comparative Example 10]

An organic electroluminescent device was produced in the same manner as in Comparative Example 9, except that the hole injection layer was formed to have a thickness of 301 nm by using a spin-coating method at 2050 rpm for 30 seconds, and also except that the coating-type hole transport layer was formed to have a thickness of 198 nm by using a spin-coating method at 2500 rpm for 120 seconds using a solution having a composition concentration of 6.0 wt%.
The organic electroluminescent devices produced in Examples 5 to 11 and Comparative Examples 2 to 10 were checked for the presence or absence of leakage therein according to <detection of leakage -2>. The results are shown in Table 15.
[Table 15]

Table 15

| | Type of Glass Substrate | Glass Production Method | Glass Material | Presence or Absence of Polishing | Hole Injection Layer | Hole Transport Layer (wet method of film formation) | Hole Injection and Transport Layer Thickness (nm) | Leakage Incidence Ratio (%)*1 |
|---|---|---|---|---|---|---|---|---|
| Example 5 | I | floating | alkali | no | formula (C) | formula (D) | 130 | 38 |
| Example 6 | I | floating | alkali | no | formula (C) | formula (D) | 150 | 25 |
| Example 7 | I | floating | alkali | no | formula (C) | formula (D) | 201 | 19 |
| Example 8 | I | floating | alkali | no | formula (C) | formula (D) | 305 | 0 |
| Example 9 | I | floating | alkali | no | formula (C) | formula (D) | 403 | 0 |
| Example 10 | I | floating | alkali | no | formula (C) | formula (D) | 500 | 0 |
| Example 11 | I | floating | alkali | no | formula (E) | formula (D) | 149 | 25 |
| Comparative Example 2 | I | floating | alkali | no | formula (C) | formula (D) | 60 | 100 |
| Comparative Example 3 | I | floating | alkali | no | formula (C) | formula (D) | 105 | 100 |
| Comparative Example 4 | I | floating | alkali | no | formula (G) | formula (D) | 100 | 81 |
| Comparative Example 5 | I | floating | alkali | no | formula (G) | formula (D) | 129 | 63 |
| Comparative Example 6 | I | floating | alkali | no | formula (G) | formula (D) | 151 | 50 |
| Comparative Example 7 | I | floating | alkali | no | formula (G) | formula (D) | 192 | 31 |
| Comparative Example 8 | I | floating | alkali | no | formula (G) | formula (D) | 301 | 25 |
| Comparative Example 9 | I | floating | alkali | no | formula (G) | formula (D) | 390 | 19 |
| Comparative Example 10 | I | floating | alkali | no | formula (G) | formula (D) | 499 | 6 |

*1: according to detection of leakage -2.

The results in Table 13 to Table 15 confirm the following:

(1) The leakage incidence ratio in the organic electroluminescent devices of Examples is the same numerical level as that in the cases using already-existing high-cost glass baseplates produced by using a method of fusion process (Reference Examples 1-1 and 1-2).
(2) Though the organic electroluminescent devices of Examples use glass produced by using the method of float process, the leakage incidence ratio therein can be reduced as compared with that in the cases where the thickness of the charge injection and transport layer (hole injection and transport layer) is small (Comparative Example 1-1, Comparative Example 1-2, Comparative Examples 2 and 3). In some Examples in Table 14, the leakage incidence ratio is higher than that in Comparative Examples in Table 15 (for example, the leakage incidence ratio in Example 1-2 is higher than that in Comparative Examples 8 to 10). However, the data in the tables must be compared with each other between those in which the thickness of the charge injection and transport layer (hole injection and transport layer) is nearly the same and in which only the type of the aromatic amine polymer contained in the charge injection and transport layer (hole injection and transport layer) is changed (taking the point of presence or absence of crosslinking in each polymer into account). For example, in Example 1-2 and Comparative Example 6, the thickness of the hole injection and transport layer is about 150 nm, and it is known that, in Example 1-2 in which a crosslinked aromatic amine polymer is used in the hole injection and transport layer, the leakage incidence ratio is reduced as compared with that in Comparative Example 6 where a crosslinked aromatic amine polymer is not used in the hole injection and transport layer.
(3) In the test for <detection of leakage -2>, the cases using the glass substrate A of which the minimum value of the waviness tangent is not less than 4.20 (Examples 1-2 to 4-2, Comparative Example 1-2) provided a good result of leakage incidence ratio of 0% when the thickness of the charge injection and transport layer (hole injection and transport layer) is 200 nm. On the other hand, in the cases using the glass baseplate I of which the minimum value of the waviness tangent is not less than 4.00 (Example 5 to Example 10, Comparative Examples 2 and 3), the leakage incidence ratio was not 0% even though the thickness of the charge injection and transport layer (hole injection and transport layer) was 201 nm; but in these, the leakage incidence ratio was 0% when the thickness of the layer was 305 nm.

While the present invention has been described in detail with reference to specific embodiments thereof, it will be apparent to one skilled in the art that various changes and modifications can be made therein without departing from the spirit and scope thereof. The present application is based on a Japanese patent application filed on September 4, 2012 (Application No. 2012-194341), the contents of which are incorporated herein by reference.

Reference Signs List

1 Baseplate (Glass Baseplate)
2 Anode
3 Hole Injection Layer
4 Hole Transport Layer
5 Light-Emitting Layer
6 Hole-Blocking Layer
7 Electron Transport Layer
8 Electron Injection Layer
9 Cathode
10 Organic Electroluminescent Device
11 Hole Injection and Transport Layer

## Claims

**1.** An organic electroluminescent device comprising, as stacked on a glass baseplate, at least, a first conductive layer, a charge injection and transport layer, a light-emitting layer, and a second conductive layer, wherein:

(1) the minimum value of a waviness tangent of the surface of the glass baseplate towards the first conductive layer is equal to or more than $4.00 \times 10^{-6}$, or a maximum value of the waviness tangent is equal to or more than $22 \times 10^{-6}$,

(2) the charge injection and transport layer is a layer formed by using a wet method of film formation,
(3) the charge injection and transport layer includes a charge injection layer in contact with the first conductive layer,
(4) the charge injection and transport layer has a thickness ranging from 130 to 1000 nm,
(5) the charge injection layer contains a crosslinked aromatic amine polymer.

**2.** The organic electroluminescent device according to claim 1, wherein a density of surface defects in the state where the first conductive layer is formed on the glass baseplate is equal to or more than 2.0 defects/$cm^2$.

**3.** The organic electroluminescent device according to claim 1 or claim 2, wherein the glass baseplate contains at least one of $Na_2O$ and $K_2O$ in an amount equal to or more than 1.0% by mass.

**4.** The organic electroluminescent device according to any one of claim 1 to claim 3, wherein the thickness of the charge injection and transport layer is ranging from 130 to 500 nm.

**5.** The organic electroluminescent device according to any one of claim 1 to claim 4, wherein the glass baseplate is produced by using the method of float process.

**6.** The organic electroluminescent device according to claim 5, wherein the glass baseplate is an unpolished glass baseplate.

**7.** The organic electroluminescent device according to any one of claim 1 to claim 6, wherein the crosslinked aromatic amine polymer contains a partial structure represented by the following formula (1):

[Chem. 1]

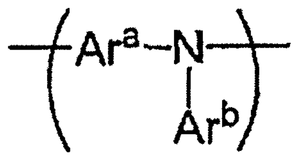

(1)

(In the formula (1), $Ar^a$ and $Ar^b$ each independently represent an aromatic hydrocarbon-cyclic group or an aromatic heterocyclic group having from 4 to 60 carbon atoms and optionally having a substituent, and $Ar^a$ is a divalent group, and $Ar^b$ is a monovalent group.)

**8.** The organic electroluminescent device according to any one of claim 1 to claim 7, wherein the crosslinked aromatic amine polymer has a crosslinked structure derived from a crosslinking group selected from the following crosslinking group family T:
<Crosslinking Group Family T>

[Chem. 2]

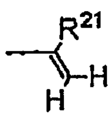
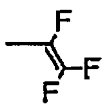
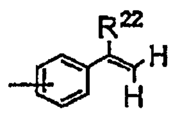
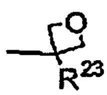
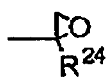
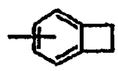

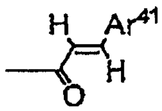
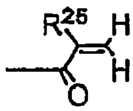
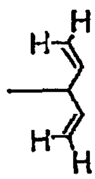
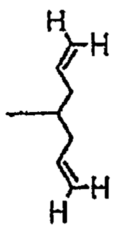
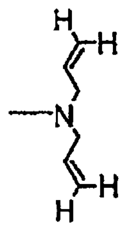

(In the formulae, $R^{21}$ to $R^{25}$ each independently represent a hydrogen atom or an alkyl group having from 1 to 12

carbon atoms, $Ar^{41}$ represents an aromatic hydrocarbon-cyclic group optionally having a substituent or an aromatic heterocyclic group optionally having a substituent, and the benzocyclobutene ring may optionally have a substituent.)

**9.** An organic electroluminescent device comprising, as stacked on a baseplate, at least, a first conductive layer, a charge injection and transport layer, a light-emitting layer, and a second conductive layer, wherein:

(1) the charge injection and transport layer is a layer formed by using a wet method of film formation,
(2) the charge injection and transport layer includes a charge injection layer in contact with the first conductive layer,
(3) the charge injection and transport layer has a thickness ranging from 130 to 1000 mm,
(4) the charge injection layer contains a crosslinked aromatic amine polymer.

**10.** The organic electroluminescent device according to claim 9, wherein the baseplate is a glass baseplate, and a density of surface defects in the state where the first conductive layer is formed on the glass baseplate is equal to or more than 2.0 defects/$cm^2$.

**11.** The organic electroluminescent device according to claim 10, wherein the glass baseplate is produced by using the method of float process.

**12.** The organic electroluminescent device according to claim 11, wherein the glass baseplate is an unpolished glass baseplate.

**13.** The organic electroluminescent device according to any one of claims 9 to 12, wherein the thickness of the charge injection and transport layer is ranging from 130 to 500 nm.

**14.** A method to produce an organic electroluminescent device comprising, as stacked on a glass baseplate, at least, a first conductive layer, a charge injection and transport layer, a light-emitting layer, and a second conductive layer, wherein:

(1) as the glass baseplate, a glass baseplate where a minimum value of a waviness tangent of the surface thereof towards the first conductive layer is equal to or more than $4.00 \times 10^{-6}$, or a maximum value of the waviness tangent is equal to or more than $22 \times 10^{-6}$, is used, in such a manner that the surface thereof having the waviness tangent is the surface towards the first conductive layer,
(2) the charge injection and transport layer is formed by using a wet method of film formation,
(3) the charge injection and transport layer includes a charge injection layer in contact with the first conductive layer,
(4) the charge injection layer is formed by coating, by using a wet method of film formation, a composition containing a crosslinking group-having aromatic amine polymer and a solvent, and drying and crosslinking the coating film with coating the composition,
(5) the charge injection and transport layer is formed to have a thickness ranging from 130 to 1000 nm.

**15.** The method to produce an organic electroluminescent device according to claim 14, wherein a density of surface defects in the state where the first conductive layer is formed on the glass baseplate is equal to or more than 2.0 defects/$cm^2$.

**16.** The method to produce an organic electroluminescent device according to claim 14 or claim 15, wherein, as the glass baseplate, a glass baseplate containing at least one of $Na_2O$ and $K_2O$ in an amount equal to or more than 1.0% by mass, is used.

**17.** The method to produce an organic electroluminescent device according to any one of claim 14 to claim 16, wherein the thickness of the charge injection and transport layer is ranging from 130 to 500 nm.

**18.** The method to produce an organic electroluminescent device according to any one of claim 14 to claim 17, wherein, as the glass baseplate, a glass baseplate produced by using the method of float process, is used.

**19.** The method to produce an organic electroluminescent device according to claim 18, wherein, as the glass baseplate, a glass baseplate that has been produced by using the method of float process and is unpolished, is used.

**20.** A method to produce an organic electroluminescent device comprising, as stacked on a baseplate, at least, a first conductive layer, a charge injection and transport layer, a light-emitting layer, and a second conductive layer, wherein:

(1) the charge injection and transport layer is formed by using a wet method of film formation,
(2) the charge injection and transport layer includes a charge injection layer in contact with the first conductive layer,
(3) the thickness of the charge injection and transport layer is ranging from 130 to 1000 nm,
(4) the charge injection layer is formed by coating, by using a wet method of film formation, a composition containing a crosslinking group-having aromatic amine polymer and a solvent, and drying and crosslinking the coating film with coating the composition.

**21.** The method to produce an organic electroluminescent device according to claim 20, wherein the baseplate is a glass baseplate, and a density of surface defects in the state where the first conductive layer is formed on the glass baseplate is equal to or more than 2.0 defects/$cm^2$.

**22.** The method to produce an organic electroluminescent device according to claim 21, wherein, as the glass baseplate, a glass baseplate produced by using the method of float process, is used.

**23.** The method to produce an organic electroluminescent device according to claim 22, wherein, as the glass baseplate, a glass baseplate that has been produced by using the method of float process and is unpolished, is used.

**24.** The method to produce an organic electroluminescent device according to any one of claims 20 to 23, wherein the thickness of the charge injection and transport layer is ranging from 130 to 500 nm.

**25.** An organic electroluminescent device comprising, on a glass baseplate, at least, a first conductive layer, a charge injection and transport layer formed by using a wet method of film formation and containing a charge transport material, a light-emitting layer, and a second conductive layer, in this order, wherein:

the glass baseplate is produced by using the method of float process,
the surface of the glass baseplate towards the first conductive layer is in an unpolished state, and
the thickness of the charge injection and transport layer is at least 1.3 times the thickness of the first conductive layer.

**26.** An organic electroluminescent device comprising, on a glass baseplate, at least, a first conductive layer, a charge injection and transport layer formed by using a wet method of film formation and containing a charge transport material, a light-emitting layer, and a second conductive layer, in this order, wherein:

the minimum value of a waviness tangent of the surface of the glass baseplate towards the first conductive layer is equal to or more than $4.20 \times 10^{-6}$, or a maximum value of the waviness tangent is equal to or more than $22 \times 10^{-6}$,
the thickness of the charge injection and transport layer is at least 1.3 times the thickness of the first conductive layer.

[Fig. 1]

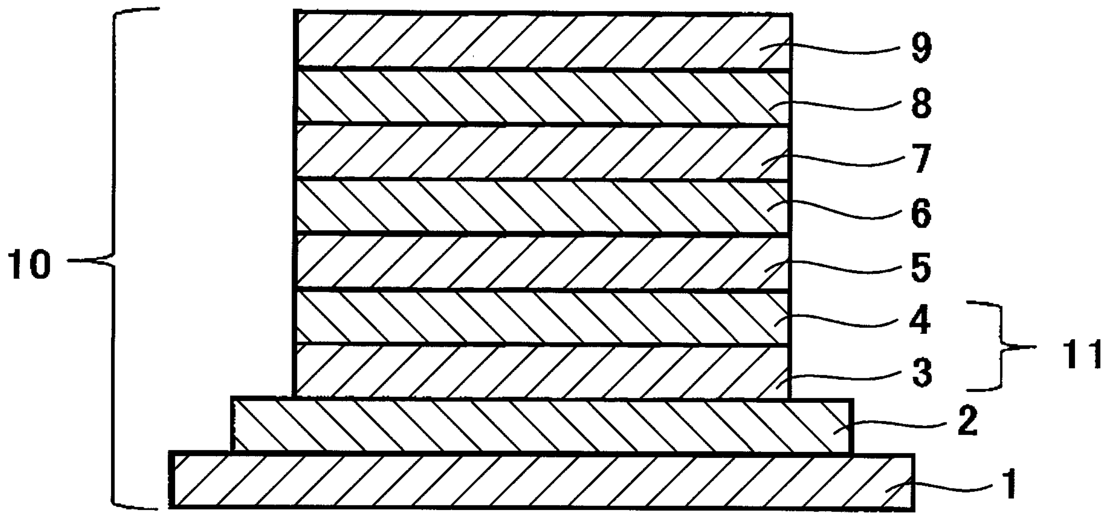

## INTERNATIONAL SEARCH REPORT

International application No. PCT/JP2013/073712

A. CLASSIFICATION OF SUBJECT MATTER
*H05B33/02*(2006.01)i, *C03C17/38*(2006.01)i, *H01L51/50*(2006.01)i, *H05B33/10*(2006.01)i

According to International Patent Classification (IPC) or to both national classification and IPC

B. FIELDS SEARCHED

Minimum documentation searched (classification system followed by classification symbols)
H05B33/02, C03C17/38, H01L51/50, H05B33/10

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2005-243300 A (Sanyo Electric Co., Ltd.), 08 September 2005 (08.09.2005), paragraphs [0100], [0145], [0147] & US 2005/0186106 A1 | 1-24 |
| Y | JP 2003-257675 A (Sanyo Electric Co., Ltd.), 12 September 2003 (12.09.2003), paragraph [0024]; fig. 7 & US 2003/0168974 A1 & CN 1443029 A | 1-26 |
| Y | JP 2003-338383 A (Sanyo Electric Co., Ltd.), 28 November 2003 (28.11.2003), paragraphs [0025], [0026]; fig. 5 & US 2004/0027063 A1 & TW 594617 B & CN 1447632 A | 1-26 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 31 October, 2013 (31.10.13) | 12 November, 2013 (12.11.13) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2013/073712

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2005-190838 A (Optrex Corp.), 14 July 2005 (14.07.2005), paragraphs [0009] to [0011], [0029], [0037], [0054] (Family: none) | 1-8,10-12, 14-19,21-23, 25-26 |
| Y | JP 2000-21563 A (Futaba Corp.), 21 January 2000 (21.01.2000), paragraphs [0010], [0011], [0024], [0025] (Family: none) | 1-8,10-12, 14-19,21-23 |
| A | WO 2008/010487 A1 (Hitachi Chemical Co., Ltd.), 24 January 2008 (24.01.2008), paragraphs [0112] to [0114] & US 2009/0321723 A1 & KR 10-2011-0033269 A & KR 10-2011-0036120 A & KR 10-2009-0023699 A & CN 101490864 A & KR 10-2011-0033270 A & KR 10-2011-0036119 A & TW 200813110 A | 1-24 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 11195487 A
- JP 2007091522 A
- JP 2004111201 A
- JP 2004276133 A
- JP 4431516 B
- JP 2006233162 A
- JP 2009287000 A
- JP 11251067 A
- JP 2003031365 A
- WO 2005089024 A
- JP 11242996 A
- JP 7041759 A
- JP 10079297 A
- WO 2005022962 A
- JP 59194393 A
- US P5645948 A
- JP 6207169 A
- JP 5331459 A
- JP 10270171 A
- JP 2002100478 A
- JP 2002100482 A
- JP 10074586 A

### Non-patent literature cited in the description

- Organic Chemistry, Biochemical Nomenclature. Nanko-do, 1992, vol. 1
- *Applied Physics Letters,* 1997, vol. 70, 152
- *IEEE transactions on Electron Devices,* 1997, vol. 44, 1245
- *SID 04 Digest,* 154